# EUROPEAN PATENT APPLICATION

(11) **EP 4 741 409 A1**
(43) Date of publication of application: **13.05.2026**
(21) Application number: 23947385.3
(22) Date of filing: 04.12.2023
(51) Int. Cl.: C07F 15/00, C09K 11/06, H10K 50/10

(54) **FUSED-RING CARBAZOLE TETRADENTATE METAL PLATINUM (II) COMPLEX AND USE THEREOF, AND ELECTRONIC DEVICE**

(30) Priority: 03.08.2023 CN 202310971583
(71) Applicant: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Guijie, Hangzhou, Zhejiang 310014 (CN); YAO, Huanhuan, Hangzhou, Zhejiang 310014 (CN); SHE, Yuanbin, Hangzhou, Zhejiang 310014 (CN); CHU, Qingshan, Hangzhou, Zhejiang 310014 (CN); WU, Kongwu, Jiaxing, Zhejiang 314107 (CN)
(74) Representative: Chung, Hoi Kan
(86) International application number: PCT/CN2023/136018
(87) International publication number: WO 2025/025447

(57) **Abstract**

The present invention relates to the field of organic electroluminescence, and in particular to a fused-ring carbazole tetradentate metal platinum (II) complex and a use thereof, and an electronic device. According to the present invention, the interaction between molecules is reduced by means of the introduction of diphenyl, and a fused-ring carbazole system is introduced at different positions of carbazole to improve the component proportion of a localized state (LE) in an excited triplet state of a cyclic tetradentate platinum (II) complex, so that the cyclic tetradentate platinum (II) complex has a low shoulder peak to improve the purity of luminescence of material molecules. Materials involved in the present invention all have good chemical stability and thermal stability, and are easy to prepare evaporated OLED devices. The combination with a fluorescent doping material can balance transport of holes and electrons, and energy transfer between a subject and an object is more efficient. An organic electroluminescent device manufactured by using the compound of the present invention as a luminous layer has markedly improved current efficiency, markedly prolonged service life, and a markedly reduced tum-on voltage. In particular, the joint use with boron-containing compounds sensitized by phosphorescence materials can improve the purity of luminescence of devices.

## Description

### TECHNICAL FIELD

The present disclosure relates to the field of organic electroluminescence, specifically to a fused-ring carbazole tetradentate platinum(II) complex and an application thereof, and an electronic device.

### BACKGROUND

Organic light-emitting diodes (OLEDs) represent a new generation of full-color display and lighting technology. Compared to the liquid crystal display which suffers from slow response, narrow viewing angle, necessity for backlight and high energy consumption, OLEDs as self-luminous devices offer advantages such as no need for backlight, high energy efficiency, low drive voltage, quick response, high resolution and contrast, wide viewing angle and excellent low-temperature performance; and OLED devices may be fabricated to be thin and into flexible structures. In addition, OLEDs further offer advantages such as low production cost, simple manufacturing process and suitability for large-format products. Therefore, OLEDs possess broad and significant application prospects in high-end electronic products and the aerospace fields. With a gradual increase in investment, further in-depth research and development and upgrading of production equipment, OLEDs will have extensive application scenarios and promising development potential in the future.

The core of the development of OLEDs lies in design and development of light-emitting materials. At present, light-emitting layers of OLED devices in use almost exclusively employs a host-guest light-emitting system, i.e., doping a host material with a guest light-emitting material. An energy gap of the host material is typically higher than that of the guest light-emitting material, such that energy is transferred from the host material to the guest light-emitting material, thereby leading to excitation and subsequent light emission of the guest light-emitting material. Common organic phosphorescent guest materials are predominantly complexes of heavy metals such as iridium(III), platinum(II) and palladium (Pd)(II). Commonly used phosphorescent organic materials 3,3'-bis(9-carbazolyl)-biphenyl (i.e., mCBP) and 2,6-bis(9-carbazolyl)-pyridine (i.e., 2,6-mCPy) possess high efficiency and high triplet energy levels, and when the materials are used as organic materials, triplet energy can be effectively transferred from the light-emitting organic materials to guest phosphorescent materials. However, mCBP exhibits high hole mobility but poor electron transport capability, and 2,6-mCPy suffers from inadequate hole transport. This causes charges in the light-emitting layers to be unbalanced, resulting in a decrease in current efficiency of devices. Moreover, heavy-metal phosphorescent organic complexes in use are mainly cyclometalated iridium(III) complex molecules, whose variety is limited. The abundance of platinum in the Earth's crust and the annual global production of platinum are both approximately ten times greater than those of iridium; and the price of IrCl₃-H₂O used for preparing iridium(III) complex phosphorescent materials is significantly higher than that of PtCl₂ used for preparing platinum(II) complex phosphorescent materials. Additionally, the preparation of the iridium(III) phosphorescent materials involves four steps: preparation of an iridium(III) dimer, ligand exchange of an iridium (III) intermediate, synthesis of a mer-iridium(III) complex, and isomerization from mer- to fac-iridium(lll) complex. This substantially reduces an overall yield, greatly decreases utilization ratio of a starting material IrCl₃·H₂O, and consequently increases a production cost of the iridium(lll) phosphorescent materials. In contrast, the preparation of the platinum(II) complex phosphorescent materials consists of just one step: ligand metallation. This process affords a high utilization ratio of platinum, thereby further reducing a production cost of the platinum(II) complex phosphorescent materials.

In summary, the production cost of the platinum (II) complex phosphorescent materials is much lower than that of the iridium (III) complex phosphorescent materials. Furthermore, the issue of how to reduce a height of a shoulder peak in an emission spectrum to improve color purity of light emitted by molecules of a material is particularly important for blue and deep-blue light-emitting materials, as this significantly affects efficiency and energy utilization of top-emission devices in commercial applications. However, there are still some technical challenges in the development of the platinum complex materials and devices, and improving device efficiency and lifetime remains an important research topic. Therefore, novel phosphorescent platinum(II) complexes need to be developed.

### SUMMARY

In view of the above, the present disclosure aims to provide a fused-ring carbazole tetradentate platinum(II) complex. When used as a light-emitting layer to fabricated an organic electroluminescent device, the fused-ring carbazole tetradentate platinum(II) complex in the present disclosure may enable the device to exhibit excellent performance, current efficiency of the organic electroluminescent device may be enhanced, lifetime of the device may be improved, and an operating voltage of the device may also be reduced.

To achieve the above-described technical objective, the technical solutions of the present disclosure are as described below.

The present disclosure provides a fused-ring carbazole tetradentate platinum(II) complex. The fused-ring carbazole tetradentate platinum(II) complex has a general structure selected from formulas (I) to (V):

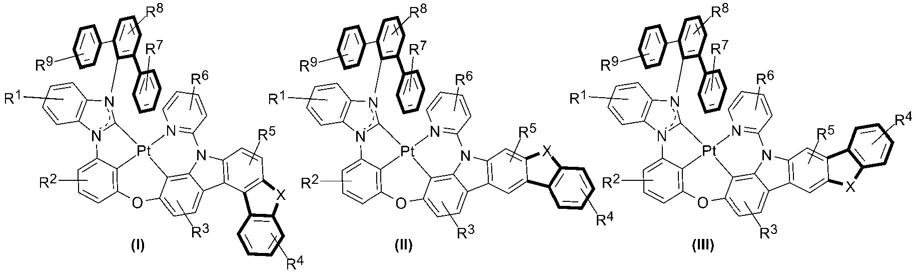

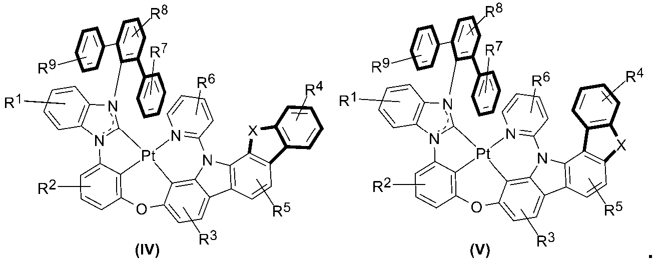

In formulas (I) to (V), X is selected from C, O and S; R¹-R⁹ each independently represent from mono to maximum allowable substitution, or no substitution; and R¹-R⁹ are each independently selected from the group consisting of: hydrogen, deuterium (D), halogen, CN, C1-C30 alkyl, C1-C30 deuterated alkyl, C1-C30 haloalkyl, C1-C30 cycloalkyl, C1-C30 heterocycloalkyl, C6-C60 aryl, a C6-C60 fused-ring aromatic hydrocarbon group, C6-C60 heteroaryl, a C6-C60 fused heterocyclic aromatic hydrocarbon group, C6-C60 arylamino, and combinations thereof, in a case where a heteroatom is involved, the heteroatom being selected from N and O.

Furthermore, R¹ and R⁶-R⁹ are each independently selected from the group consisting of: hydrogen, deuterium, CD₃, F, methyl, ethyl, n-propyl, isopropyl, n-butyl, isobutyl, sec-butyl, tert-butyl, n-pentyl, isopentyl, sec-pentyl, tert-pentyl, n-hexyl, isohexyl, sec-hexyl, tert-hexyl, n-heptyl, isoheptyl, sec-heptyl, tert-heptyl, n-octyl, isooctyl, sec-octyl, tert-octyl, n-nonyl, isononyl, sec-nonyl, tert-nonyl, phenyl, and combinations thereof.

Preferably, R¹ and R⁶-R⁹ are each independently selected from the group consisting of: hydrogen, deuterium, CD₃, F, methyl, ethyl, n-propyl, isopropyl, n-butyl, isobutyl, sec-butyl, tert-butyl, phenyl, and combinations thereof.

Furthermore, R²-R⁵ are each independently selected from the group consisting of: hydrogen, deuterium, CD₃, F, CF₃, methyl, ethyl, n-propyl, isopropyl, n-butyl, isobutyl, sec-butyl, tert-butyl, phenyl, naphthyl, pyridyl, quinolinyl, cyclopentane, cyclohexane, five-membered heterocycle, diphenylamine, and combinations thereof.

Preferably, the fused-ring carbazole tetradentate platinum(II) complex is any one selected from chemical structures shown below, wherein D represents deuterium:

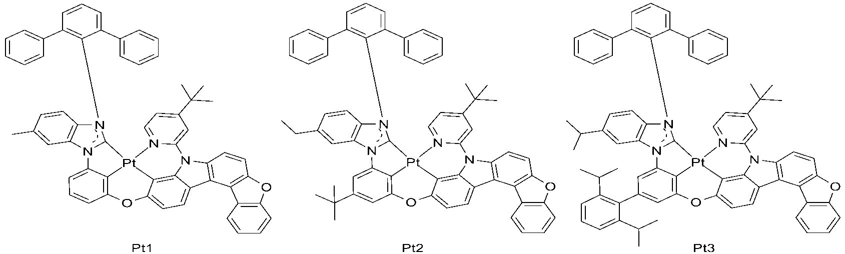

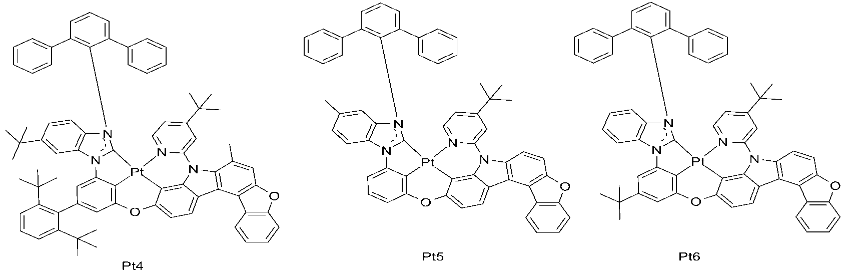

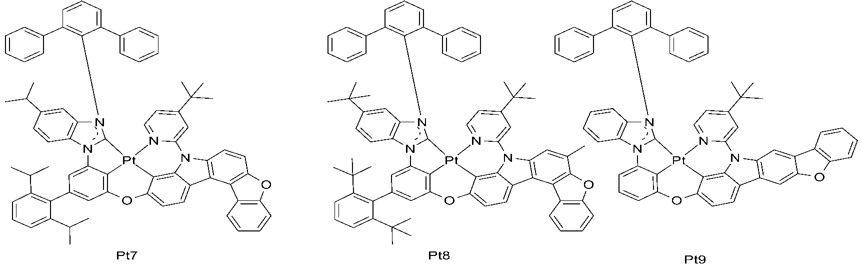

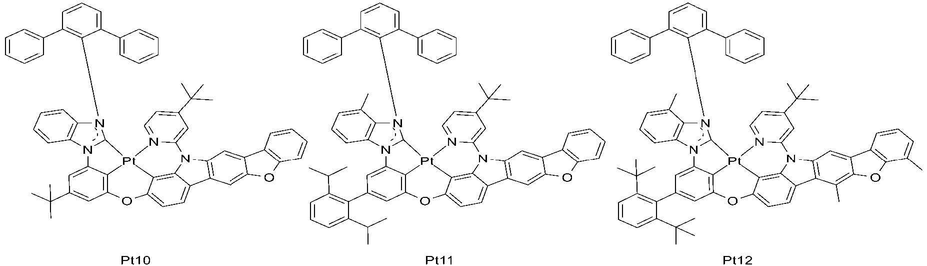

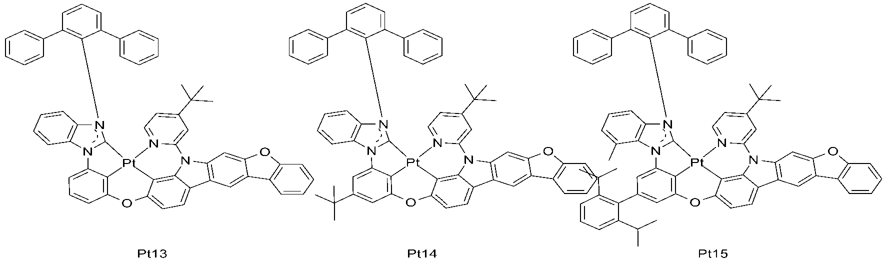

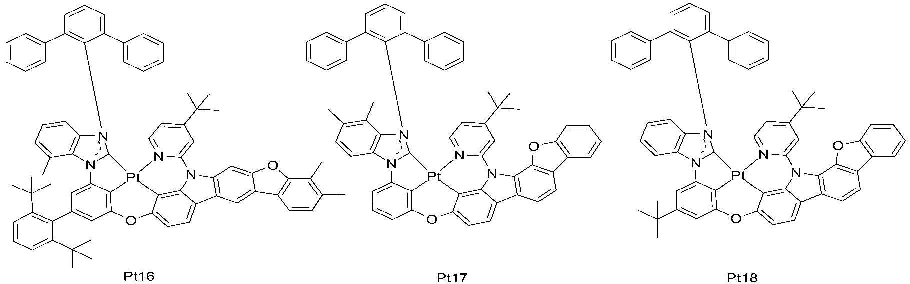

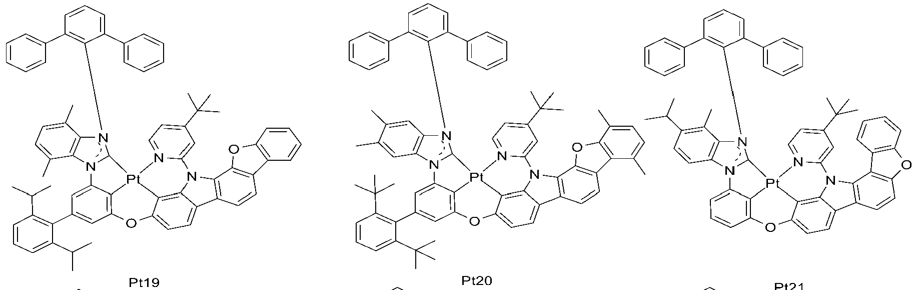

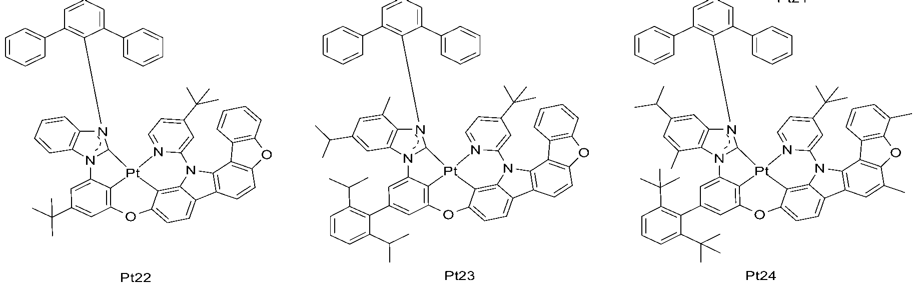

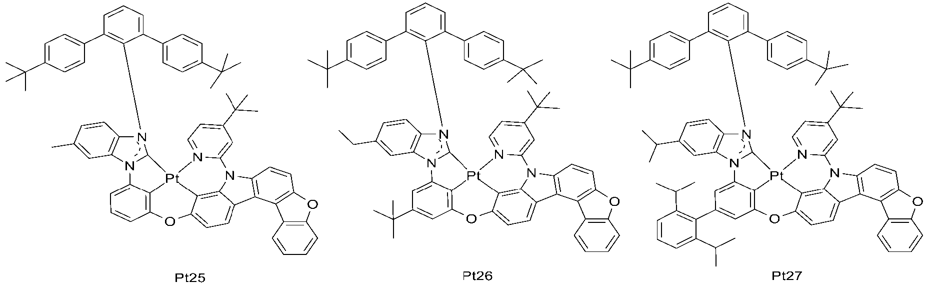

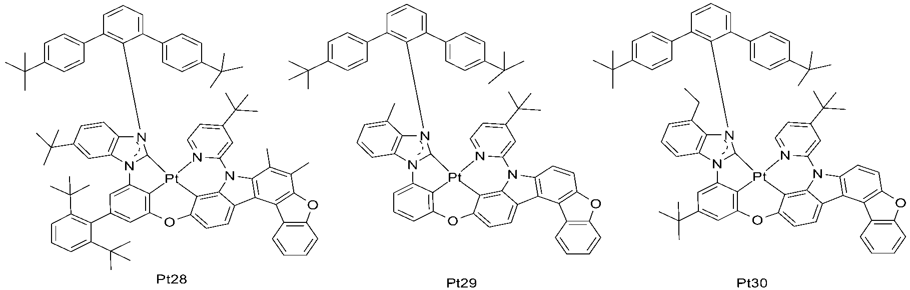

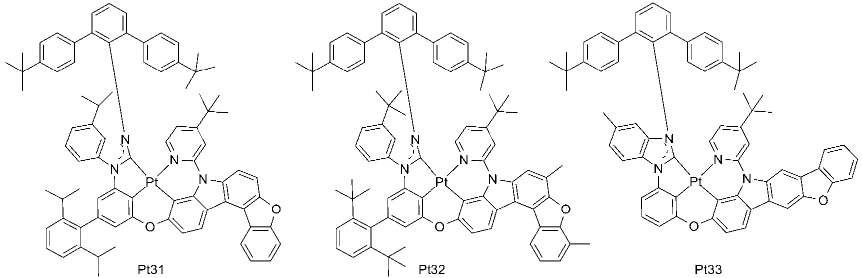

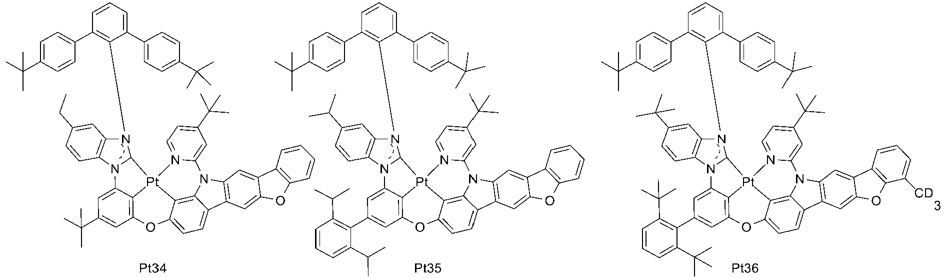

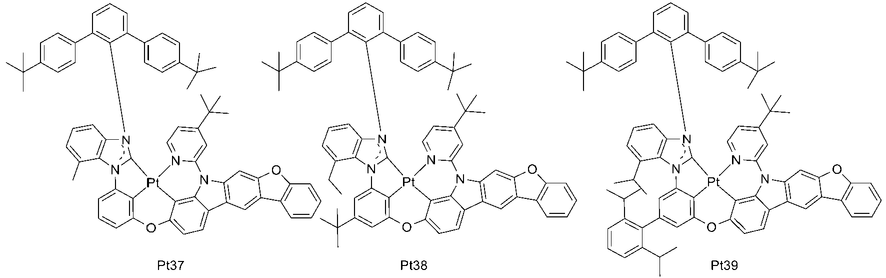

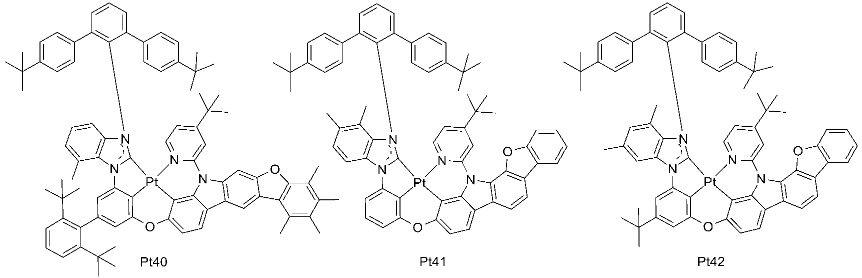

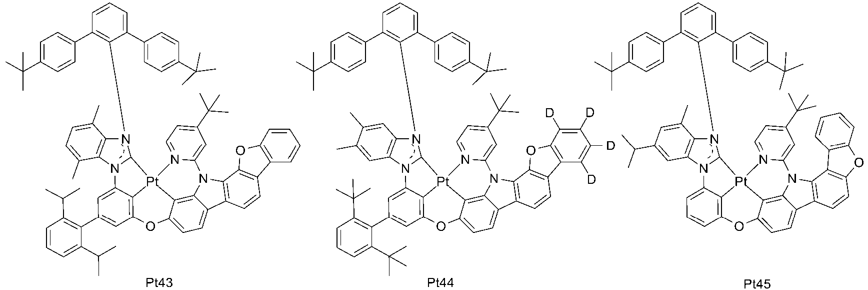

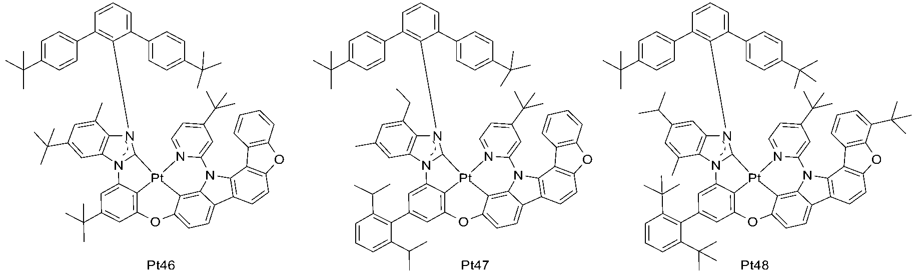

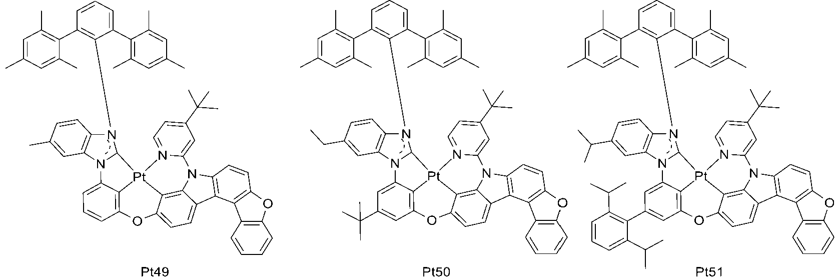

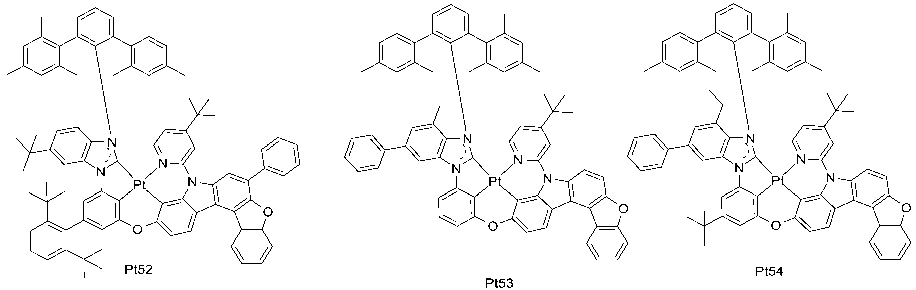

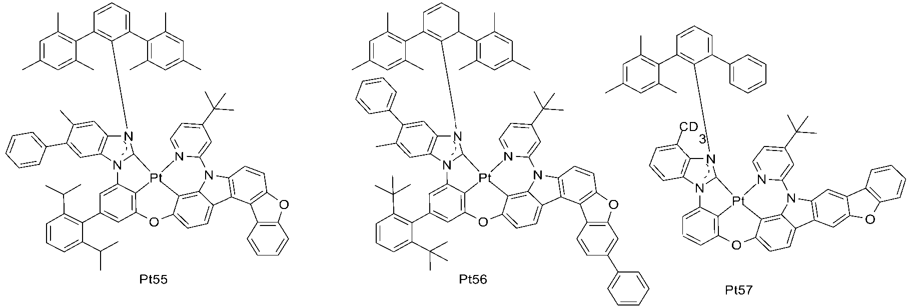

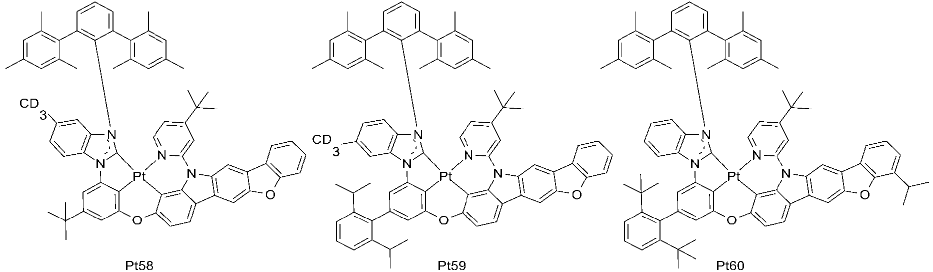

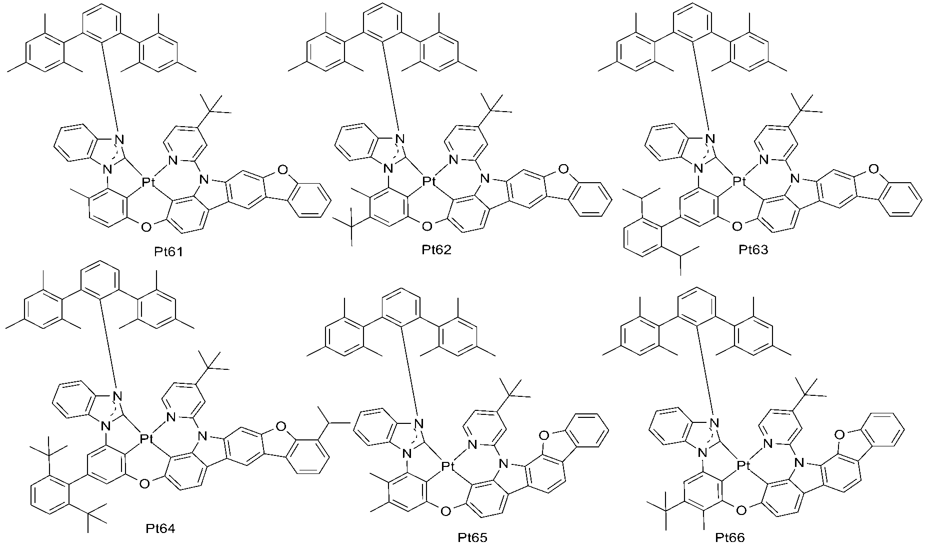

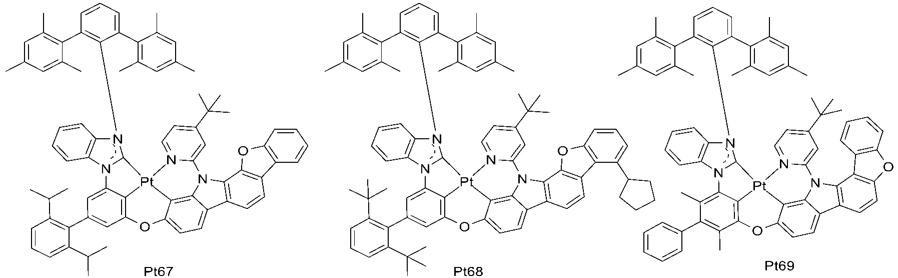

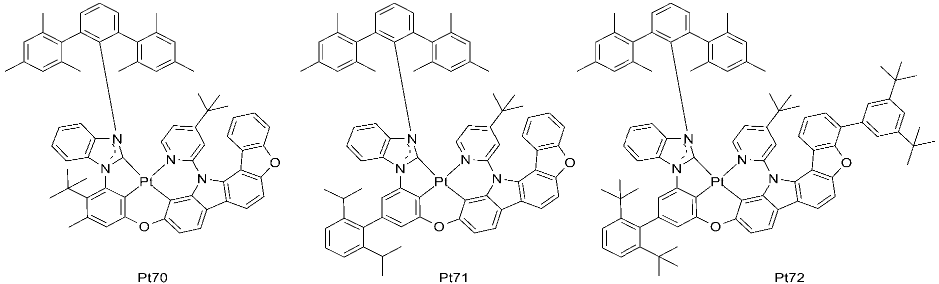

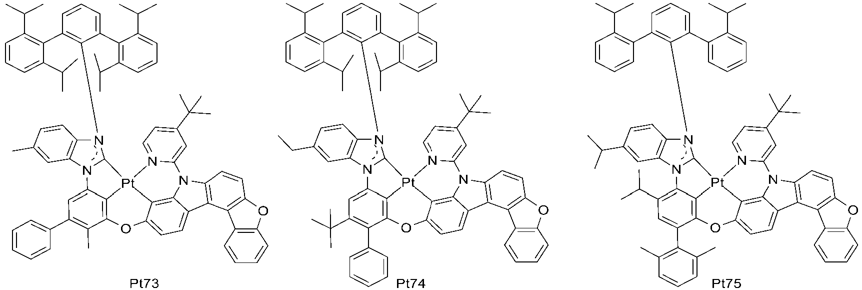

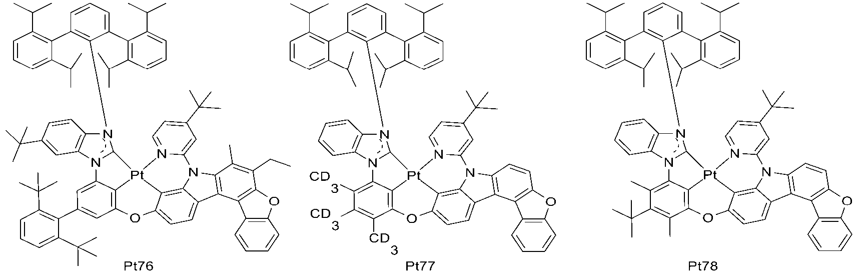

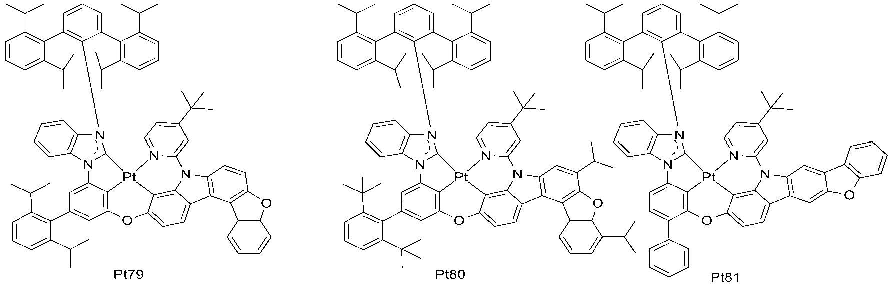

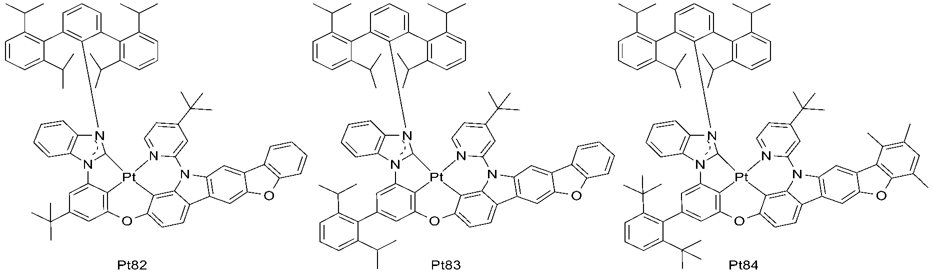

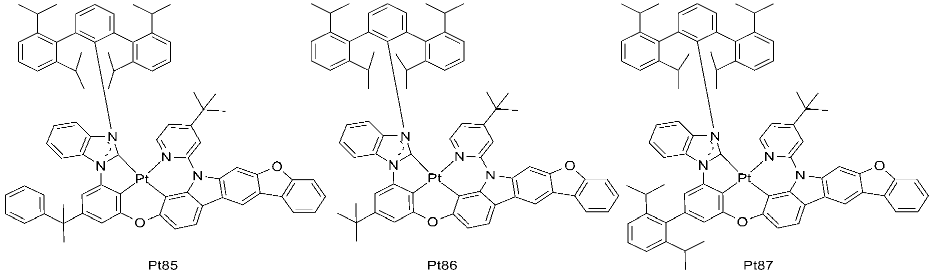

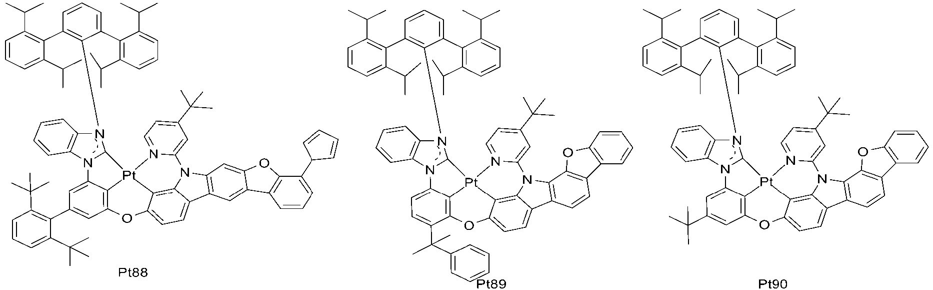

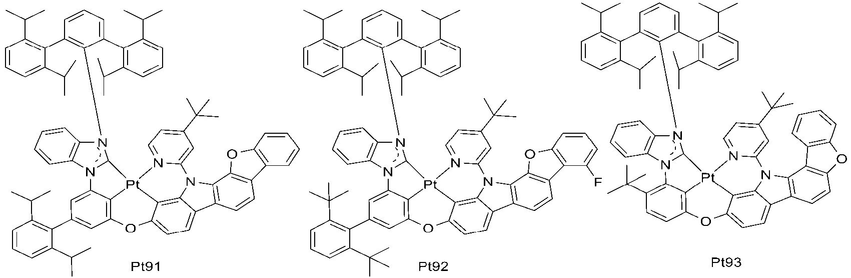

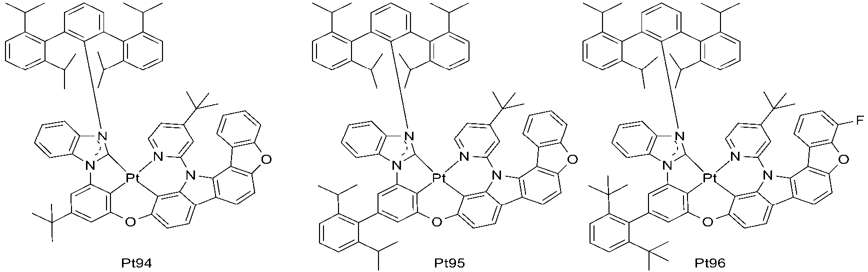

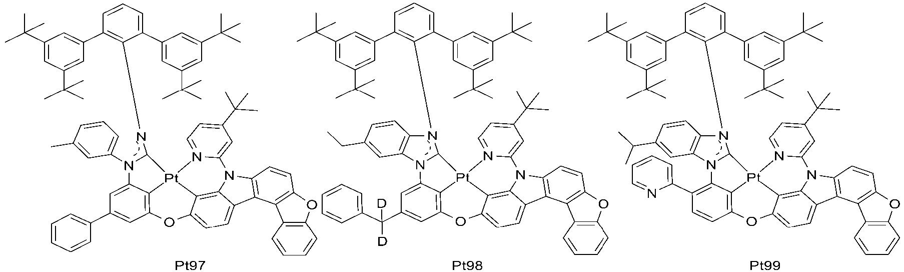

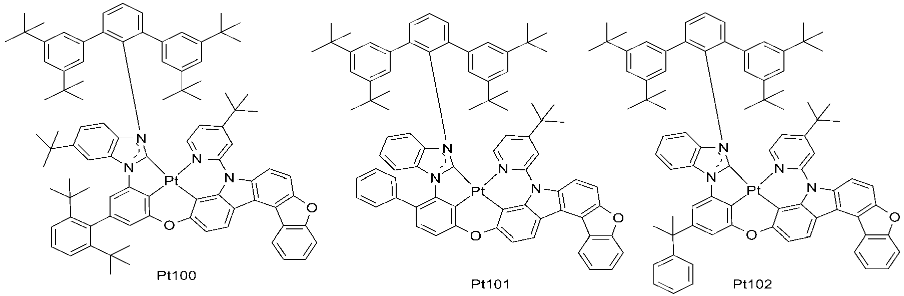

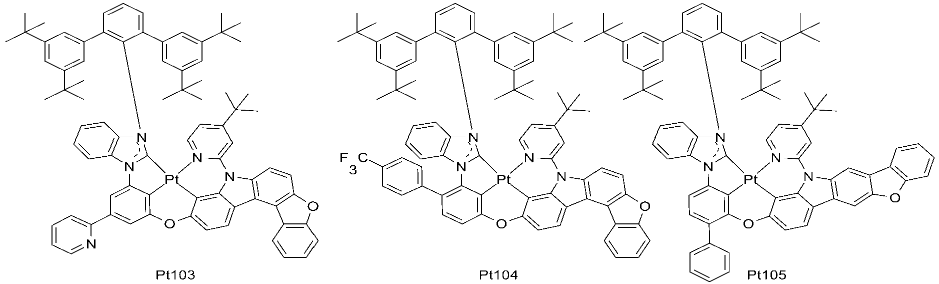

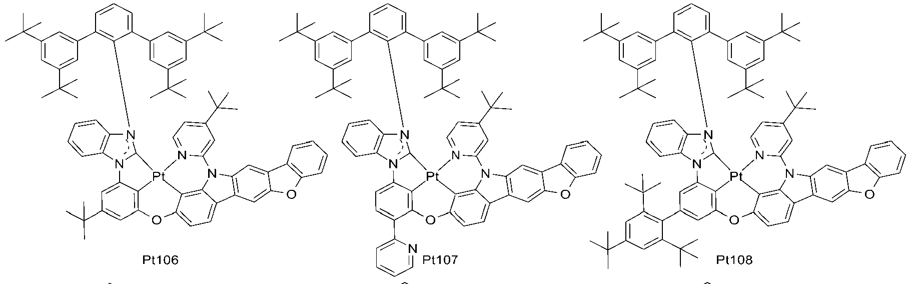

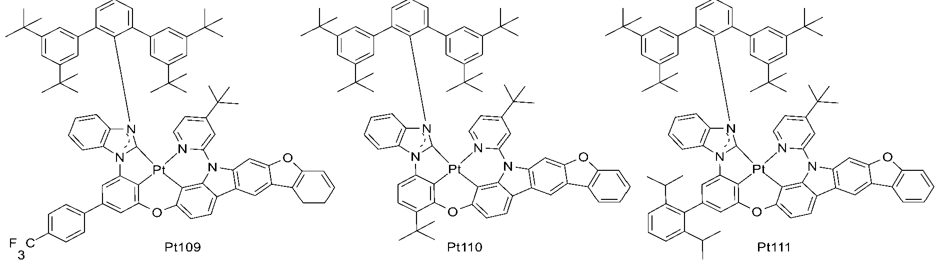

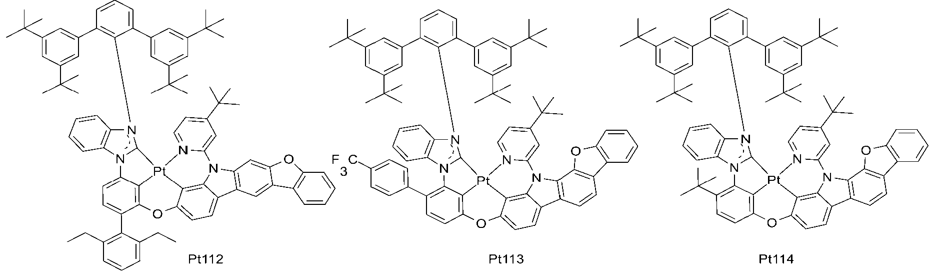

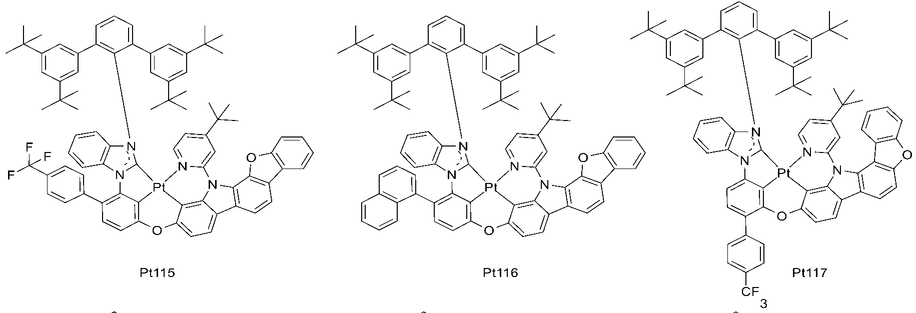

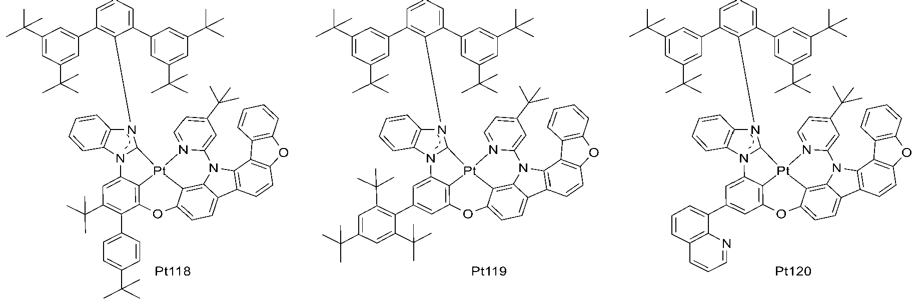

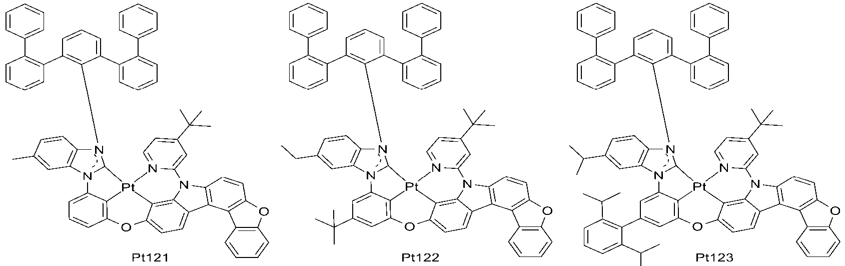

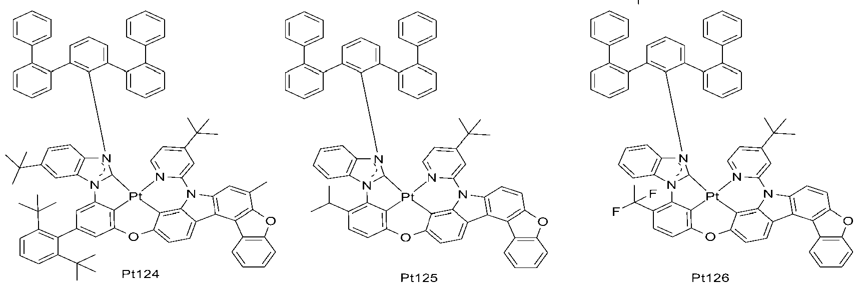

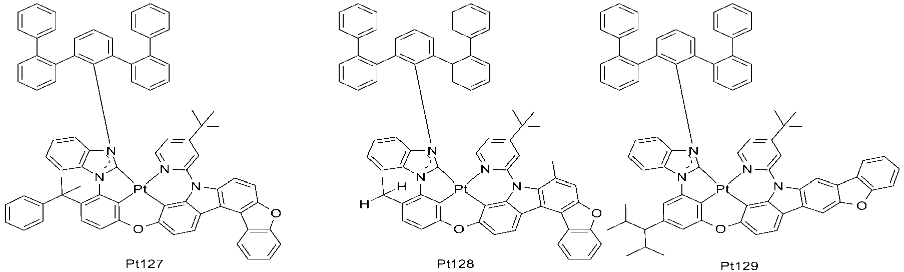

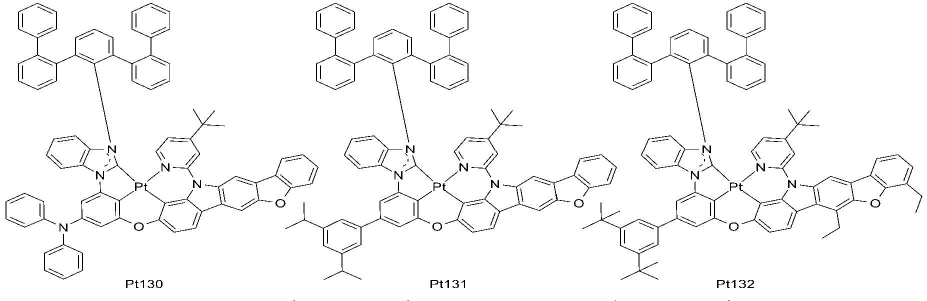

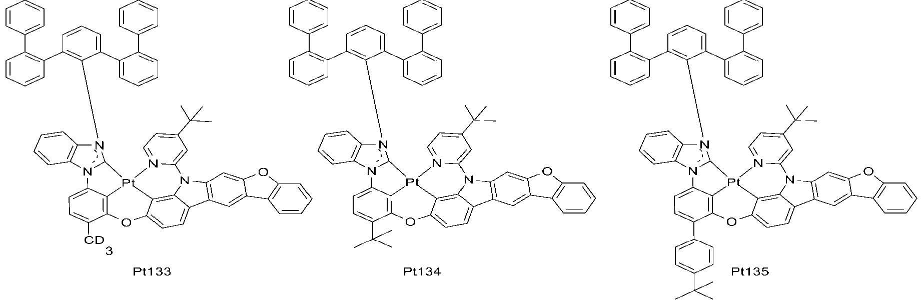

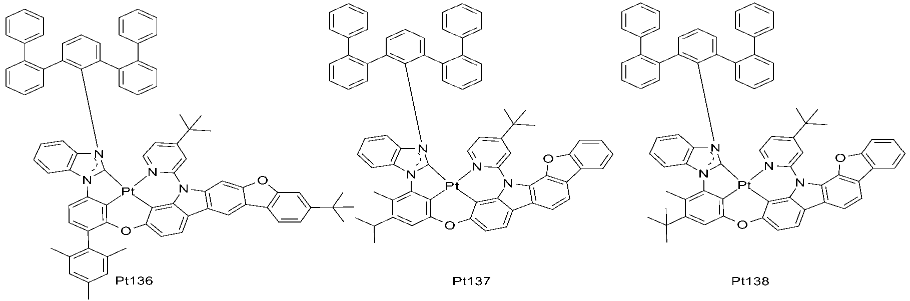

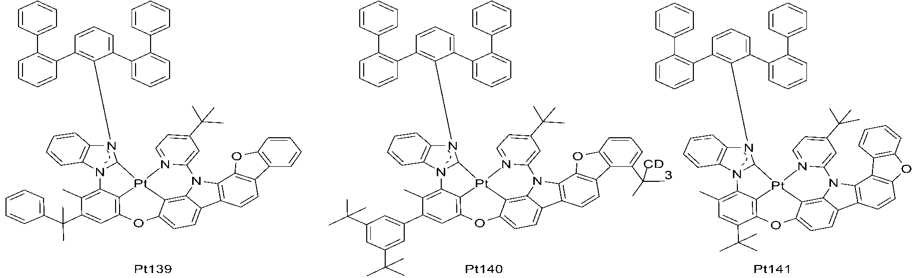

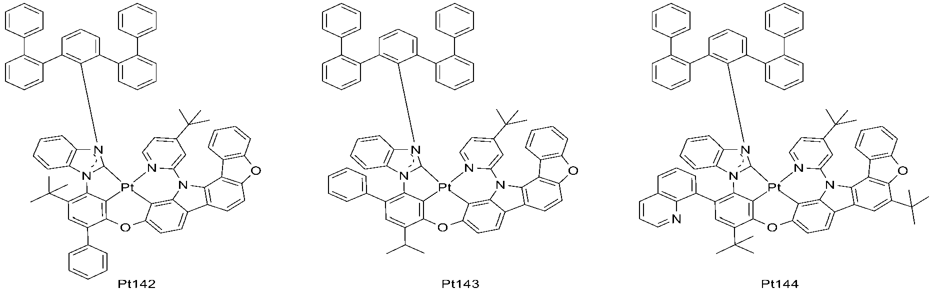

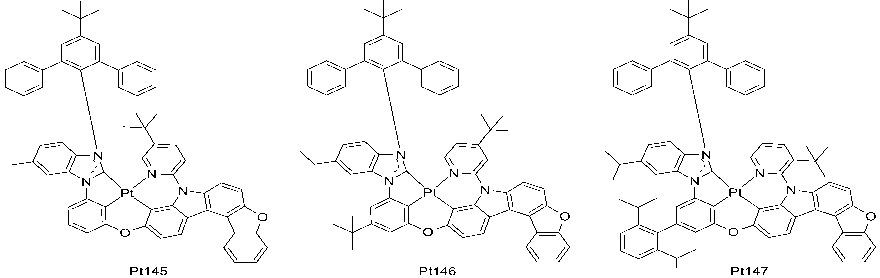

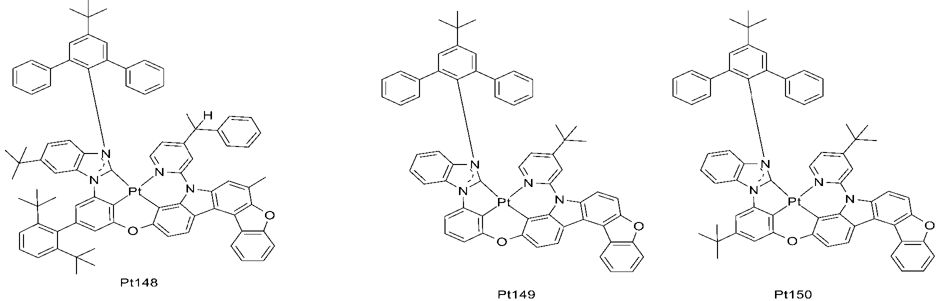

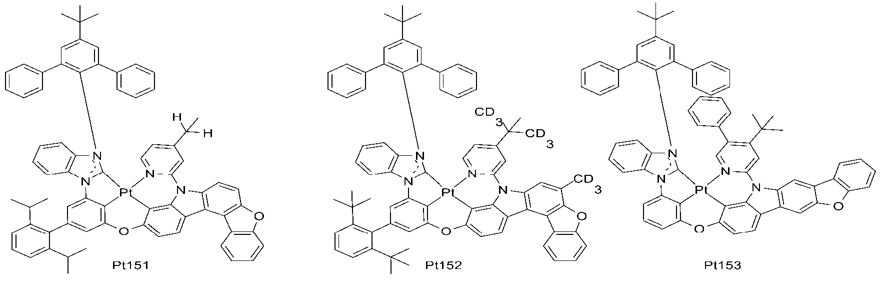

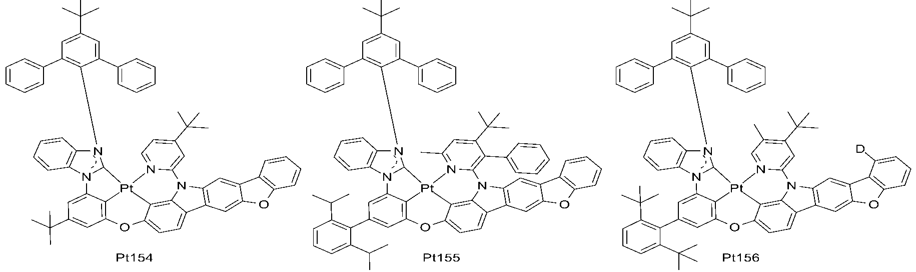

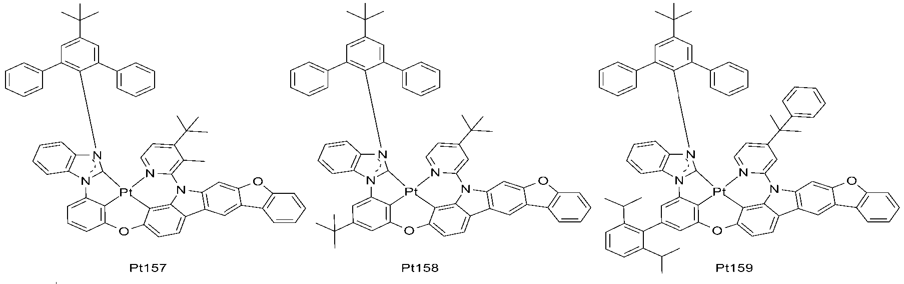

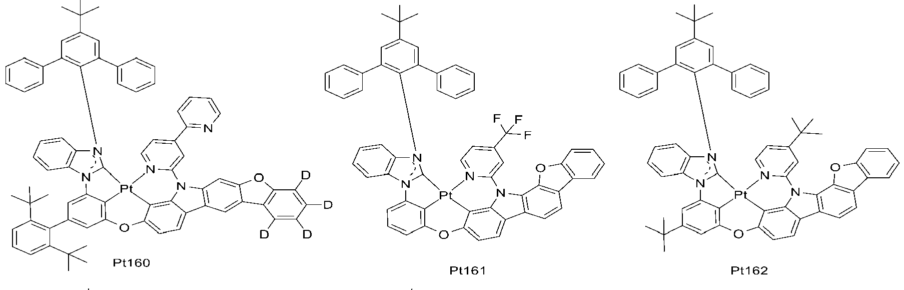

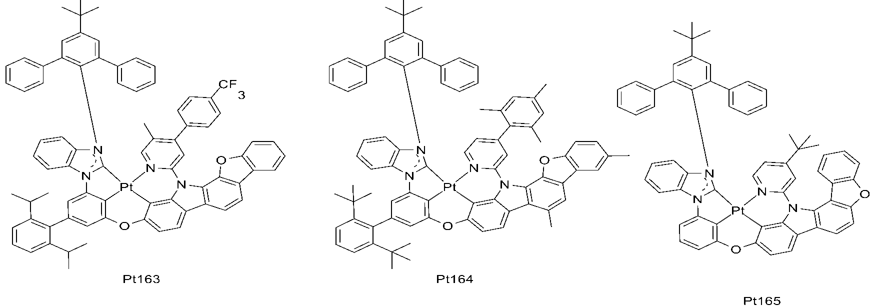

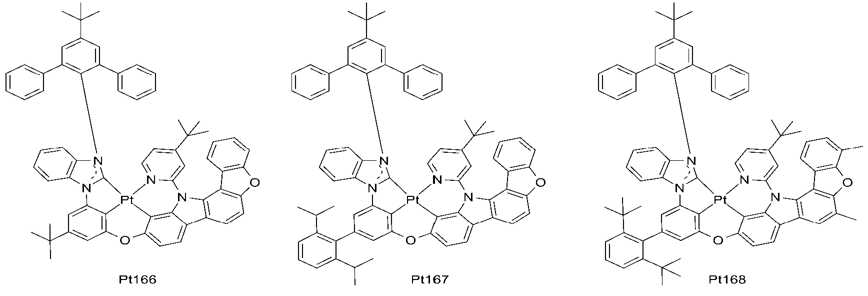

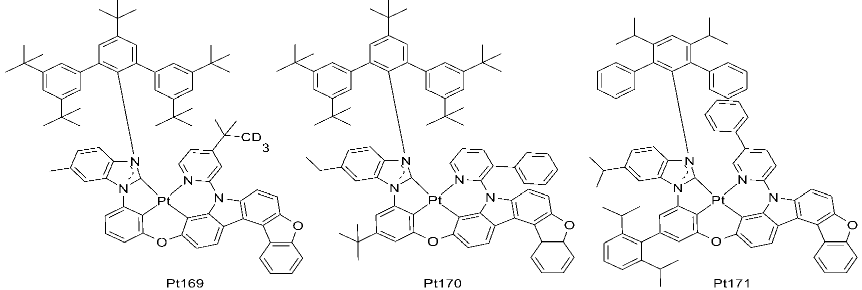

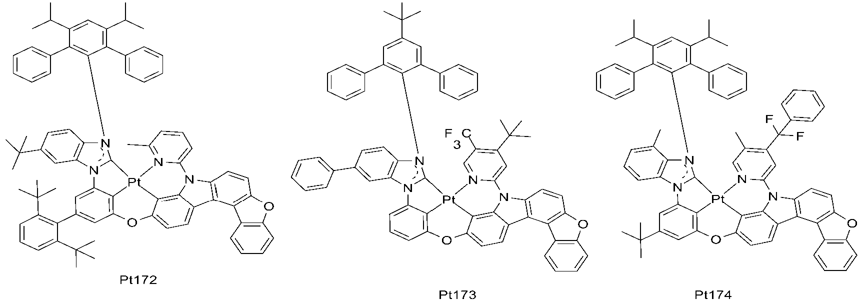

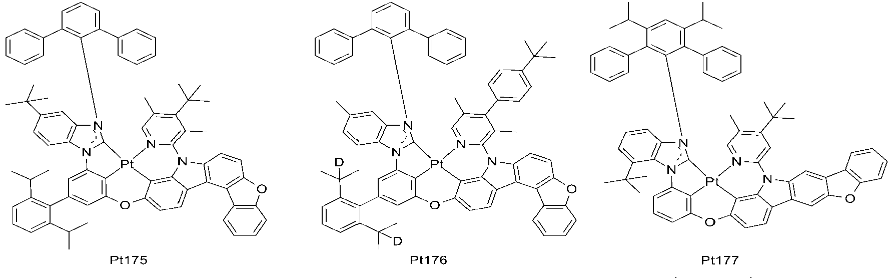

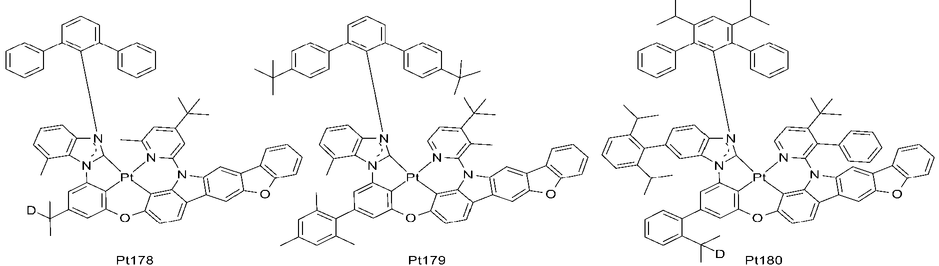

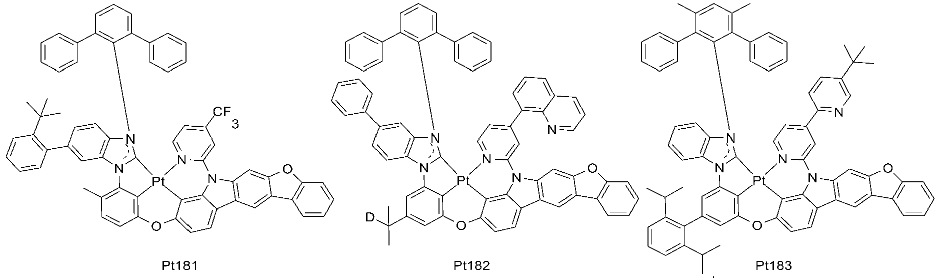

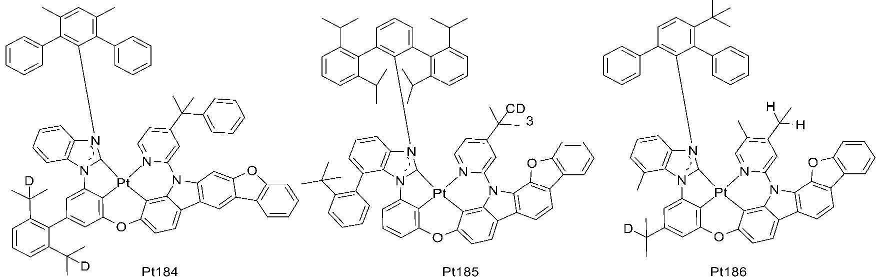

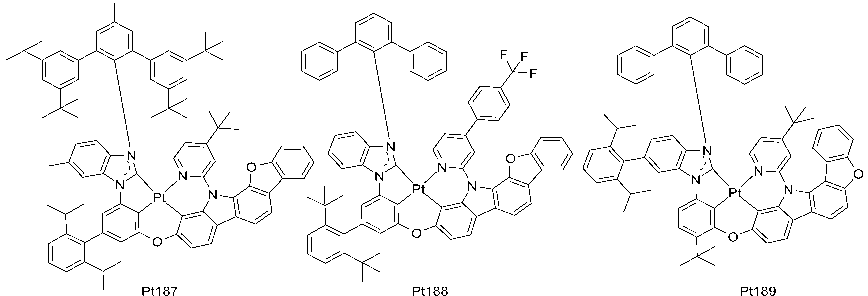

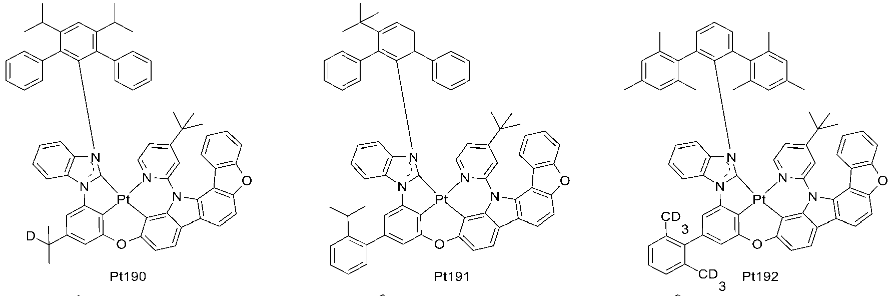

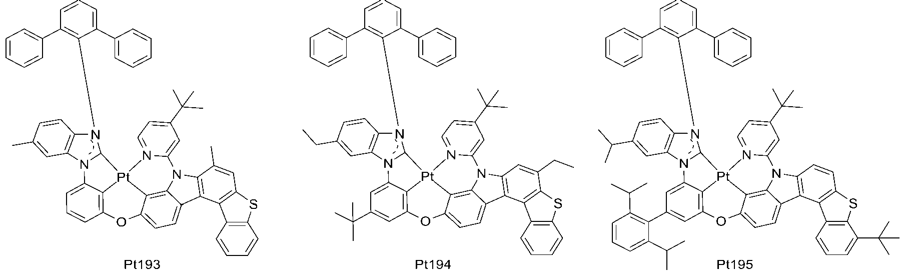

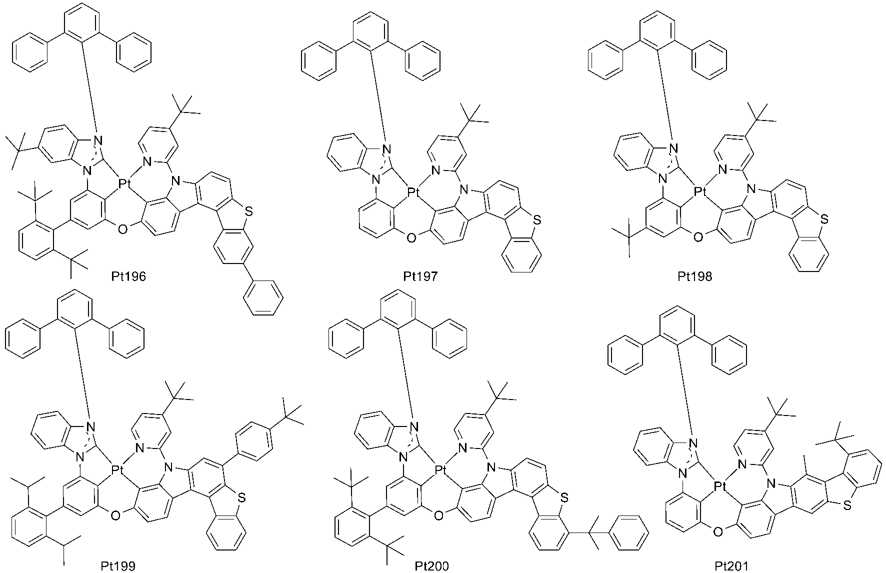

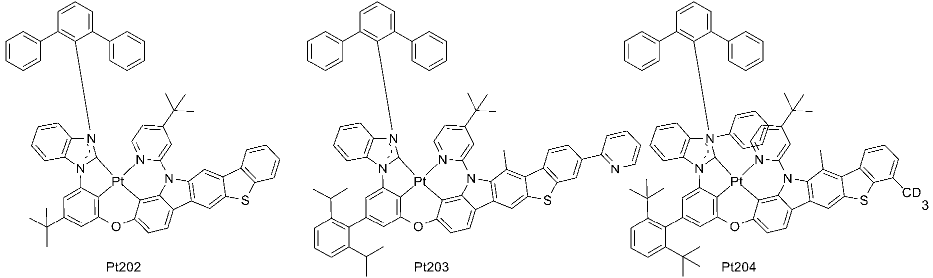

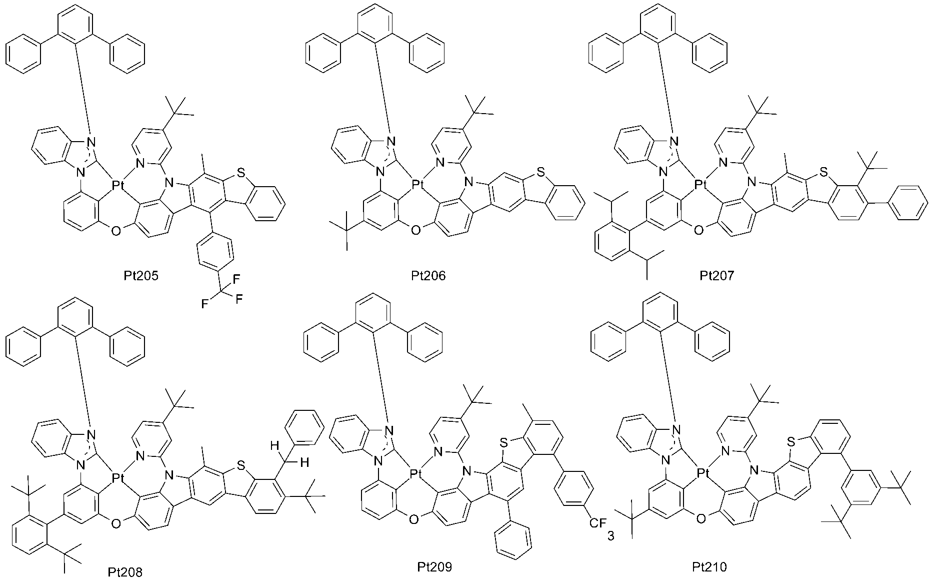

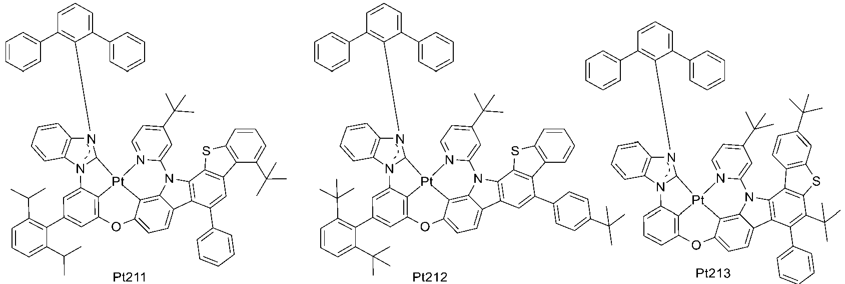

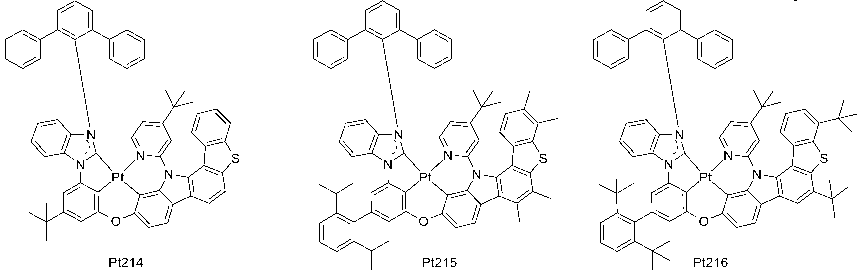

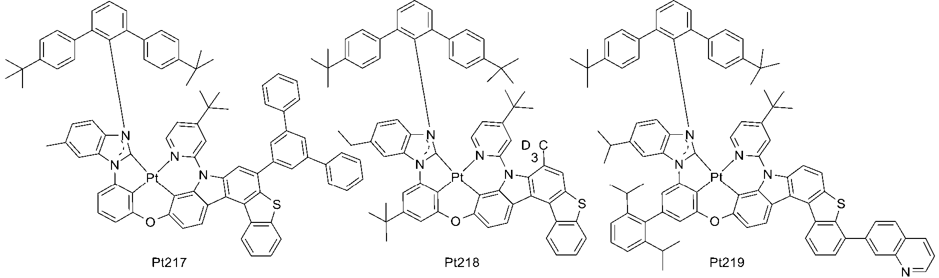

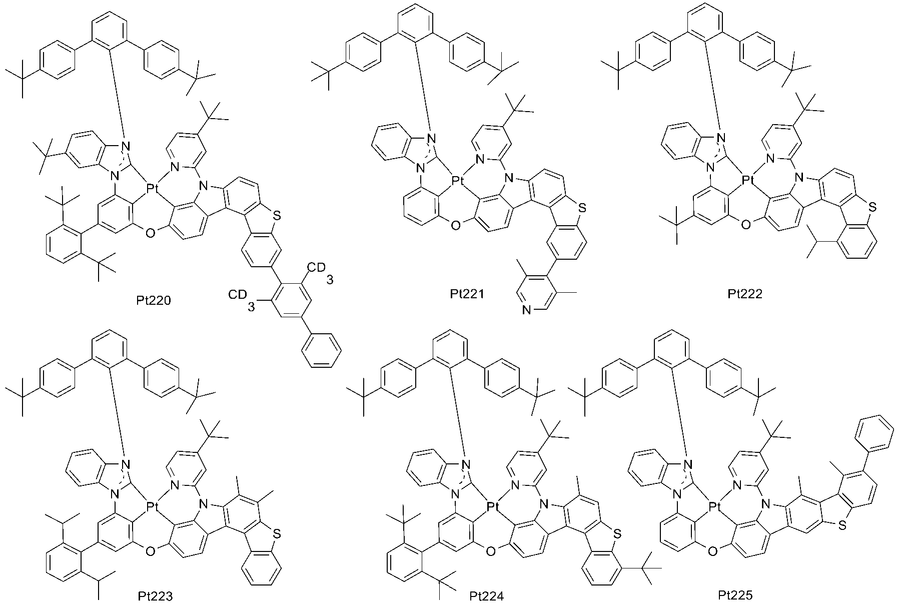

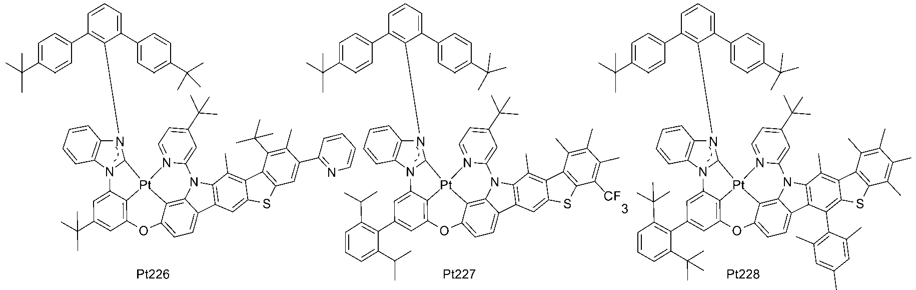

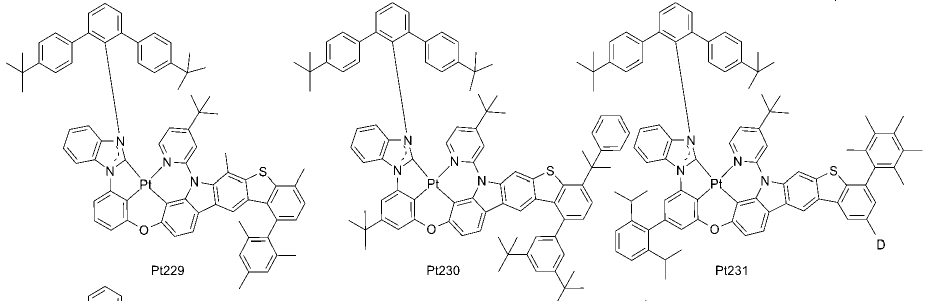

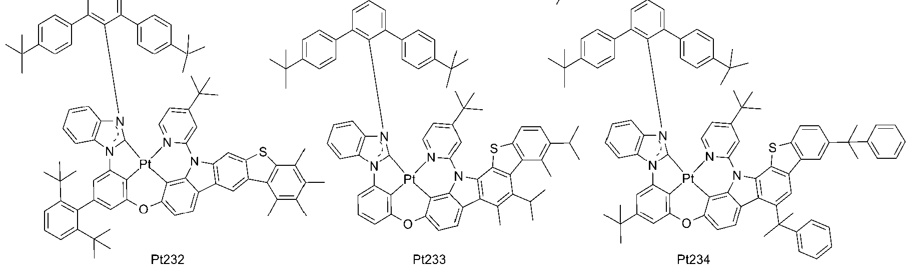

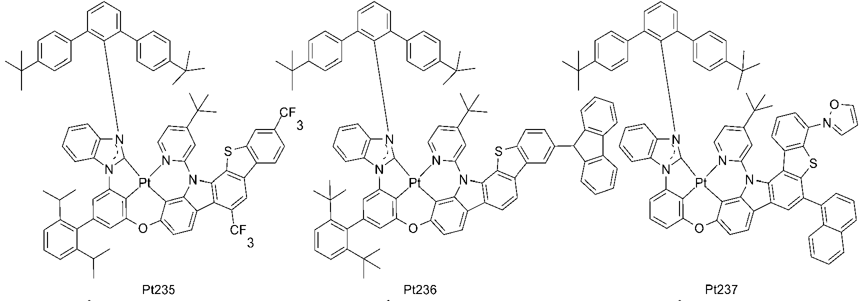

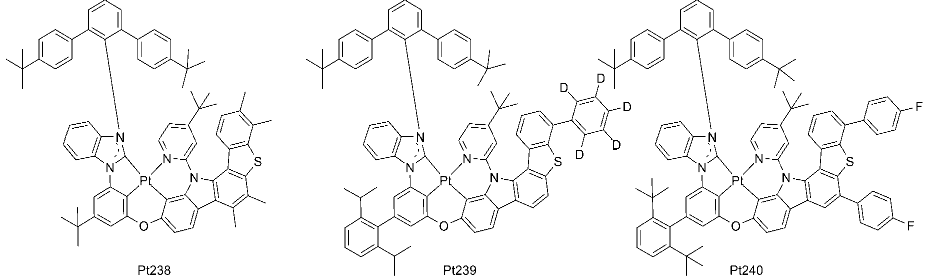

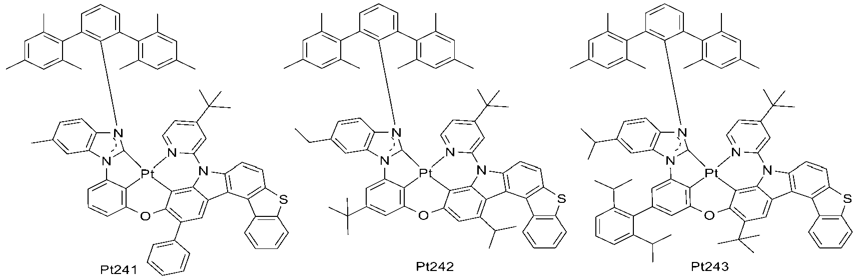

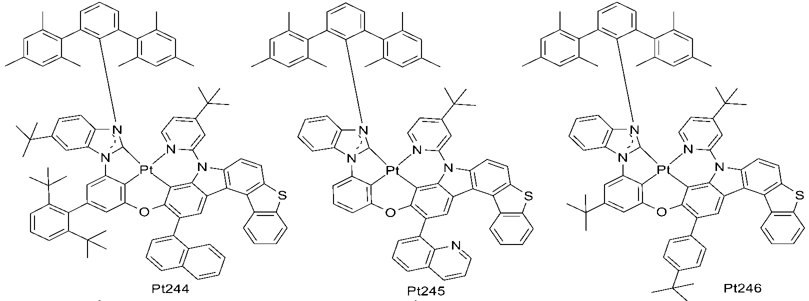

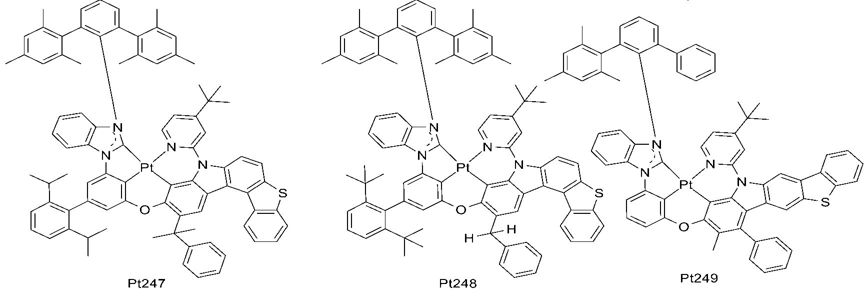

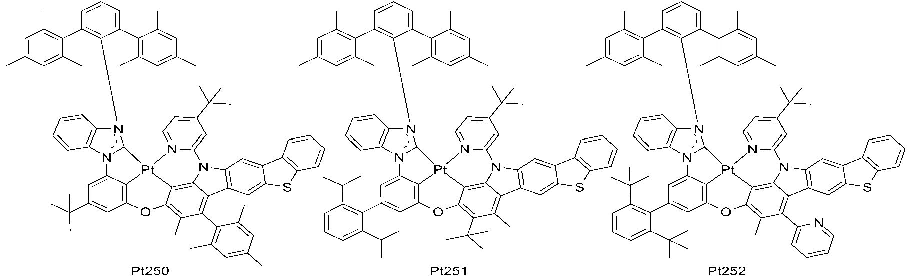

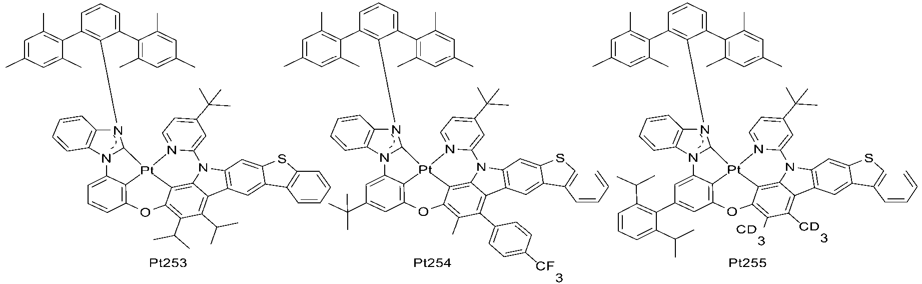

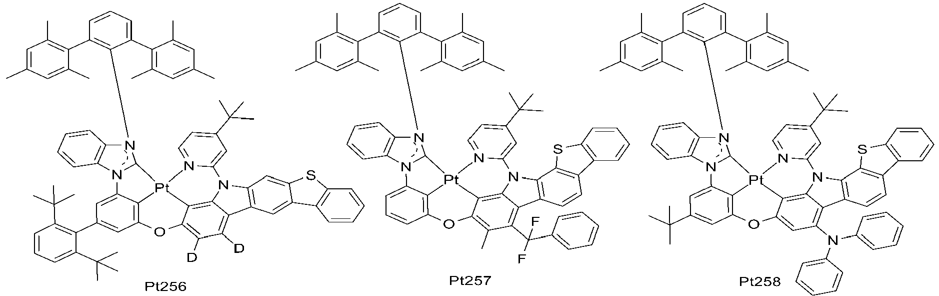

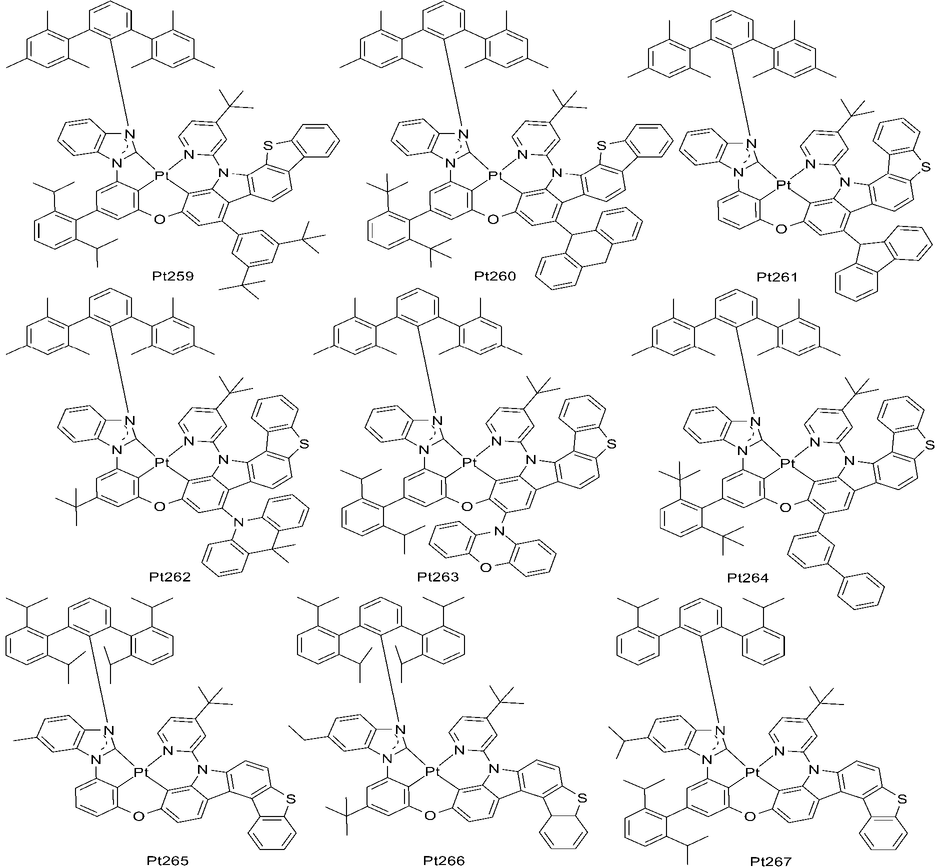

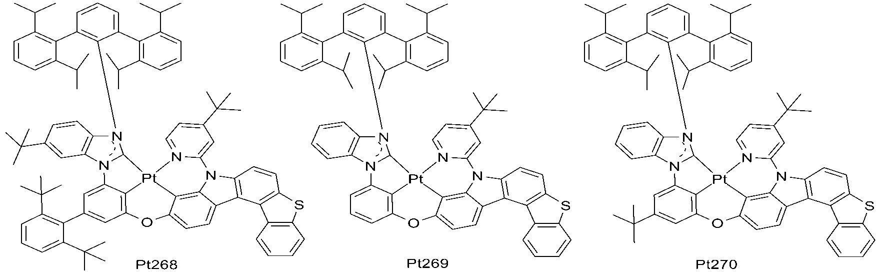

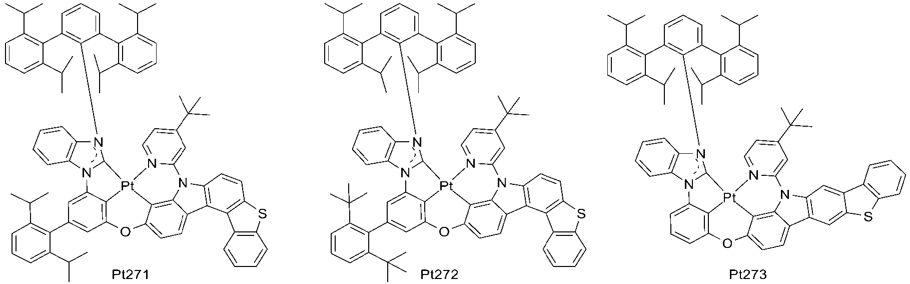

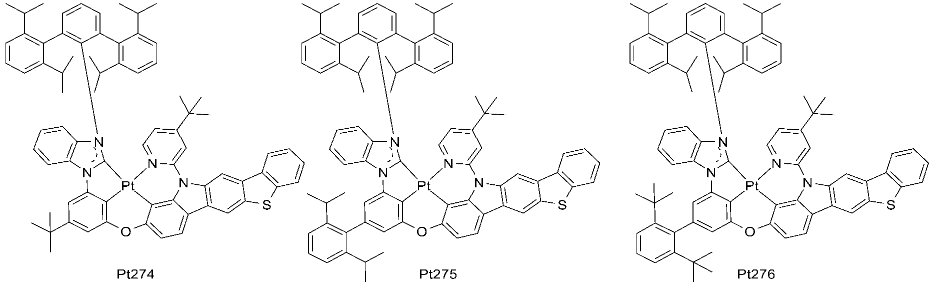

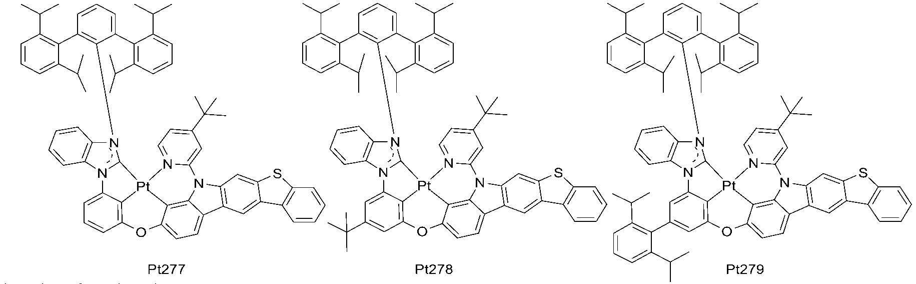

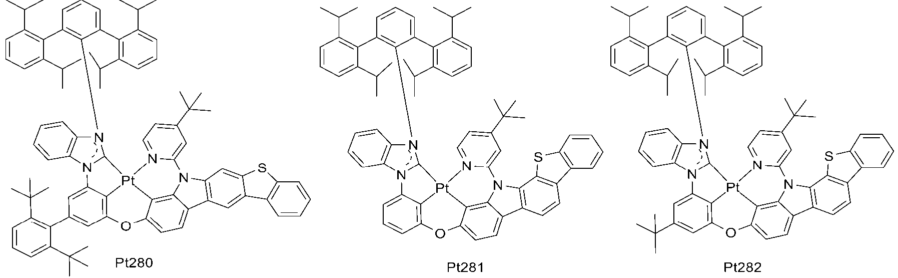

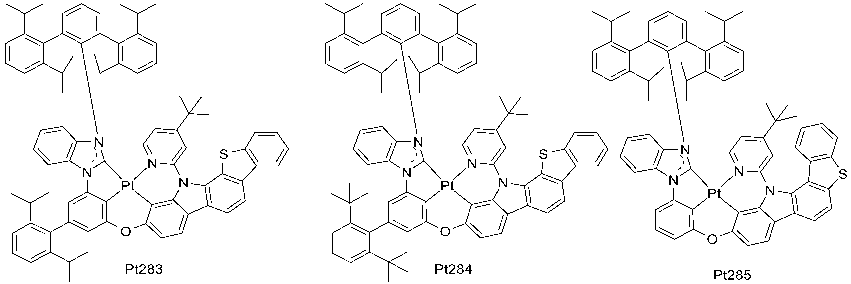

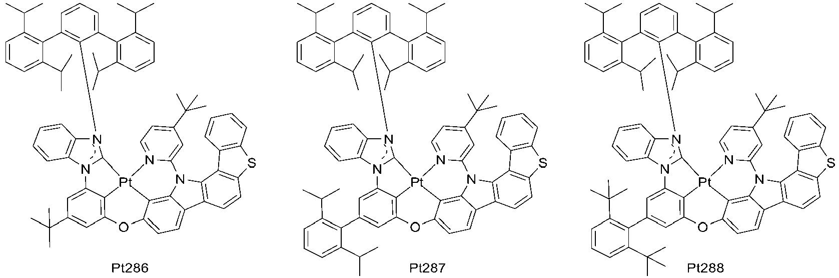

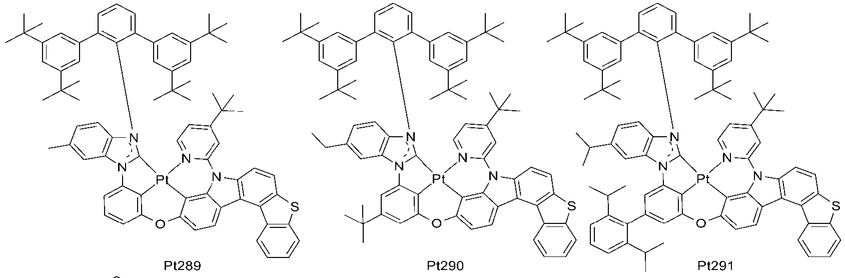

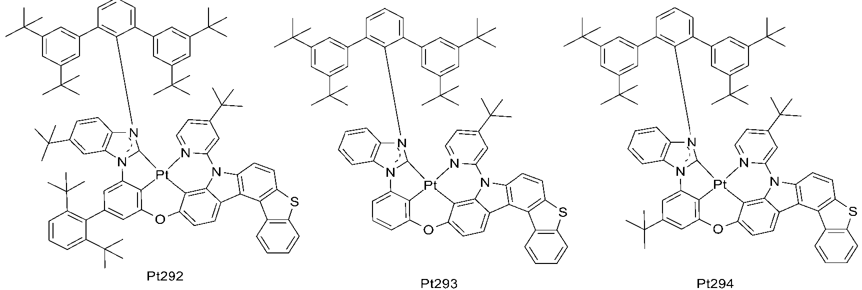

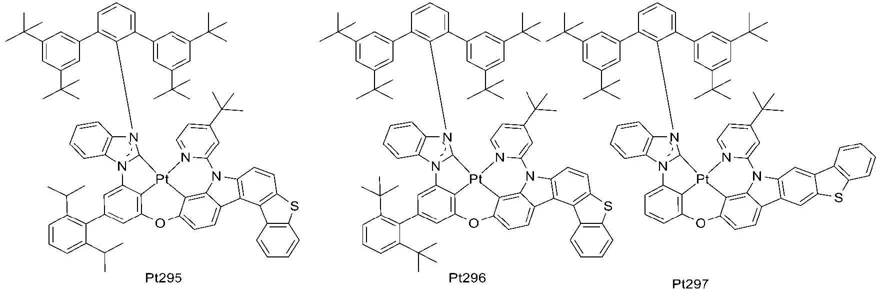

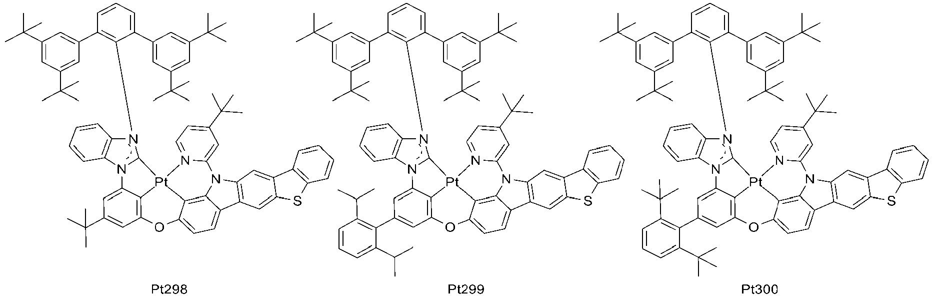

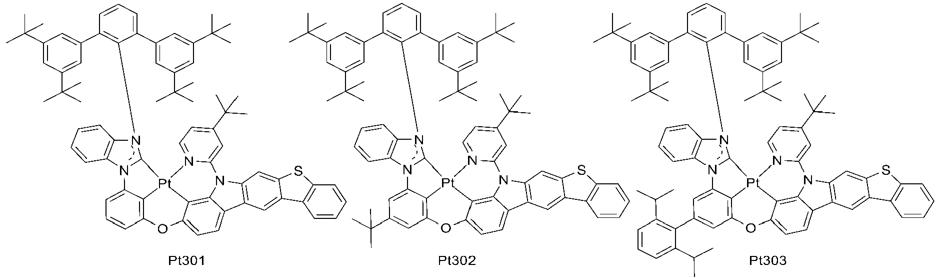

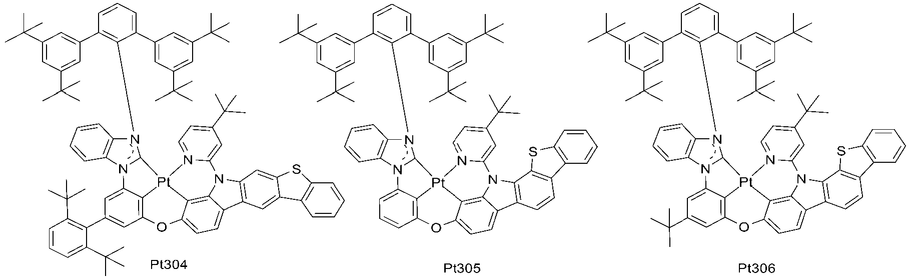

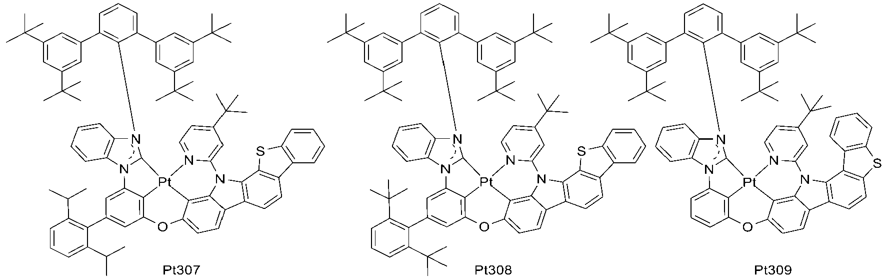

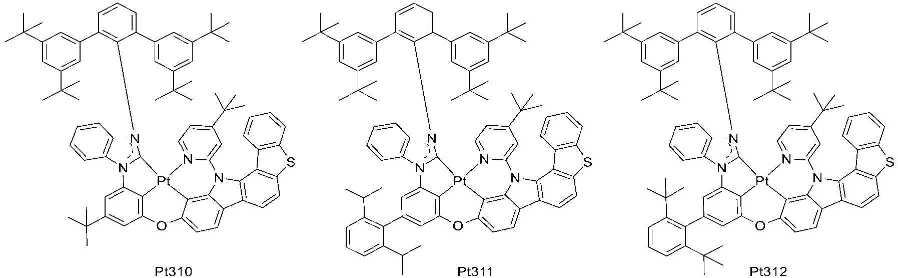

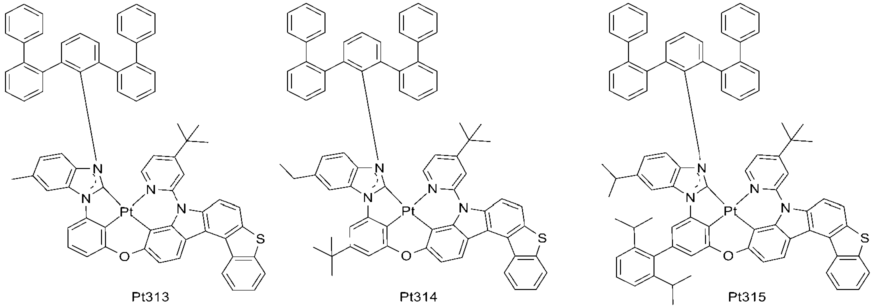

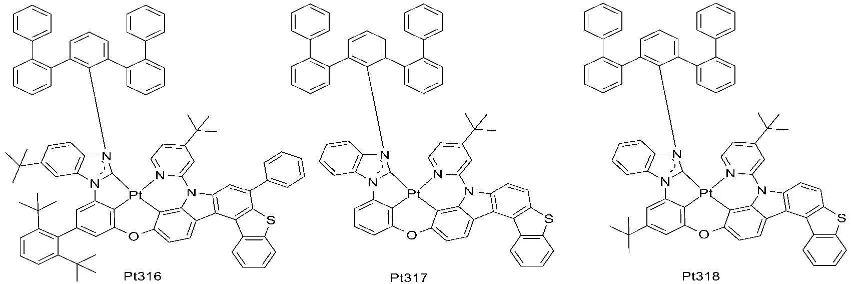

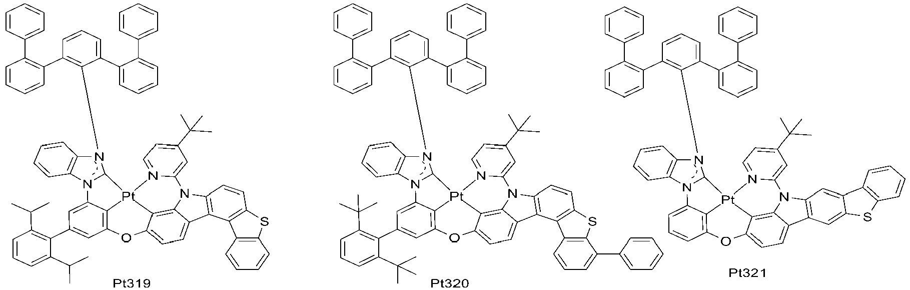

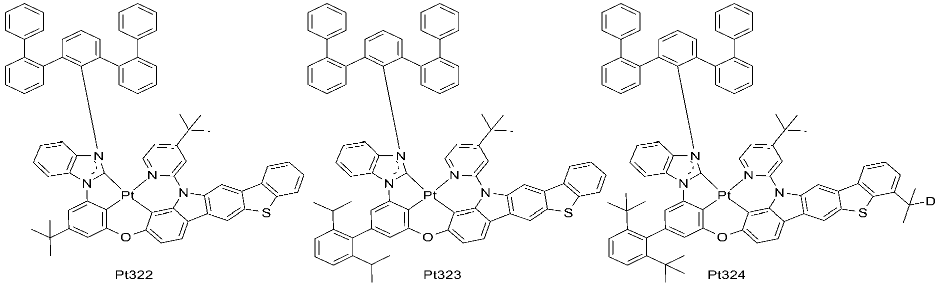

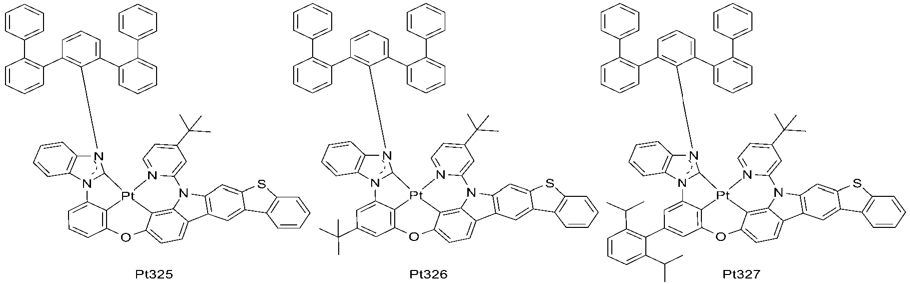

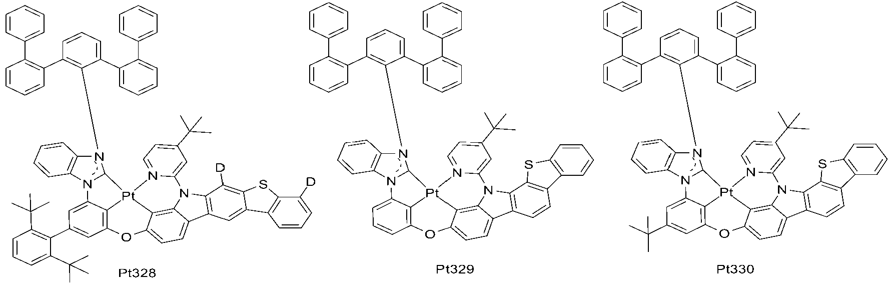

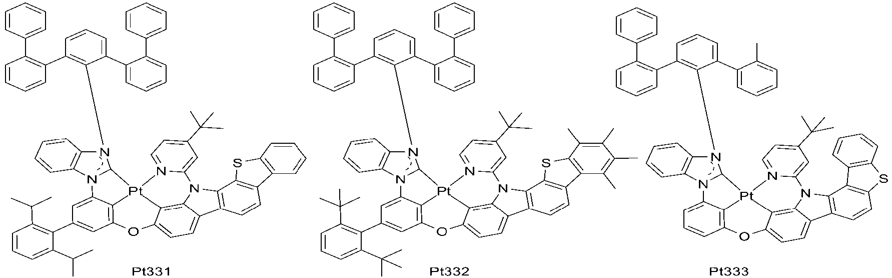

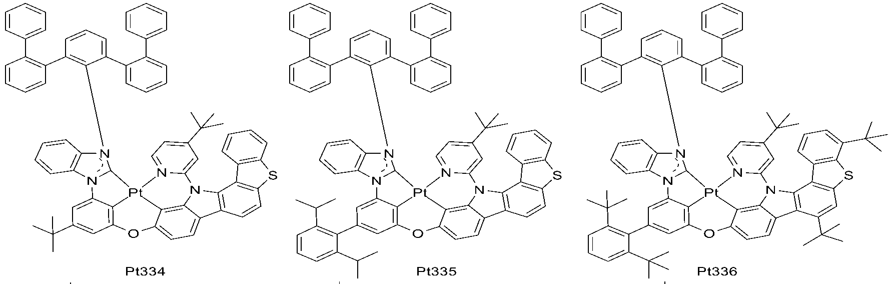

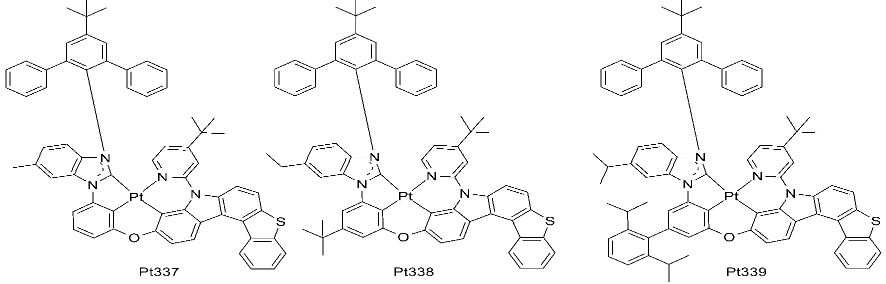

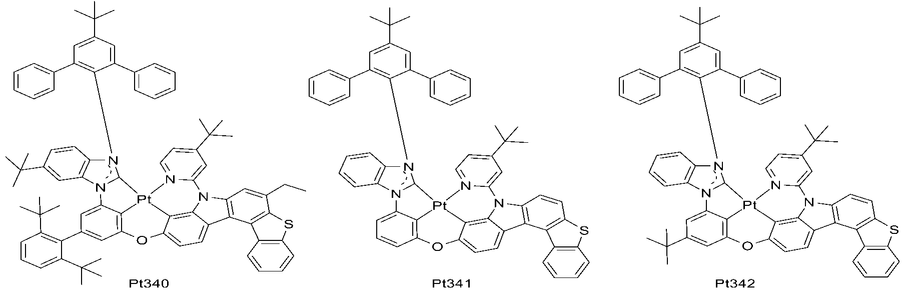

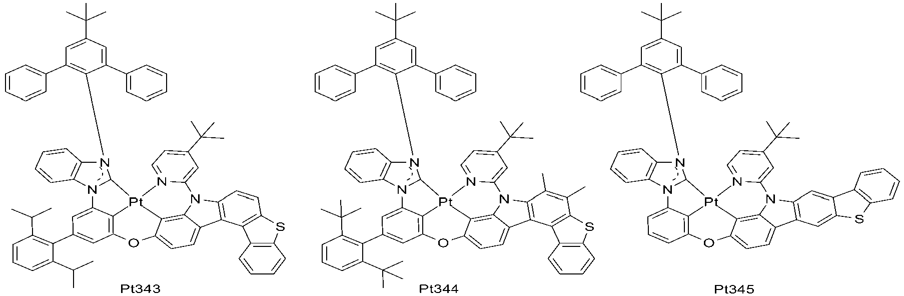

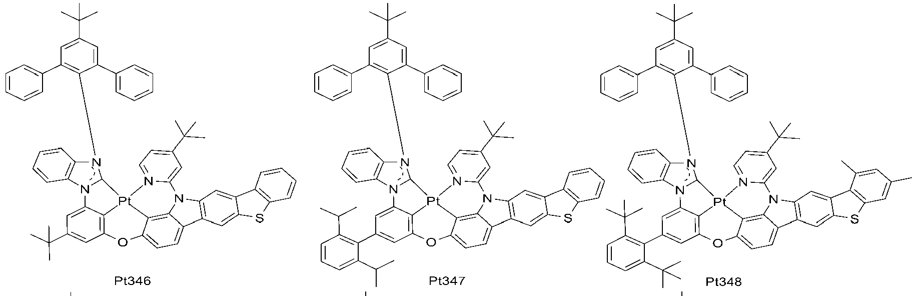

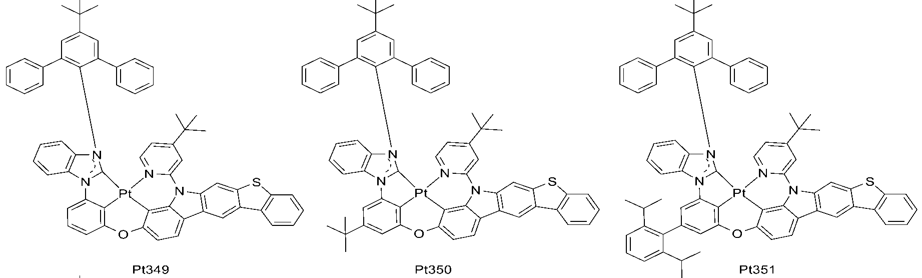

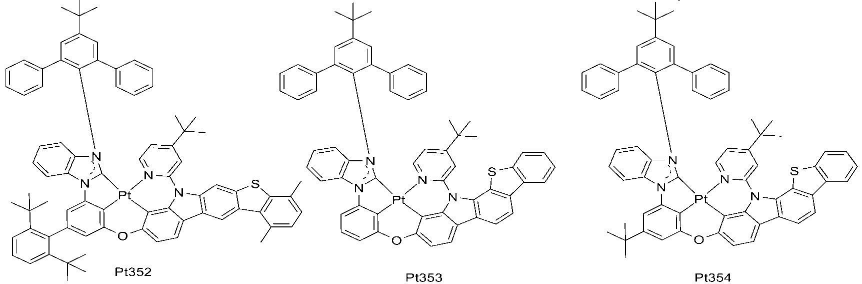

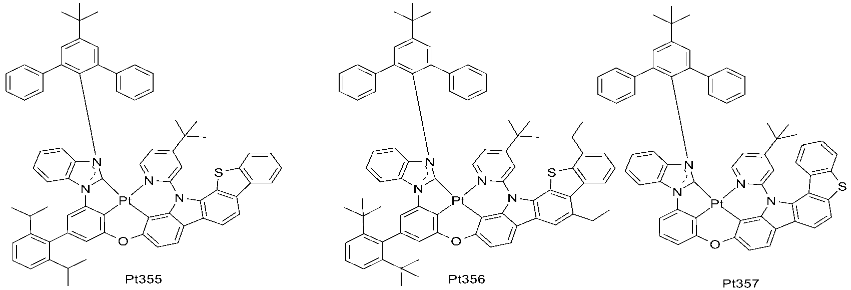

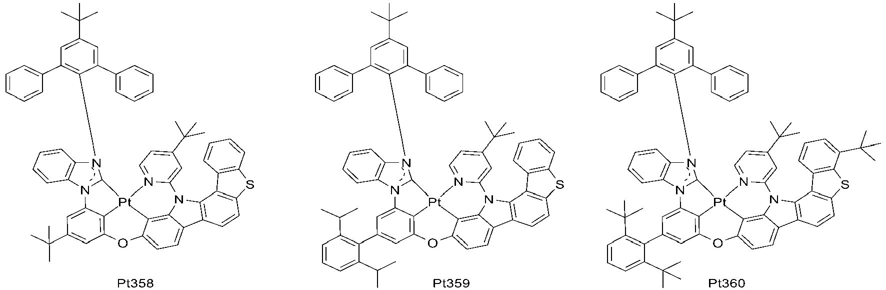

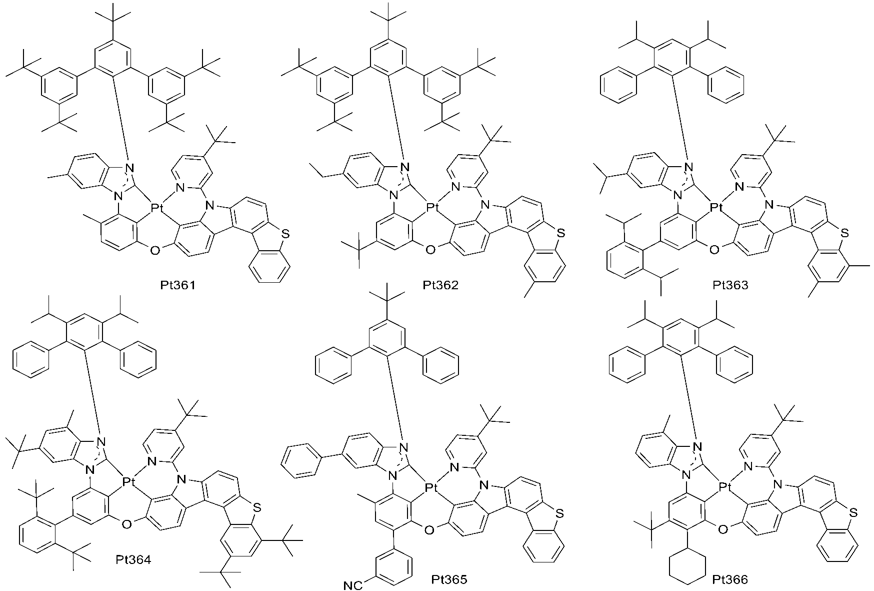

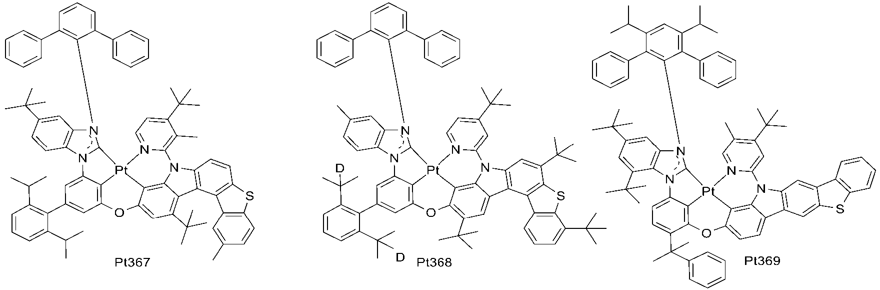

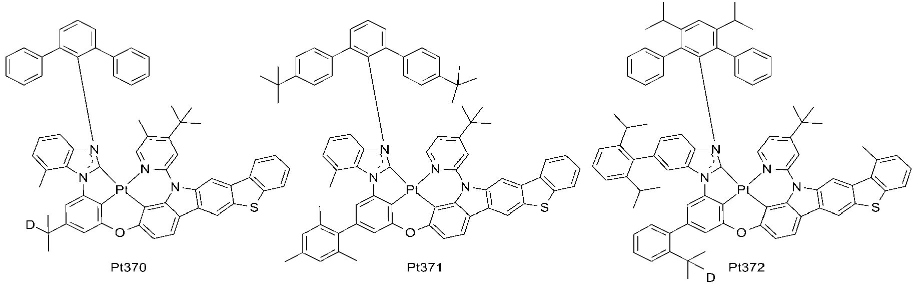

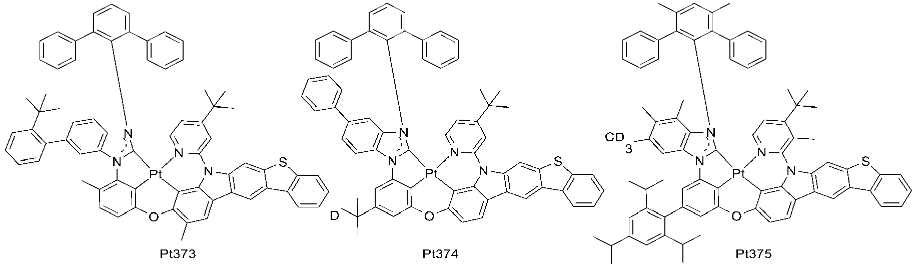

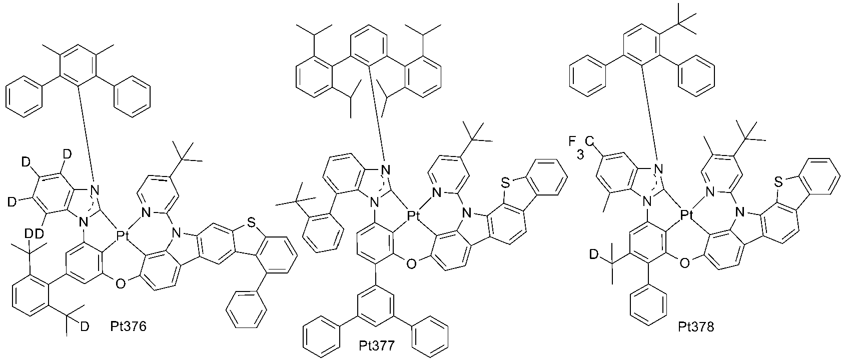

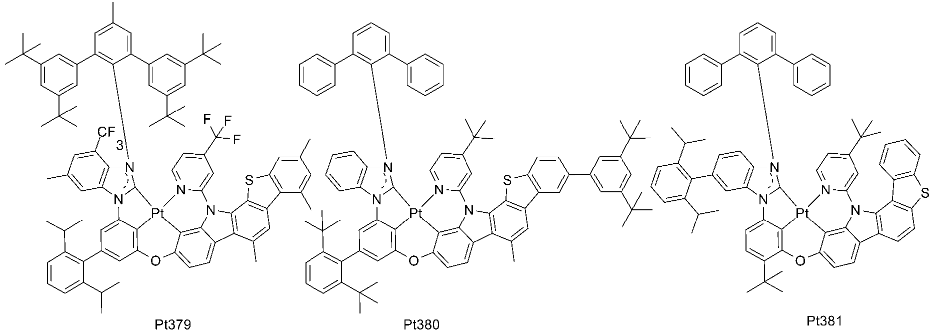

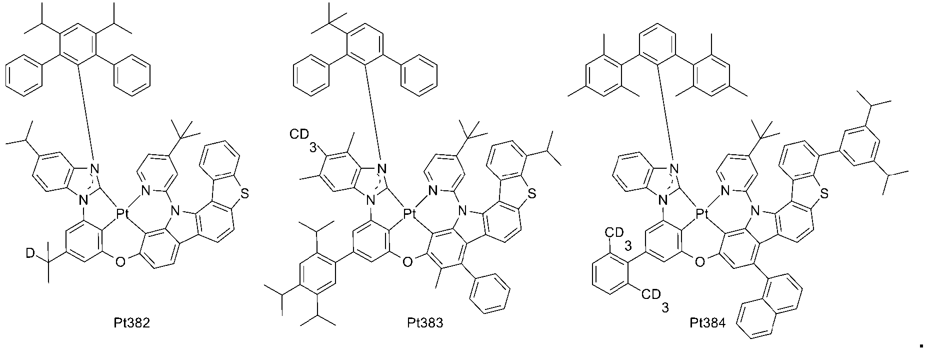

Furthermore, the present disclosure further provides an application of the fused-ring carbazole tetradentate platinum(II) complex having the structure selected from formulas (I) to (V) in an electronic device.

Furthermore, the electronic device includes an organic electroluminescent device (OLED), an organic integrated circuit (O-IC), an organic field-effect transistor (O-FET), an organic thin-film transistor (O-TFT), an organic light-emitting transistor (O-LET), an organic solar cell (O-SC), an organic optical detector, an organophotoreceptor, an organic field-quench device (O-FQD), a light-emitting electrochemical cell (LEC) and an organic laser diode (O-laser).

In another aspect, the present disclosure further provides an organic electroluminescent device. The organic electroluminescent device includes the fused-ring carbazole tetradentate platinum(II) complex having the structure selected from formulas (I) to (V).

Furthermore, the organic electroluminescent device includes a cathode, an anode and an organic functional layer between the cathode and the anode. The organic functional layer contains the fused-ring carbazole tetradentate platinum(II) complex having the structure selected from formulas (I) to (V).

Preferably, the organic functional layer includes a light-emitting layer. The light-emitting layer contains the fused-ring carbazole tetradentate platinum(II) complex having the structure selected from formulas (I) to (V).

Furthermore, the light-emitting layer further includes a fluorescent dopant material. The fluorescent dopant material is preferably a boron-containing organic molecular light-emitting material.

In still another aspect, the present disclosure further provides an organic optoelectronic device. The organic optoelectronic device includes: a substrate layer, a first electrode disposed on the substrate; an organic light-emitting functional layer disposed on the first electrode, and a second electrode disposed on the organic light-emitting functional layer. The organic light-emitting functional layer contains the fused-ring carbazole tetradentate platinum(II) complex having the structure selected from formula (I). For example, the platinum(II) complex may be contained as a light-emitting material in the organic light-emitting functional layer.

Furthermore, the organic light-emitting functional layer further includes any one or more fluorescent dopant materials. A fluorescent dopant material is preferably a boron-containing organic molecular light-emitting material. The fluorescent dopant material is preferably a boron-containing compound that is sensitizable to phosphorescence.

In the present disclosure, the organic optoelectronic device may fabricated as follows: forming an anode on a substrate by depositing a metal, an conductive oxide, or an alloy thereof by means of a method such as sputter coating, electron beam evaporation or vacuum evaporation; sequentially depositing a hole injection layer, a hole transport layer, a light-emitting layer, a hole blocking layer and an electron transport layer on a surface of the formed anode; then, depositing a cathode. In addition to the above method, the organic electroluminescent device may also be fabricated by sequentially depositing a cathode, an organic layer and an anode on a substrate. The organic layer may also include a plurality of layers of structures such as a hole injection layer, a hole transport layer, a light-emitting layer, a hole blocking layer and an electron transport layer. In the present disclosure, the organic layer is formed by using a polymer material via a solution-processing method (e.g., spin-coating, tape-casting, doctor-blading, screenprinting, inkjet printing or thermal imaging) instead of vapor evaporation, which may reduce the number of layers of a device.

The present disclosure further provides a composition. The composition contains the fused-ring carbazole tetradentate platinum(II) complex having the structure selected from formulas (I) to (V). Preferably, the composition further contains a fluorescent dopant material. The fluorescent dopant material is preferably a boron-containing organic molecular light-emitting material. The fluorescent dopant material is preferably a boron-containing compound that is sensitizable to phosphorescence.

The present disclosure further provides a formulation. The formulation contains the fused-ring carbazole tetradentate platinum(II) complex having the structure selected from formulas (I) to (V) and at least one solvent, or contains the composition described above and at least one solvent.

The solvent is not particularly limited, and may be used, for example, an unsaturated hydrocarbon solvent such as toluene, xylene, mesitylene, tetralin, decahydronaphthalene, dicyclohexane, n-butylbenzene, sec-butylbenzene or tert-butylbenzene, or a halogenated saturated hydrocarbon solvent such as carbon tetrachloride, chloroform, dichloromethane, dichloroethane, chlorobutane, bromobutane, chloropentane, bromopentane, chlorohexane, bromohexane, chlorocyclohexane or bromocyclohexane, or a halogenated unsaturated hydrocarbon solvent such as chlorobenzene, dichlorobenzene or trichlorobenzene, or an ether solvent such as tetrahydrofuran or tetrahydropyran, or an ester solvent such as alkyl benzoate, as well known to those skilled in the art.

The present disclosure further provides a display or lighting apparatus. The apparatus includes at least one organic optoelectronic device each as described above.

**Compared with the prior art, the beneficial effects of the present disclosure are as follows:**
The present disclosure provides a system in which benzofuran or benzothiophene is introduced at different positions of carbazole, so as to increase a proportion of a locally excited (LE) state within an excited triplet state of the cyclic tetradentate platinum(II) complex, thereby endowing the complex with a reduced emission shoulder and improving color purity of light emitted by molecules of a material. Materials of the present disclosure all exhibit excellent chemical stability and thermal stability, facilitating the fabrication of vacuum-evaporated OLED devices. Combining the materials of the present disclosure with fluorescent dopant materials may balance transport of holes and electrons, and enhance efficient energy transfer between a host and a guest. Organic electroluminescent devices fabricated with compounds of the present disclosure as light-emitting layers demonstrate significant improvements in both current efficiency and lifetime, while also markedly reducing a turn-on voltage. Particularly, when the compounds of the present disclosure are used in combination with boron-containing compounds sensitized by phosphorescence materials, light color purity of devices may be improved.

### BRIEF DESCRIPTION OF DRAWINGS

FIG.1 shows emission spectra of compounds **Pt150** and **R1** in a dichloromethane solution at room temperature;
FIG.2 shows emission spectra of compounds **Pt162** and **R1** in a dichloromethane solution at room temperature; and
FIG.3 shows emission spectra of compounds **Pt166** and **R1** in a dichloromethane solution at room temperature.

### DETAILED DESCRIPTION

The content of the present disclosure is to be described in detail below. The description of constituent elements below is sometimes formed based on representative embodiments or specific examples of the present disclosure, but the disclosure is not limited to such embodiments or examples.

The term "substituted" as used herein is intended to encompass all allowable substituents for organic compounds. In a broad sense, the allowable substituents include acyclic and cyclic, branched and unbranched, carbocyclic and heterocyclic, and aromatic and non-aromatic substituents for organic compounds. Illustrative substituents include, for example, those described below. The allowable substituents for a suitable organic compound may include one or more substituents, which may be identical or different. For the purposes of the present disclosure, the present disclosure is not intended to limit, in any manner, allowable substituents for organic compounds. Similarly, the terms "substitution" or "substituted with" carry the implicit condition that such substitution conforms to allowable valence bonds of an atom being substituted and a substituent, and that the substitution results in a stable compound (i.e., a compound that does not spontaneously undergo transformation, such as through rearrangement, cyclization or elimination). It is also anticipated that, in certain aspects, unless explicitly indicated to the contrary, an individual substituent may be further optionally substituted (i.e., the individual substituent may be further substituted or unsubstituted).

In defining various terms, "R¹"-"R⁹" are used as general symbols in the present disclosure to denote various specific substituents. The symbols may be any substituents, not limited to those disclosed in the present disclosure; and when defined as certain substituents in one case, the symbols may also be defined as other substituents in other cases. "R¹", "R²" ... "Rⁿ" (where n is an integer) used in the present disclosure may independently possess one or more of the groups listed above. For example, if R¹ is a linear alkyl group, a hydrogen atom of the alkyl group may optionally be substituted with a hydroxyl group, an alkoxy group, an alkyl group, halogen, etc. Depending on selected groups, a first group may be incorporated within a second group; alternatively, a first group may be suspended from, i.e., connected to, a second group.

The terms "alkyl" and "alkyl group" as used in the present disclosure each refer to a branched or unbranched saturated hydrocarbyl group having 1 to 60 carbon atoms, such as methyl, ethyl, n-propyl, isopropyl, n-butyl, isobutyl, sec-butyl, tert-butyl, n-pentyl, isopentyl, sec-pentyl, neopentyl, hexyl, heptyl, octyl, nonyl, decyl, dodecyl, tetradecyl, hexadecyl, octadecyl, eicosyl and tetracosyl. The alkyl group may be cyclic or non-cyclic. The alkyl group may be branched or unbranched. The alkyl group may also be substituted or unsubstituted. For example, the alkyl group may be substituted with one or more substituents, and includes but not limited to optionally substituted alkyl, cycloalkyl, alkoxy, amino, halogen, hydroxyl, nitro, silyl, sulfur-oxo (sulfo-oxo), or mercapto groups as described in the present disclosure.

The term "aryl" and "aryl group" as used herein each refer to a group containing any carbon-based aromatic group containing 5 to 60 carbon atoms. The carbon-based aromatic group includes, but is not limited to, phenyl, naphthyl, phenyl, biphenyl, phenoxyphenyl, anthryl, phenanthryl, etc. The terms "aryl" and "aryl group" each also include "heteroaryl" or "heteroaryl group", and are each defined as a group containing an aromatic group, the aromatic group possessing at least one heteroatom introduced into a ring of the aromatic group. Examples of a heteroatom include but are not limited to a nitrogen atom, an oxygen atom, a sulfur atom and a phosphorus atom. Similarly, the terms "non-heteroaryl" and "non-heteroaryl group" (which are also included in the terms "aryl" and "aryl group") each define groups containing an aromatic group, the aromatic group containing no heteroatoms. The aryl group may be substituted or unsubstituted. The aryl group may be substituted with one or more substituents, a substituent therein including but not limited to alkyl, cycloalkyl, alkoxy, alkenyl, cycloalkenyl, alkynyl, cycloalkynyl, aryl, heteroaryl, aldehyde, amino, carboxyl, ester, halogen, hydroxyl, carbonyl, azido, nitro, silyl, sulfur-oxo (sulfo-oxo) and mercapto listed in the present disclosure.

Compounds disclosed herein can exhibit desired properties and possess emission spectra and/or absorption spectra that can be modulated by selecting suitable ligands. In another aspect, the present disclosure may exclude any one or more of the compounds, structures, or parts thereof specifically described herein. The compounds of the present disclosure may be prepared by various methods, including but not limited to those described in embodiments provided herein.

It will be noted that both the general description above and the detailed description below are merely illustrative and explanatory, but are not intended to be limiting. The present disclosure may be more readily understood by reference to specific embodiments and examples included therein.

Before disclosing and describing the compounds of the present disclosure, devices and/or methods of the present disclosure, it will be understood that they are not limited to specific synthesis methods (unless otherwise indicated) or specific reagents (unless otherwise indicated), as these are readily variable. It will also be understood that the terms used herein are intended solely for the purpose of describing specific aspects, but are not intended to be limiting. Any methods and materials similar or equivalent to those described herein may be used in the practice or testing, and exemplary methods and materials are to be described below. All raw materials and solvents used in synthetic examples are commercially available unless otherwise specified. The solvents are used as received without further processing.

A substrate described herein may be any substrate used in typical organic optoelectronic devices. The substrate may be a glass substrate or a transparent plastic substrate, or may be a substrate of an opaque material such as silicon or stainless steel, or may be a flexible polyimide (PI) film. Different substrates are different in mechanical strength, thermal stability, transparency, surface smoothness and waterproofness; and depending on natures of the different substrates, the different substrates are used in different directions. Materials for a hole injection layer, a hole transport layer and an electron injection layer may be selected from any known relevant materials used in OLED apparatuses, which is not specially limited in the present disclosure.

### Synthesis Embodiments

Examples of compound synthesis, composition, devices or methods below are provided solely to illustrate general approaches within the field, but are not intended to limit the scope of protection of the present disclosure. While every effort has been made to ensure the accuracy of data (quantities, temperatures, etc.) presented herein, some discrepancies may exist. Unless otherwise specified, all weights are measured separately, temperatures refer to 25 degrees Celsius (°C) or room temperature (RT), and pressures are near atmospheric pressure.

The examples below provide methods for preparing new compounds, but the preparation of such compounds is not limited thereto. In the specialized technical field, since the compounds disclosed in the present disclosure are readily modified and prepared, synthesis of the compounds may be achieved by using the methods listed below or other methods. The following examples are provided merely as illustrations, but are not intended to limit the scope of protection of the present disclosure. Temperatures, catalysts, concentrations, reactants and reaction processes may all be modified, so as to select different conditions for preparing the compounds from various reactants.

¹H NMR (500 MHz) spectra, ¹H NMR (400 MHz) spectra and ¹³C NMR (126 MHz) spectra are measured on an ANANCE III (500 MHz) nuclear magnetic resonance spectrometer. Unless otherwise specified, the NMR spectra are all recorded by using dimethyl sulfoxide-*d₆* (DMSO-*d₆*) or CDCl₃ containing 0.1% (w/w) tetramethylsilane (TMS) as a solvent. For ¹H NMR spectra recorded by using CDCl₃ as a solvent, TMS (δ=0.00 ppm) serves as an internal standard; and for ¹H NMR spectra recorded by using DMSO-*d₆* as a solvent, TMS (δ=0.00 ppm), a residual DMSO peak (δ=2.50 ppm) or a residual water peak (δ=3.33 ppm) serves as an internal standard. In ¹³C NMR spectra, CDCl₃ (δ=77.00 ppm) or DMSO-*d₆* (δ=39.52 ppm) serves as an internal standard. High performance liquid chromatography-mass spectrometry (HPLC-MS) spectra are measured on an Agilent 6210 TOF LC/MS mass spectrometer. High-resolution mass spectrometry (HRMS) spectra are measured on an Agilent 6210 TOF LC/MS liquid chromatography time-of-flight mass spectrometer. In data of the ¹H NMR spectra, s=singlet, d=doublet, t=triplet, q=quartet, p=quintet, m=multiplet, br=broad.

### Synthesis Route

### Embodiment 1: Tetradentate Cyclometalated Platinum(II) Complex Phosphorescent Light-Emitting Material Pt150

**The synthesis route is as follows:**

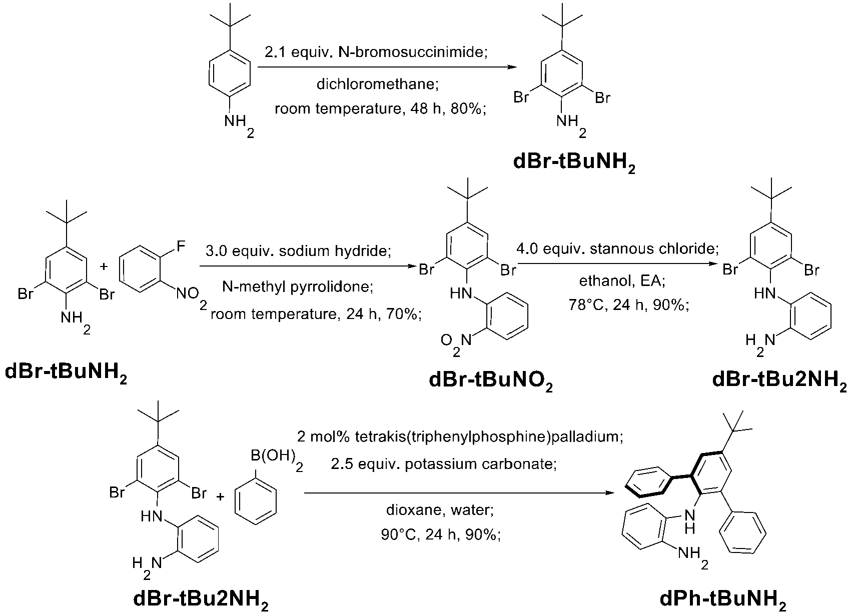

Synthesis of Intermediate **dBr-tBuNH₂:** P-tert-butylaniline (15.0 g, 100 mmol, 1.0 equivalent) and dichloromethane (150 mL) are added into a reaction flask and dissolved; then, N-bromosuccinimide (37.7 g, 210 mmol, 2.1 equivalents) is added; the mixture is allowed to react at room temperature for 48 hours, and then the reaction is stopped; and the reacted mixture is concentrated, and then purified by silica gel column chromatography to afford 25.6 g of a red liquid in 80% yield. The red liquid is directly used in a subsequent reaction.

Synthesis of Intermediate **dBr-tBuNO₂:** Intermediate **dBr-tBuNH₂** (5 g, 16.3 mmol, 1.0 equivalent) is added into a reaction flask, and dissolved by using N-methyl pyrrolidone (50 mL); sodium hydride (1.96 g, 49 mmol, 3.0 equivalents) is added; then, o-fluoronitrobenzene (3.45 g, 24.5 mmol, 1.5 equivalents) is added; the mixture is allowed to react at room temperature for 48 hours, and then the reaction is stopped; and the reacted mixture is concentrated, and then purified by silica gel column chromatography to afford 5.08 g of a yellow solid in 70% yield. The yellow solid is directly used in a subsequent reaction.

Synthesis of Intermediate **dBr-tBu2NH₂:** Intermediate **dBr-tBuNO₂** (4.8 g, 11.2 mmol, 1.0 equivalent) and stannous chloride (10.1 g, 44.8 mmol, 4.0 equivalents) are added into a reaction flask; then, ethyl acetate (EA) (50 mL) and ethanol (50 mL) are added; the mixture is allowed to react at 78°C for 24 hours, and then the reaction is stopped; and the reacted mixture is cooled to room temperature, concentrated and purified by silica gel column chromatography to afford 3.43 g of a white solid in 90% yield. The white solid is directly used in a subsequent reaction.

Synthesis of Intermediate **dPh-tBuNH₂:** Intermediate **dBr-tBu2NH₂** (3.2 g, 8 mmol, 1.0 equivalent), phenylboronic acid (2.93 g, 24 mmol, 3.0 equivalents), tetrakis(triphenylphosphine)palladium (185 mg, 0.16 mmol, 0.02 equivalents), sodium carbonate (2.8 g, 20 mmol, 2.5 equivalents), dioxane (40 mL) and water (15 mL) are added into a reaction flask; the mixture is allowed to react at 90°C for 24 hours, and then the reaction is stopped; and the reacted mixture is cooled to room temperature, concentrated and purified by silica gel column chromatography to afford 2.66 g of a white solid in 90% yield. A ¹H NMR characterization result for the white solid is as follows: ¹H NMR (500 MHz, DMSO) δ 1.35 (s, 9H), 4.44 (s, 2H), 5.57 (s, 1H), 6.05 (dd, *J*=8.0, 1.5 Hz, 1H), 6.12 (td, *J*=7.5, 1.5 Hz, 1H), 6.25 (td, *J*=7.6, 1.5 Hz, 1H), 6.31 (dd, *J*=7.5, 1.5 Hz, 1H), 7.20-7.16 (m, 2H), 7.25 (t, *J*=7.5 Hz, 4H), 7.28 (s, 2H), 7.43-7.41 (m, 4H).

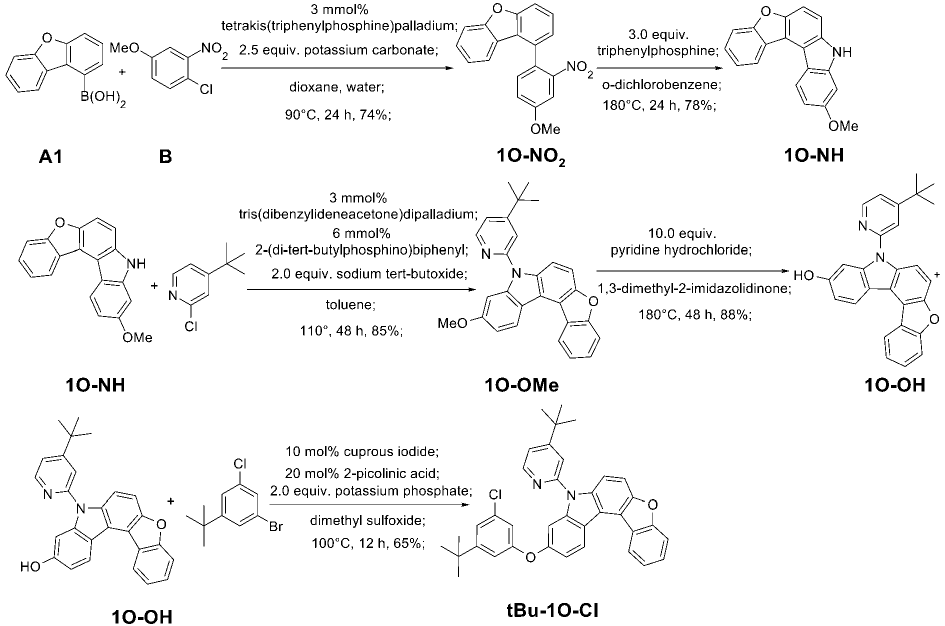

Synthesis of Intermediate **1O-NO₂:** Compound **AI** (13.55 g, 63.9 mmol, 1.5 equivalents), compound **B** (8 g, 42.6 mmol, 1.0 equivalent), tetrakis(triphenylphosphine)palladium (1.47 g, 1.28 mmol, 3 mol%) and potassium carbonate (11.78 g, 85.2 mmol, 2.0 equivalents) are added into a reaction flask; then, dioxane (80 mL) and water (20 mL) are added; the mixture is allowed to react at 90°C for 24 hours, and then the reaction is stopped; and the reacted mixture is cooled to room temperature, concentrated and purified by silica gel column chromatography to afford 10 g of a yellow solid in 74% yield. A ¹H NMR characterization result for the yellow solid is as follows: ¹H NMR (400 MHz, DMSO-*d₆*) δ 3.97 (s, 3H), 6.97 (d, *J*=7.2 Hz, 1H), 7.20 (td, *J*=7.6, 0.8 Hz, 2H), 7.46-7.51 (m, 2H), 7.56-7.60 (m, 2H), 7.72-7.77 (m, 3H).

Synthesis of Intermediate **1O-NH:** Intermediate **10-NO₂** (10 g, 31.3 mmol, 1.0 equivalent) and triphenylphosphine (32.84 g, 125.2 mmol, 3.0 equivalents) are added into a reaction flask; then, o-dichlorobenzene (60 mL) is added; the mixture is allowed to react at 110°C for 24 hours, and then the reaction is stopped; and the reacted mixture is cooled to room temperature, concentrated and purified by silica gel column chromatography to afford 6.89 g of a brown solid in 78% yield. The brown solid is directly used in a subsequent reaction.

Synthesis of Intermediate **1O-OMe:** Intermediate **1O-NH** (5.3 g, 18.4 mmol, 1.0 equivalent), 4-(tert-butyl)-2-chloropyridine (4.05 g, 23.9 mmol, 1.3 equivalents), tris(dibenzylideneacetone)dipalladium (673 mg, 1.10 mmol, 3 mol%), 2-(di-tert-butylphosphino)biphenyl (JohnPhos) (603 mg, 2.2 mmol, 6 mol%) and sodium tert-butoxide (3.54 g, 36.8 mmol, 2.0 equivalents) are added into a reaction flask; then, toluene (50 mL) is added; the mixture is heated to 110°C in an oil bath for reaction for 48 hours, and then the reaction is stopped; the reacted mixture is cooled to room temperature, concentrated and purified by silica gel column chromatography to afford 6.59 g of a brown solid in 85% yield. The brown solid is directly used in a subsequent reaction.

Synthesis of Intermediate **1O-OH:** Intermediate **1O-OMe** (6 g, 14.3 mmol, 1.0 equivalent) and pyridine hydrochloride (16.53 g, 143 mmol, 10.0 equivalents) are added into a reaction flask; then, 1,3-dimethyl-2-imidazolidinone (60 mL) is added; the mixture is heated to 180°C in an oil bath for reaction for 48 hours, and then the reaction is stopped; the reacted mixture is cooled to room temperature, concentrated and purified by silica gel column chromatography to afford 5.43 g of a brown solid in 88% yield. The brown solid is directly used in a subsequent reaction.

Synthesis of Intermediate **tBu-1O-Cl:** Intermediate **1O-OH** (1.6 g, 3.9 mmol, 1.0 equivalent), 1-tert-butyl-3-chloro-5-bromobenzene (1.25 g, 5.1 mmol, 1.3 equivalents), 2-picolinic acid (96 mg, 0.78 mmol, 20 mmol%), cuprous iodide (74 mg, 0.39 mmol, 10 mmol%) and potassium phosphate (1.66 g, 7.8 mmol, 2.0 equivalents) are added into a reaction flask; then, dimethyl sulfoxide (10 mL) is added; the mixture is allowed to react at 100°C for 12 hours, and then the reaction is stopped; and the reacted mixture is cooled to room temperature, concentrated and purified by silica gel column chromatography to afford 566 mg of a white solid in 65% yield. A ¹H NMR characterization result for the white solid is as follows: ¹H NMR (500 MHz, DMSO) δ 1.24 (s, 9H), 1.31 (s, 9H), 6.99 (t, *J*=2.0 Hz, 1H), 7.15 (t, *J*=2.0 Hz, 1H), 7.22-7.26 (m, 2H), 7.30 (d, *J*=2.5 Hz, 1H), 7.54 (dd, *J*=5.5, 1.5 Hz, 1H), 7.63-7.67 (m, 1H), 7.58-7.61 (m, 1H), 7.70 (d, *J*=2.0 Hz, 1H), 7.83-7.86 (m, 2H), 7.91 (d, *J*=9.0 Hz, 1H), 8.63 (d, *J*=5.0 Hz, 1H), 8.75 (d, *J*=7.5 Hz, 1H), 8.80 (d, J=8.5 Hz, 1H).

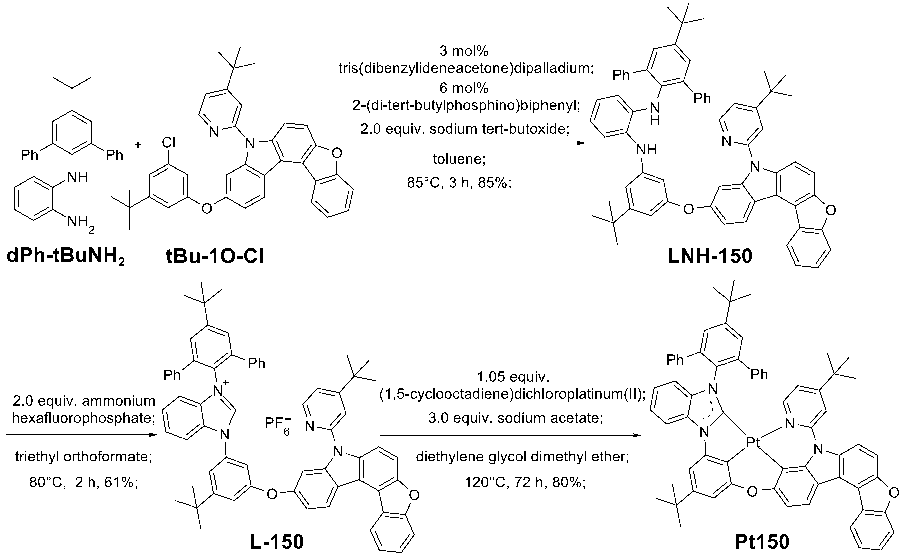

Synthesis of Intermediate **LNH-150:** Intermediate **dPh-tBuNH₂** (411 mg, 1.04 mmol, 1.3 equivalents), intermediate **tBu-1O-Cl** (460 mg, 0.8 mmol, 1.0 equivalent), tris(dibenzylideneacetone)dipalladium (22 mg, 0.03 mmol, 3 mol%), 2-(di-tert-butylphosphino)biphenyl (20 mg, 0.05 mmol, 6 mol%) and sodium tert-butoxide (153 mg, 1.6 mmol, 2.0 equivalents) are added into a reaction flask; then, toluene (5 mL) is added; the mixture is allowed to react at 85°C for 3 hours, and then the reaction is stopped; and the reacted mixture is cooled to room temperature, concentrated and purified by silica gel column chromatography to afford 631 mg of a white solid in 85% yield. The white solid is directly used in a subsequent reaction.

Synthesis of Ligand **L-150:** Intermediate **LNH-150** (631 mg, 0.68 mmol, 1.0 equivalent) is added into a reaction flask; then, ammonium hexafluorophosphate (221 mg, 1.4 mmol, 2.0 equivalents) is added; then, triethyl orthoformate (5 mL) is added; the mixture is allowed to react at 80°C for 2 hours, and then the reaction is stopped; and the reacted mixture is cooled to room temperature, concentrated and purified by silica gel column chromatography to afford 435 mg of a white solid in 61% yield. A ¹H NMR characterization result for the white solid is as follows: ¹H NMR (500 MHz, DMSO) δ 1.28 (s, 9H), 1.31 (s, 9H), 1.43 (s, 9H), 6.91 (t, *J*=2.2 Hz, 1H), 6.99 (t, *J*=1.8 Hz, 1H), 7.10-7.18 (m, 11H), 7.33 (dd, *J*=9.0, 2.5 Hz, 1H), 7.46-7.50 (m, 2H), 7.52-7.57 (m, 4H), 7.59-7.62 (m, 1H), 7.64-7.72 (m, 4H), 7.75 (s, 1H), 7.86-7.90 (m, 2H), 7.93 (d, *J*=9.0 Hz, 1H), 8.64 (d, *J*=5.0 Hz, 1H), 8.77 (d, *J*=7.0 Hz, 1H), 8.88 (d, *J*=9.0 Hz, 1H), 10.27 (s, 1H).

Synthesis of **Pt150:** Ligand **L-150** (200 mg, 0.19 mmol, 1.0 equivalent), (1,5-cyclooctadiene)dichloroplatinum(II) (75 mg, 0.20 mmol, 1.05 equivalents) and sodium acetate (47 mg, 0.57 mmol, 3.0 equivalents) are added into a reaction flask; then, diethylene glycol dimethyl ether (10 mL) is added; the mixture is allowed to react at 120°C for 72 hours, and then the reaction is stopped; and the reacted mixture is cooled to room temperature, concentrated and purified by silica gel column chromatography to afford 250 mg of a pale yellow solid in 80% yield. A ¹H NMR characterization result for the pale yellow solid is as follows: ¹H NMR (500 MHz, CDCl₃) δ 1.20 (s, 9H), 1.44 (s, 9H), 1.47 (s, 9H), 6.06-6.82 (m, 7H), 6.92 (d, *J*=8.5 Hz, 1H), 7.05 (t, *J*=7.5 Hz, 1H), 7.15-7.18 (m, 2H), 7.24-7.48 (m, 4H), 7.54-7.75 (m, 8H), 7.93 (d, *J*=2.0 Hz, 1H), 7.98 (d, *J*=8.5 Hz, 1H), 8.03 (d, *J*=9.0 Hz, 1H), 8.41 (d, *J*=8.5 Hz, 1H), 8.75 (dd, *J*=7.0, 4.0 Hz, 1H), 9.07 (d, *J*=6.5 Hz, 1H).

### Embodiment 2: Tetradentate Cyclometalated Platinum(II) Complex Phosphorescent Light-Emitting Material Pt166

**The synthesis route is as follows:**

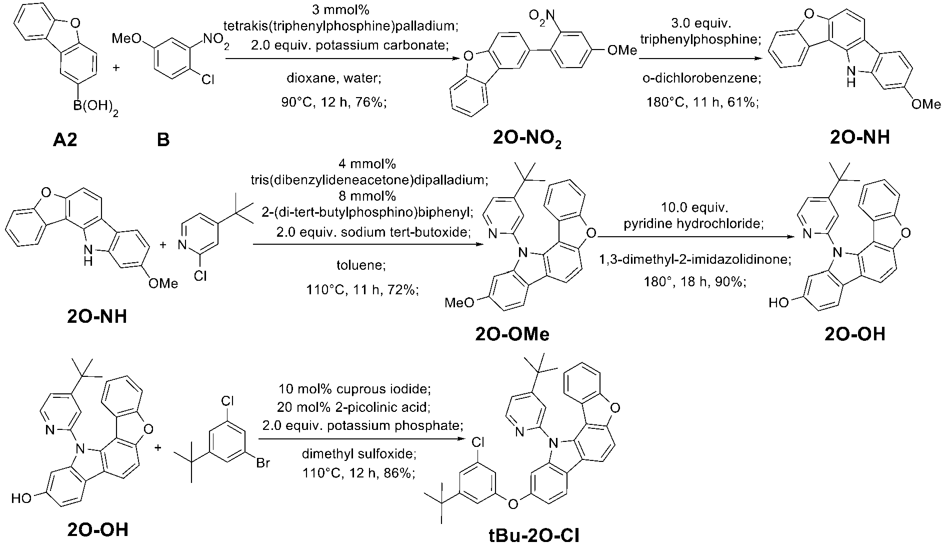

Synthesis of Intermediate **2O-NO₂:** Compound **A2** (25 g, 119.9 mmol, 1.5 equivalents), compound B (15 g, 79.7 mmol, 1.0 equivalent), tetrakis(triphenylphosphine)palladium (2.77 g, 2.4 mmol, 3 mol%) and potassium carbonate (22.1 g, 159.9 mmol, 2.0 equivalents) are added into a reaction flask; then, dioxane (160 mL) and water (40 mL) are added; the mixture is allowed to react at 90°C for 12 hours, and then the reaction is stopped; and the reacted mixture is cooled to room temperature, concentrated and purified by silica gel column chromatography to afford 19 g of a yellow solid in 76% yield. The yellow solid is directly used in a subsequent reaction.

Synthesis of Intermediate **2O-NH:** Intermediate **2O-NO₂** (19 g, 61.1 mmol, 1.0 equivalent) and triphenylphosphine (48.1 g, 183.4 mmol, 3.0 equivalents) are added into a reaction flask; then, o-dichlorobenzene (60 mL) is added; the mixture is allowed to react at 180°C for 11 hours, and then the reaction is stopped; and the reacted mixture is cooled to room temperature, concentrated and purified by silica gel column chromatography to afford 10.5 g of a brownish-white solid in 61% yield. A ¹H NMR characterization result for the brownish-white solid is as follows: ¹H NMR (400 MHz, DMSO-*d₆*) δ 3.89 (s, 3H), 6.88 (dd, *J*=8.4, 2.4 Hz, 1H), 7.12 (d, *J*=2.4 Hz, 1H), 7.48-7.54 (m, 3H), 7.74-7.77 (m, 1H), 8.07 (d, *J*=8.4 Hz, 1H), 8.17 (d, *J*=8.4 Hz, 1H), 8.59-8.61 (m, 1H), 11.95 (s, 1H).

Synthesis of Intermediate **2O-OMe:** Intermediate **2O-NH** (10 g, 34.8 mmol, 1.0 equivalent), 4-(tert-butyl)-2-chloropyridine (7.67 g, 45.2 mmol, 1.3 equivalents), tris(dibenzylideneacetone)dipalladium (1.27 g, 1.4 mmol, 4 mol%), 2-(di-tert-butylphosphino)biphenyl (830 mg, 2.8 mmol, 8 mol%) and sodium tert-butoxide (6.69 g, 69.6 mmol, 2.0 equivalents) are added into a reaction flask; then, toluene (100 mL) is added; the mixture is allowed to react at 110°C for 11 hours, and then the reaction is stopped; and the reacted mixture is cooled to room temperature, concentrated and purified by silica gel column chromatography to afford 10 g of a white solid in 72% yield. The white solid is directly used in a subsequent reaction.

Synthesis of Intermediate **2O-OH:** Intermediate **2O-OMe** (566 mg, 1.35 mmol, 1.0 equivalent) and pyridine hydrochloride (1.56 g, 13.5 mmol, 10.0 equivalents) are added into a reaction flask; then, 1,3-dimethyl-2-imidazolidinone (6 mL) is added; the mixture is allowed to react at 180°C for 18 hours, and then the reaction is stopped; and the reacted mixture is cooled to room temperature, concentrated and purified by silica gel column chromatography to afford 493 mg of a white solid in 90% yield. The white solid is directly used in a subsequent reaction.

Synthesis of Intermediate **tBu-2O-Cl:** Intermediate **2O-OH** (343 mg, 0.84 mmol, 1.0 equivalent), 1-tert-Butyl-3-chloro-5-bromobenzene (272 mg, 1.1 mmol, 1.3 equivalents), 2-picolinic acid (21 mg, 0.17 mmol, 20 mmol%), cuprous iodide (16 mg, 0.08 mmol, 10 mmol%) and potassium phosphate (356 mg, 1.7 mmol, 2.0 equivalents) are added into a reaction flask; then, dimethyl sulfoxide (5 mL) is added; the mixture is heated to 110°C in an oil bath for 12 hours, and then the reaction is stopped; and the reacted mixture is cooled to room temperature, concentrated and purified by silica gel column chromatography to afford 418 mg of a white solid in 86% yield. The white solid is directly used in a subsequent reaction.

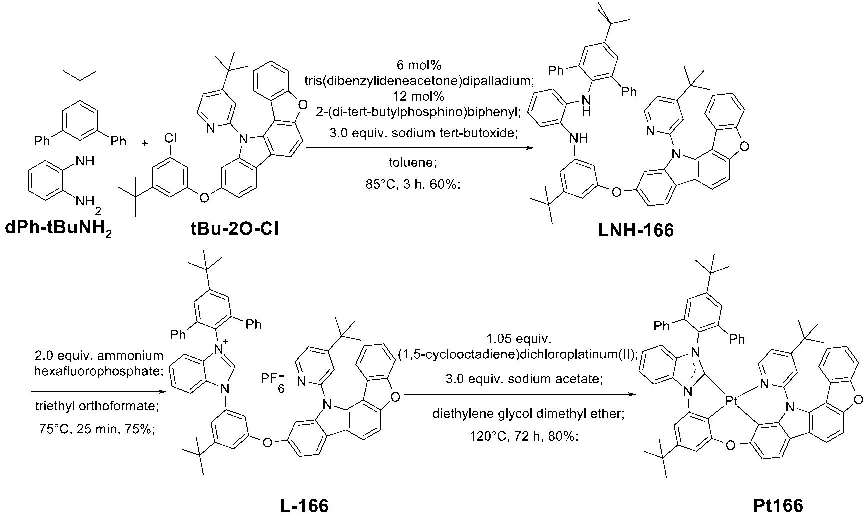

Synthesis of Intermediate **LNH-166:** Intermediate **dPh-tBuNH₂** (211 mg, 0.54 mmol, 1.2 equivalents) is added into a reaction flask; then, intermediate **tBu-2O-Cl** (256 mg, 0.45 mmol, 1.0 equivalent), tris(dibenzylideneacetone)dipalladium (24.7 mg, 0.03 mmol, 6 mol%), 2-(di-tert-butylphosphino)biphenyl (16 mg, 0.05 mmol, 12 mol%) and sodium tert-butoxide (129 mg, 1.3 mmol, 3.0 equivalents) are added; then, toluene (5 mL) is added; the mixture is allowed to react at 85°C for 3 hours, and then the reaction is stopped; and the reacted mixture is cooled to room temperature, concentrated and purified by silica gel column chromatography to afford 250 mg of a green solid in 60% yield. The green solid is directly used in a subsequent reaction.

Synthesis of Ligand **L-166:** Intermediate **LNH-166** (237 mg, 0.26 mmol, 1.0 equivalent) is added into a reaction flask; then, ammonium hexafluorophosphate (84.8 mg, 0.52 mmol, 2.0 equivalents) is added; then, triethyl orthoformate (5 mL) is added; the mixture is allowed to react at 75°C for 25 minutes, and then the reaction is stopped; and the reacted mixture is cooled to room temperature, concentrated and purified by silica gel column chromatography to afford 180 mg of a white solid in 75% yield.

Synthesis of **Pt166:** Ligand **L-166** (27 mg, 0.025 mmol, 1.0 equivalent) is added into a reaction flask; then, (1,5-cyclooctadiene)dichloroplatinum(II) (10 mg, 0.026 mmol, 1.05 equivalents) and sodium acetate (6.15 mg, 0.075 mmol, 3.0 equivalents) are added; then, diethylene glycol dimethyl ether (3 mL) is added; the mixture is allowed to react at 120°C for 72 hours, and then the reaction is stopped; and the reacted mixture is cooled to room temperature, concentrated and purified by silica gel column chromatography to afford 18 mg of a pale yellow solid in 80% yield. A ¹H NMR characterization result for the pale yellow solid is as follows: ¹H NMR (500 MHz, DMSO) δ 0.78 (s, 9H), 1.43 (s, 9H), 1.58 (s, 9H), 6.49 (t, J=8.0 Hz, 2H), 6.66 (t, J=7.5 Hz, 1H), 6.81 (dd, J=6.0, 2.0 Hz, 1H), 6.95-7.0 (m, 5H), 7.14 (d, J=2.0 Hz, 1H), 7.20 (td, J=7.5, 3.0 Hz, 2H), 7.26-7.37 (m, 5H), 7.46 (d, J=2.5 Hz, 1H), 7.55 (d, J=1.5 Hz, 1H), 7.59 (d, J=7.0 Hz, 2H), 7.65 (t, J=6.0 Hz, 1H), 8.13 (d, J=8.5 Hz, 1H), 8.43 (d, J=8.0 Hz, 1H), 9.08 (d, J=6.0 Hz, 1H).

### Embodiment 3: Tetradentate Cyclometalated Platinum(II) Complex Phosphorescent Light-Emitting Material Pt162

**The synthesis route is as follows:**

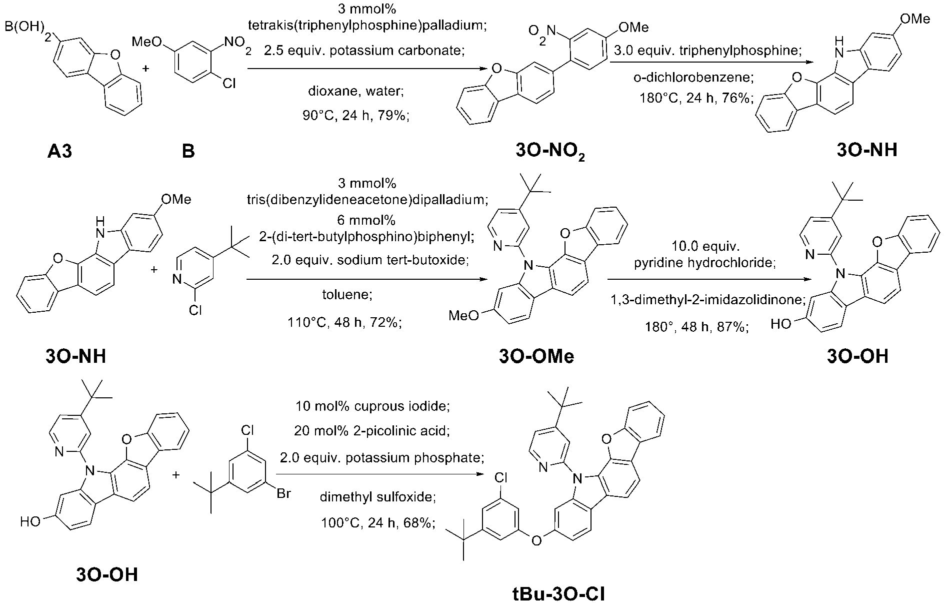

Synthesis of Intermediate **3O-NO₂:** Compound **A3** (10 g, 43.8 mmol, 1.5 equivalents), compound **B** (6.2 g, 29.2 mmol, 1.0 equivalent), tetrakis(triphenylphosphine)palladium (1.01 g, 0.88 mmol, 3 mol%), potassium carbonate (8.07 g, 58.4 mmol, 2.0 equivalents) are added into a reaction flask; then, dioxane (60 mL) and water (15 mL) are added; the mixture is allowed to react at 90°C for 24 hours, and then the reaction is stopped; and the reacted mixture is cooled to room temperature, concentrated and purified by silica gel column chromatography to afford 7.34 g of a yellow solid in 79% yield. A ¹H NMR characterization result for the yellow solid is as follows: ¹H NMR (500 MHz, DMSO-*d₆*) δ 3.91 (s, 3H), 7.30 (dd, *J*=7.5, 1.5 Hz, 1H), 7.38 (dd, *J*=8.5, 2.5 Hz, 1H), 7.44 (td, *J*=7.5, 0.5 Hz, 1H), 7.59-7.61 (m, 2H), 7.56 (m, 1H), 7.69 (d, *J*=1.0 Hz, 1H), 7.73 (d, *J*=8.0 Hz, 1H), 8.18-8.20 (m, 2H).

Synthesis of Intermediate **3O-NH:** Intermediate **3O-NO₂** (7.3 g, 30.6 mmol, 1.0 equivalent) and triphenylphosphine (24.1 g, 91.8 mmol, 3.0 equivalents) are added into a reaction flask; then, o-dichlorobenzene (60 mL) is added; the mixture is allowed to react at 180°C for 24 hours, and then the reaction is stopped; and the reacted mixture is cooled to room temperature, concentrated and purified by silica gel column chromatography to afford 6.03 g of a brown solid in 76% yield. The brown solid is directly used in a subsequent reaction.

Synthesis of Intermediate **3O-OMe:** Intermediate **3O-NH** (4.8 g, 16.7 mmol, 1.0 equivalent), 4-(tert-butyl)-2-chloropyridine (3.68 g, 21.7 mmol, 1.3 equivalents), tris(dibenzylideneacetone)dipalladium (421 mg, 1.00 mmol, 3 mol%), 2-(di-tert-butylphosphino)biphenyl (822 mg, 2.0 mmol, 6 mol%) and sodium tert-butoxide (3.2 g, 33.4 mmol, 2.0 equivalents) are added into a reaction flask; then, toluene (50 mL) is added; the mixture is allowed to react at 110°C for 48 hours, and then the reaction is stopped; and the reacted mixture is cooled to room temperature, concentrated and purified by silica gel column chromatography to afford 4.92 g of a brown solid in 72% yield. The brown solid is directly used in a subsequent reaction.

Synthesis of Intermediate **3O-OH:** Intermediate **3O-OMe** (4.9 g, 6.7 mmol, 1.0 equivalent) and pyridine hydrochloride (7.74 g, 67 mmol, 10.0 equivalents) are added into a reaction flask; then, 1,3-dimethyl-2-imidazolidinone (60 mL) is added; the mixture is allowed to react at 180°C for 48 hours, and then the reaction is stopped; and the reacted mixture is cooled to room temperature, concentrated and purified by silica gel column chromatography to afford 3.4 g of a brown solid in 87% yield. The brown solid is directly used in a subsequent reaction.

Synthesis of Intermediate **tBu-3O-Cl:** Intermediate **3O-OH** (1.0 g, 2.5 mmol, 1.0 equivalent), 1-tert-Butyl-3-chloro-5-bromobenzene (804 mg, 3.25 mmol, 1.3 equivalents), 2-picolinic acid (62 mg, 0.5 mmol, 20 mmol%), cuprous iodide (48 mg, 0.25 mmol, 10 mmol%), potassium phosphate (1.06 g, 5 mmol, 2.0 equivalents) and dimethyl sulfoxide (10 mL) are added into a reaction flask; the mixture is allowed to react at 100°C for 24 hours, and then the reaction is stopped; and the reacted mixture is cooled to room temperature, concentrated and purified by silica gel column chromatography to afford 590 mg of a white solid in 68% yield. A ¹H NMR characterization result for the white solid is as follows: ¹H NMR (500 MHz, DMSO) δ 1.24 (s, 9H), 1.37 (s, 9H), 6.87 (t, J=2.5 Hz, 1H), 7.11 (t, J=2.0 Hz, 1H), 7.14 (dd, J=8.5, 2.0 Hz, 1H), 7.19 (t, J=1.5 Hz, 1H), 7.44 (td, J=7.2, 1.5 Hz, 1H), 7.52-7.48 (m, 2H), 7.55 (dd, J=5.5, 2.0 Hz, 1H), 7.58 (d, J=2.0 Hz, 1H), 7.80 (d, J=2.0 Hz, 1H), 8.12 (d, J=8.5 Hz, 1H), 8.24 (d, J=7.5 Hz, 1H), 8.30 (d, J=8.0 Hz, 1H), 8.38 (d, J=8.5 Hz, 1H), 8.57 (d, J=4.5 Hz, 1H).

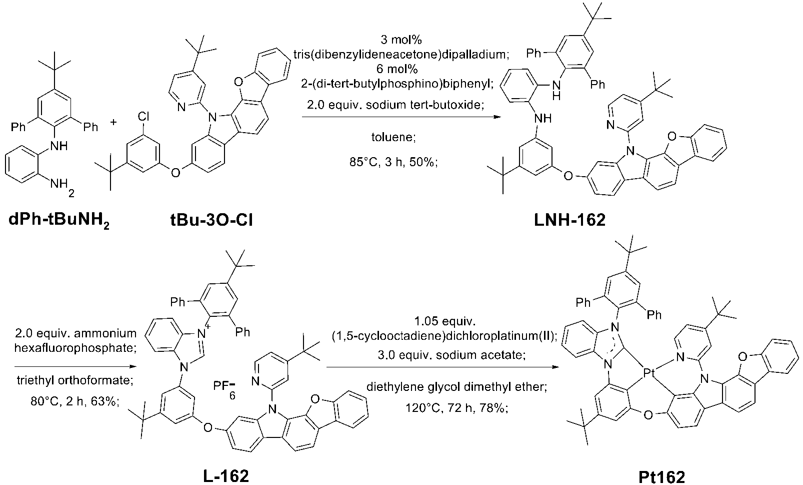

Synthesis of Intermediate **LNH-162:** Intermediate **dPh-tBuNH₂** (300 mg, 0.76 mmol, 1.0 equivalent) is added into a reaction flask; then, intermediate **tBu-3O-Cl** (458 mg, 0.8 mmol, 1.05 equivalents), tris(dibenzylideneacetone)dipalladium (21 mg, 0.03 mmol, 3 mol%), 2-(di-tert-butylphosphino)biphenyl (14 mg, 0.06 mmol, 6 mol%) and sodium tert-butoxide (146 mg, 1.5 mmol, 2.0 equivalents) are added; then, toluene (5 mL) is added; the mixture is allowed to react at 85°C for 3 hours, and then the reaction is stopped; and the reacted mixture is cooled to room temperature, concentrated and purified by silica gel column chromatography to afford 271 mg of a white solid in 50% yield. The white solid is directly used in a subsequent reaction.

Synthesis of Ligand **L-162:** Intermediate **LNH-162** (271 mg, 0.29 mmol, 1.0 equivalent) is added into a reaction flask; then, ammonium hexafluorophosphate (94 mg, 0.58 mmol, 2.0 equivalents) is added; then, triethyl orthoformate (5 mL) is added; the mixture is allowed to react at 80°C for 2 hours, and then the reaction is stopped; and the reacted mixture is cooled to room temperature, concentrated and purified by silica gel column chromatography to afford 197 mg of a white solid in 63% yield. A ¹H NMR characterization result for the white solid is as follows: ¹H NMR (500 MHz, DMSO) δ 1.31 (s, 9H), 1.36 (s, 9H), 1.43 (s, 9H), 6.81 (t, *J*=2.0 Hz, 1H), 6.95 (t, *J*=1.5 Hz, 1H), 7.11-7.16 (m, 10H), 7.24 (dd, *J*=8.5, 2.5 Hz, 1H), 7.44-7.58 (m, 8H), 7.72-7.75 (m, 4H), 7.83 (d, J=1.5 Hz, 1H), 8.15 (d, *J*=8.5 Hz, 1H), 8.25 (d, *J*=7.5 Hz, 1H), 8.35 (d, *J*=8.0 Hz, 1H), 8.46 (d, *J*=8.5 Hz, 1H), 8.58 (d, *J*=5.5 Hz, 1H), 10.24 (s, 1H).

Synthesis of **Pt162:** Ligand **L-162** (153 mg, 0.15 mmol, 1.0 equivalent), (1,5-cyclooctadiene)dichloroplatinum(II) (55 mg, 0.16 mmol, 1.05 equivalents) and sodium acetate (37 mg, 0.45 mmol, 3.0 equivalents) are added into a reaction flask; then, diethylene glycol dimethyl ether (10 mL) is added; the mixture is allowed to react at 120°C for 72 hours, and then the reaction is stopped; and the reacted mixture is cooled to room temperature, concentrated and purified by silica gel column chromatography to afford 138 mg of a pale yellow solid in 78% yield. A ¹H NMR characterization result for the pale yellow solid is as follows: ¹H NMR (500 MHz, CDCl₃) δ 1.13 (s, 9H), 1.47 (s, 9H), 1.53 (s, 9H), 6.22 (t, *J*=7.5 Hz, 2H), 6.37 (dd, *J*=6.0, 1.5 Hz, 1H), 6.48 (t, *J*=2.5 Hz, 1H), 6.69 (d, *J*=6.5 Hz, 2H), 6.94 (d, *J*=7.0 Hz, 1H), 7.07-7.02 (m, 1H), 7.12 (d, J=1.5 Hz, 1H), 7.21-7.25 (m, 2H), 7.28-7.32 (m, 2H), 7.35-7.39 (m, 2H), 7.44-7.51 (m, 4H), 7.54 (d, *J*=1.5 Hz, 1H), 7.61 (d, *J*=7.5 Hz, 2H), 7.70 (s, 1H), 7.86 (d, *J*=8.0 Hz, 1H), 7.99 (d, *J*=8.5 Hz, 1H), 8.06 (d, *J*=8.0 Hz, 1H), 8.12 (d, *J*=8.0 Hz, 2H), 9.04 (d, *J*=6.0 Hz, 1H).

### Embodiment 4: Tetradentate Cyclometalated Platinum(II) Complex Phosphorescent Light-Emitting Material Pt6

**The synthesis route is as follows:**

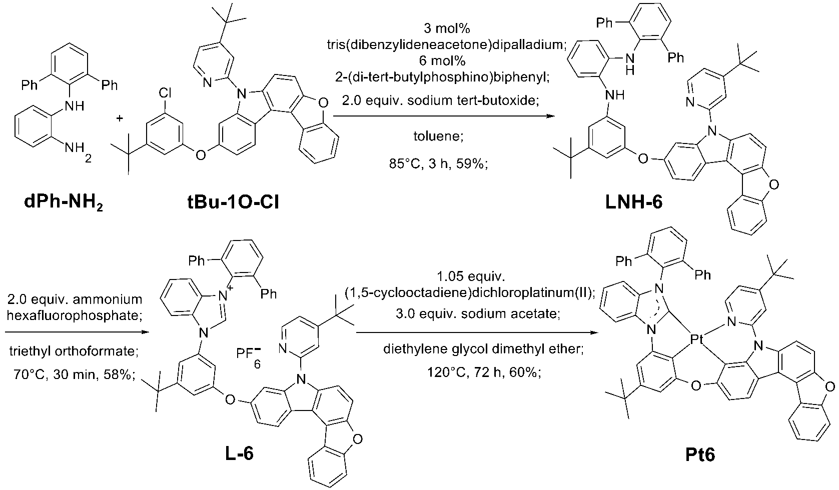

**Pt6** is synthesized with reference to the steps and reaction conditions for synthesizing compound **Pt162.** A target product **LNH-6** is first synthesized and obtained as a pale green foamy solid (680 mg, 59% yield); then, a target product **L-6** is synthesized and obtained as a pale green foamy solid (377 mg, 58% yield), MS (ESI) *m*/*z:* [M]⁺ 883.4; finally, a target product, i.e., **Pt6,** is synthesized and obtained as a yellow solid (180 mg, 60% yield), MS (ESI) *m*/*z:* [M+H]⁺ 1076.3.

### Example 5: Tetradentate Cyclometalated Platinum(II) Complex Phosphorescent Light-Emitting Material Pt13

**The synthesis route is as follows:**

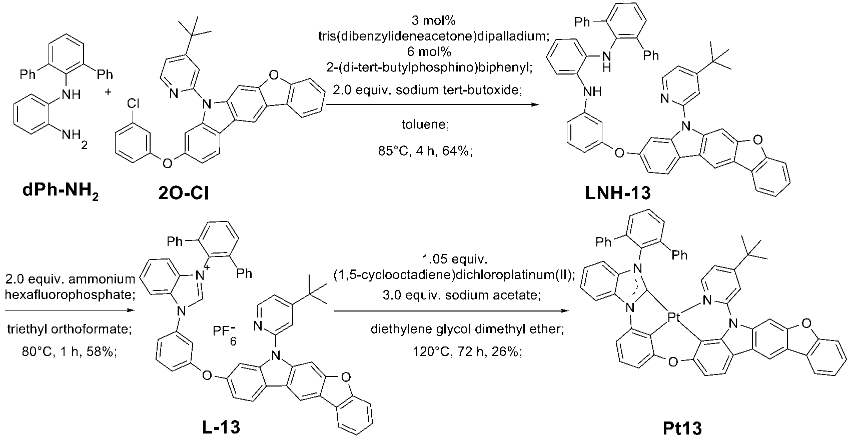

**Pt13** is synthesized with reference to the steps and reaction conditions for synthesizing compound **Pt162.** A target product **LNH-13** is synthesized and obtained as a pale green foamy solid (900 g, 64% yield); then, a target product **L-13** is synthesized and obtained as a pale green foamy solid (423 mg, 58% yield), MS (ESI) *m*/*z:* [M]⁺ 827.3; finally, a target product, i.e., **Pt13,** is synthesized and obtained as a yellow solid (30 mg, 26% yield), MS (ESI) *m*/*z:* [M+H]⁺ 1020.33.

### Example 6: Tetradentate Cyclometalated Platinum(II) Complex Phosphorescent Light-Emitting Material Pt14

**The synthesis route is as follows:**

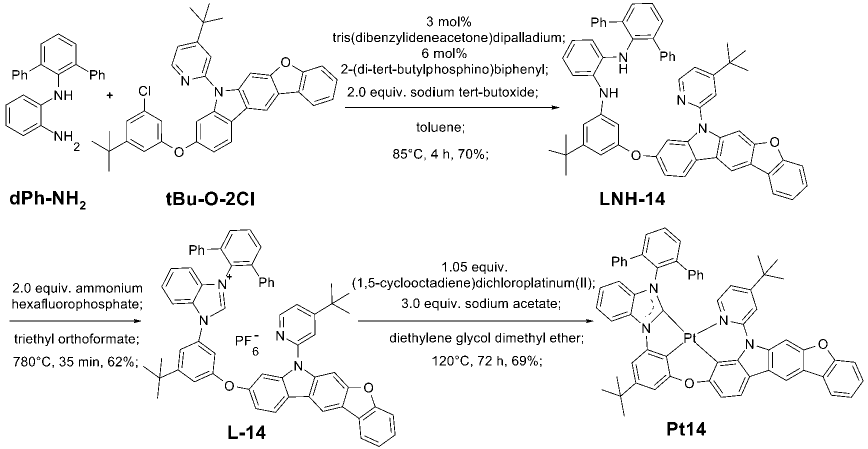

**Pt14** is synthesized with reference to the steps and reaction conditions for synthesizing compound **Pt162.** A target product **LNH-14** is synthesized and obtained as a pale green foamy solid (1.5 g, 70% yield); then, a target product **L-14** is synthesized and obtained as a pale green foamy solid (800 mg, 62% yield), MS (ESI) *m*/*z:* [M]⁺ 883.4; finally, a target product, i.e., **Pt14,** is synthesized and obtained as a yellow solid (346 mg, 59% yield), MS (ESI) *m*/*z:* [M+H]⁺ 1076.3.

### Example 7: Tetradentate Cyclometalated Platinum(II) Complex Phosphorescent Light-Emitting Material Pt-154

**The synthesis route is as follows:**

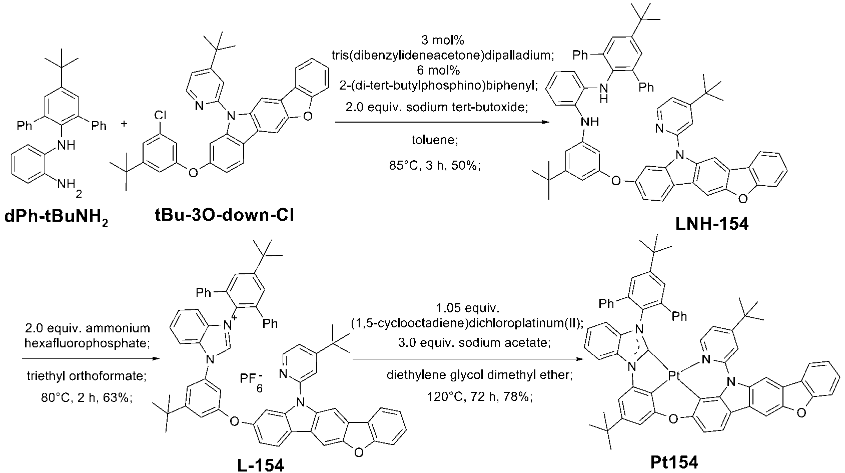

**Pt154** is synthesized with reference to the steps and reaction conditions for synthesizing compound **Pt162.** A target product **LNH-154** is synthesized and obtained as a pale green foamy solid (1.1 g, 60% yield); then, a target product **L-154** is synthesized and obtained as a pale green foamy solid (504 mg, 63% yield), MS (ESI) *m*/*z:* [M]⁺ 939.5; finally, a target product, i.e., **Pt154,** is synthesized and obtained as a yellow solid (178 mg, 78% yield), MS (ESI) *m*/*z:* [M+H]⁺ 1132.4.

### Embodiment 8: Tetradentate Cyclometalated Platinum(II) Complex Phosphorescent Light-Emitting Material Pt197

**The synthesis route is as follows:**

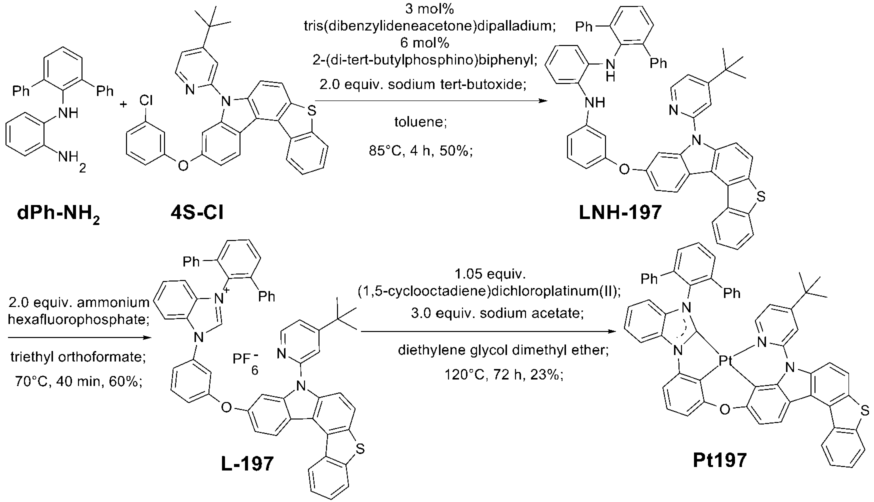

**Pt197** is synthesized with reference to the steps and reaction conditions for synthesizing compound **Pt162.** A target product **LNH-197** is synthesized and obtained as a pale green foamy solid (2.4 g, 50% yield); then, a target product **L-197** is synthesized and obtained as a pale green foamy solid (1 g, 60% yield), MS (ESI) *m*/*z*: [M]⁺ 843.3; finally, a target product, i.e., **Pt197,** is synthesized and obtained as a yellow solid (210 mg, 23% yield), MS (ESI) *m*/*z*: [M+H]⁺ 1036.3.

### Embodiment 9: Synthesis of Pt26

**Pt26** is synthesized with reference to the steps and reaction conditions for synthesizing compound **Pt162.** A target product, i.e., **Pt26,** is obtained as a yellow solid (530 mg, 58% yield). MS (ESI) *m*/*z*: [M+H]⁺ 1215.5.

### Embodiment 10: Synthesis of Pt63

**Pt63** is synthesized with reference to the steps and reaction conditions for synthesizing compound **Pt162.** A target product, i.e., **Pt63,** is synthesized and obtained as a yellow solid (432 mg, 70% yield). MS (ESI) *m*/*z*: [M+H]⁺ 1264.5.

### Embodiment 11: Synthesis of Pt76

**Pt76** is synthesized with reference to the steps and reaction conditions for synthesizing compound **Pt162.** A target product is obtained as a yellow solid (801 mg, 65% yield). MS (ESI) *m*/*z:* [M+H]⁺ 1474.7.

### Embodiment 12: Synthesis of Pt230

**Pt230** is synthesized with reference to the steps and reaction conditions for synthesizing compound **Pt-162.** A target product, i.e., **Pt230,** is synthesized and obtained as a yellow solid (56 mg, 40% yield), MS (ESI) *m*/*z:* [M+H]⁺ 1510.7.

### Embodiment 13: Synthesis of Pt237

**Pt237** is synthesized with reference to the steps and reaction conditions for synthesizing compound **Pt162.** A target product is obtained as a yellow solid (730 mg, 43% yield). MS (ESI) *m*/*z:* [M+H]⁺ 1342.5.

### Embodiment 14: Synthesis of Pt244

**Pt244** is synthesized with reference to the steps and reaction conditions for synthesizing compound **Pt162.** A target product is obtained as a yellow solid (530 mg, 52% yield). MS (ESI) *m*/*z:* [M+H]⁺ 1490.6.

### Embodiment 15: Synthesis of Pt252

**Pt252** is synthesized with reference to the steps and reaction conditions for synthesizing compound **Pt162.** A target product, i.e., **Pt252,** is synthesized and obtained as a yellow solid (121 mg, 61% yield). MS (ESI) *m*/*z:* [M+H]⁺ 1399.6.

### Embodiment 16: Synthesis of Pt257

**Pt257** is synthesized with reference to the steps and reaction conditions for synthesizing compound **Pt162.** A target product, i.e., **Pt257,** is synthesized and obtained as a yellow solid (158 mg, 30% yield). MS (ESI) *m*/*z:* [M+H]⁺ 1260.4.

### Embodiment 17: Synthesis of Pt258

**Pt258** is synthesized with reference to the steps and reaction conditions for synthesizing compound **Pt162.** A target product, i.e., **Pt258,** is obtained as a yellow solid (188 mg, 60% yield). MS (ESI) *m*/*z:* [M+H]⁺ 1343.5.

### Embodiment 18: Synthesis of Pt263

**Pt263** is synthesized with reference to the steps and reaction conditions for synthesizing compound **Pt162.** A target product is obtained as a yellow solid (472 mg, 50% yield). MS (ESI) *m*/*z:* [M+H]⁺ 1461.5.

### Embodiment 19: Synthesis of Pt264

**Pt264** is synthesized with reference to the steps and reaction conditions for synthesizing compound **Pt162.** A target product is obtained as a yellow solid (545 mg, 49% yield). MS (ESI) *m*/*z:* [M+H]⁺ 1461.5.

### Embodiment 20: Synthesis of Pt328

**Pt328** is synthesized with reference to the steps and reaction conditions for synthesizing compound **Pt162.** A target product is obtained as a yellow solid (571 mg, 45% yield). MS (ESI) *m*/*z:* [M+H]⁺ 1378.5.

### Embodiment 21: Synthesis of Pt333

**Pt333** is synthesized with reference to the steps and reaction conditions for synthesizing compound **Pt162.** A target product is obtained as a yellow solid (418 mg, 47% yield). MS (ESI) *m*/*z:* [M+H]⁺ 1126.3.

### Embodiment 22: Synthesis of Pt362

**Pt362** is synthesized with reference to the steps and reaction conditions for synthesizing compound **Pt162.** A target product is obtained as a yellow solid (590 mg, 63% yield). MS (ESI) *m*/*z:* [M+H]⁺ 1414.7.

### Embodiment 23: Synthesis of Pt364

**Pt364** is synthesized with reference to the steps and reaction conditions for synthesizing compound **Pt162.** A target product is obtained as a yellow solid (518 mg, 53% yield). MS (ESI) *m*/*z:* [M+H]⁺ 1490.7.

### Embodiment 24: Synthesis of Pt365

**Pt365** is synthesized with reference to the steps and reaction conditions for synthesizing compound **Pt162.** A target product is obtained as a yellow solid (459 mg, 61% yield). MS (ESI) *m*/*z:* [M+H]⁺ 1283.4.

### Embodiment 25: Synthesis of Pt372

**Pt372** is synthesized with reference to the steps and reaction conditions for synthesizing compound **Pt162.** A target product is obtained as a yellow solid (480 mg, 63% yield). MS (ESI) *m*/*z:* [M+H]⁺ 1413.6.

### Embodiment 26: Synthesis of Pt378

**Pt378** is synthesized with reference to the steps and reaction conditions for synthesizing compound **Pt162.** A target product is obtained as a yellow solid (556 mg, 52% yield). MS (ESI) *m*/*z:* [M+H]⁺ 1307.4.

### Embodiment 27: Synthesis of Pt383

**Pt383** is synthesized with reference to the steps and reaction conditions for synthesizing compound **Pt162.** A target product is obtained as a yellow solid (458 mg, 47% yield). MS (ESI) *m*/*z:* [M+H]⁺ 1471.7.

### Theoretical Calculation Explanation

Geometric structures of ground-state (S₀) molecules are optimized by using density functional theory (DFT). DFT calculations are performed using the Becke, 3-parameter, Lee-Yang-Parr functional (B3LYP functional), with the 6-31G(d) basis set for C, H, O and N atoms and the LANL2DZ basis set for Pt atoms.

**Table 1. Electron and Hole Distribution in T₁ Excited States for Selected Metal Complexes of the Present Disclosure.**

| Metal Complex | T₁-electron | T₁-hole |
|---|---|---|
| 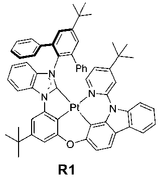 | 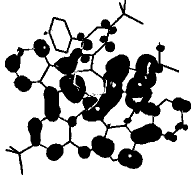 | 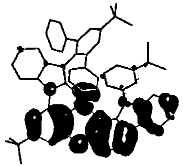 |
| 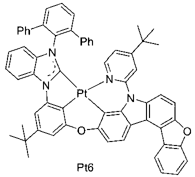 | 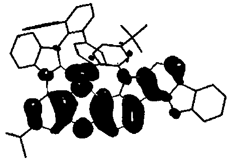 | 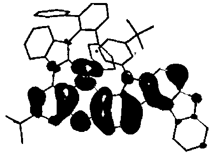 |
| 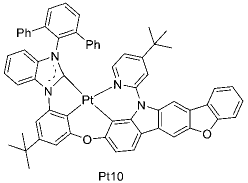 | 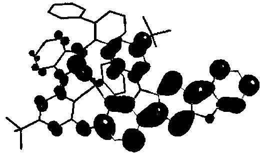 | 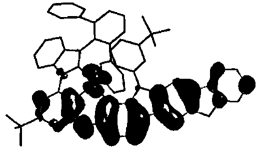 |
| 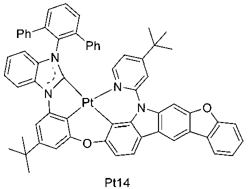 | 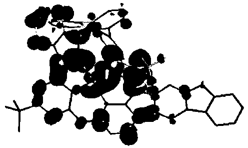 | 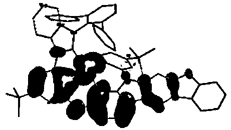 |
| 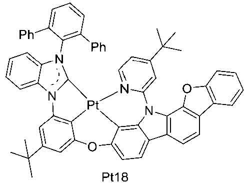 | 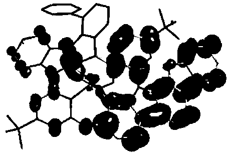 | 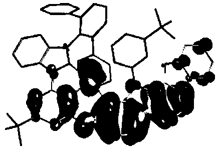 |
| 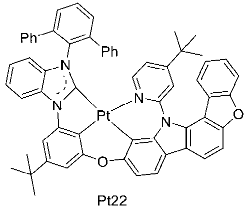 | 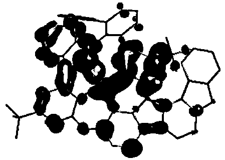 | 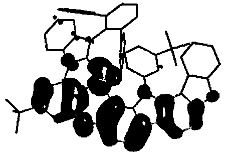 |
| 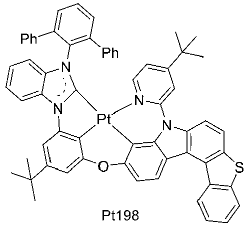 | 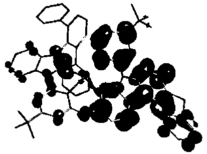 | 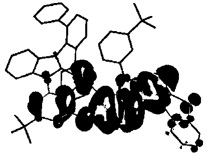 |
| 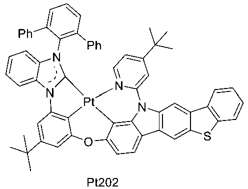 | 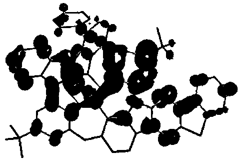 | 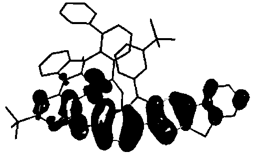 |
| 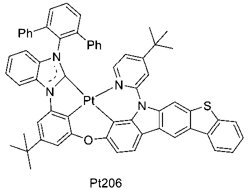 | 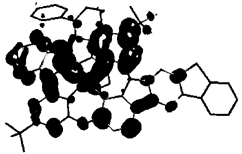 | 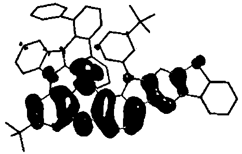 |
| 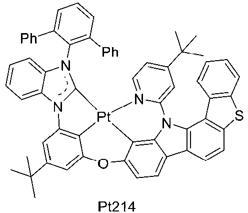 | 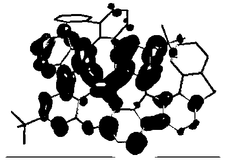 | 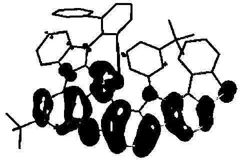 |

As can be seen from Table 1, a fused ring is introduced at different positions of carbazole in the present disclosure, which expands a conjugated system, increases the distribution of a locally excited state. This results in a lower emission shoulder peak, a narrower full width at half maximum and higher color purity, thereby meeting the requirements for blue light-emitting materials.

### Photophysical Properties:

**Table 2. Photophysical Properties of Selected Metal Complexes in Dichloromethane Solution**

| **Complex** | **Maximum Emission Wavelength** | **Full Width at Half Maximum** |
|---|---|---|
| **Pt162** | 474.4 nm | 24.4 nm |
| **Pt150** | 481.6 nm | 36.2 nm |
| **Pt166** | 462.2 nm | **18.6nm** |

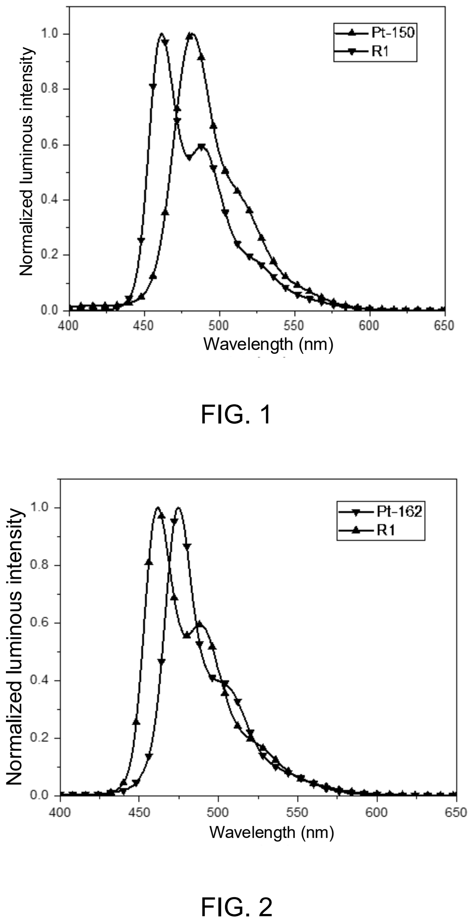

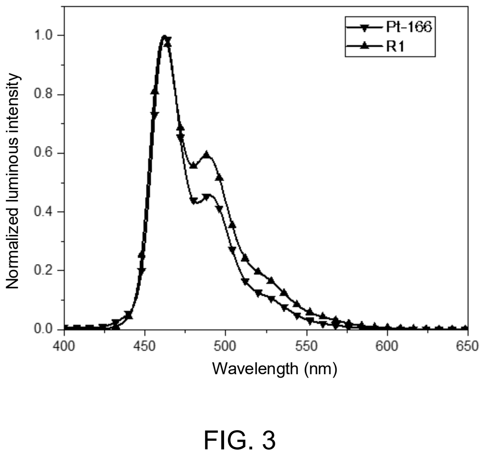

FIGS. 1 to 3 show emission spectra of **Pt150, Pt162, Pt166** and **R1** in a dichloromethane solution at room temperature. As can be seen from FIGS. 1 to 3 and Table 2, comparison of the emission spectra of the platinum complexes in the dichloromethane solution at room temperature demonstrates that, introduction of a fused ring at different positions of carbazole expands a conjugated system, increases the distribution of a locally excited state, resulting in a lower emission shoulder peak, a narrower full width at half maximum and higher color purity. Platinum complex **Pt166** exhibits a maximum emission wavelength of 462.2 nm with a full width at half maximum of 18.6 nm.

### Fabrication of OLED Devices:

A reference fabrication method for device examples in the present disclosure includes the following steps: on a surface of an indium-tin-oxide (ITO) glass with a light-emitting area of 2 mm×2 mm or on an anode, vapor-depositing a p-type doped material or co-depositing a p-type doped material at a mass concentration of 1% to 50% with a hole injection material to form a hole injection layer (HIL) with a thickness of 5 nm to 100 nm; forming a hole transport layer (HTL) with a thickness of 5 nm to 200 nm; subsequently, forming a light-emitting layer (EML) (which may contain the compound described in the present disclosure) with a thickness of 10 nm 100 nm on the HTL; and forming an electron transport layer (ETL) with a thickness of 20 nm to 200 nm and a cathode with a thickness of 50 nm 200 nm. If necessary, an electron blocking layer (EBL) is introduced between the HTL and the EML, and an electron injection layer (EIL) is introduced between the ETL and the cathode. Thus, an OLED device is fabricated. OLED devices are tested by using standard methods. Unless otherwise specified, the materials for fabricating the devices in the present disclosure can be obtained through known synthesis methods.

In a preferred embodiment of the present disclosure, a structure of Device Example 1 is as follows: ITO/**P-4** (10 nm)/**NPD** (60 nm)**/HTH-85** (5 nm)/platinum(II) complex: **HTH-85:ETH-45** (25 nm) **(Pt150:HTH-85:ETH-45** with a mass ratio of 10:60:30)/**ETH-5** (5 nm)/**ET-14** (40 nm)/Lithium 8-hydroxyquinolinate (LiQ) (1 nm)/Aluminum (Al) (100 nm).

Devices in Device Examples 2 to 27 and Comparative Example 1 are fabricated by using structures similar to that of the device in Device Example 1, differing only in that **Pt150** in Device Example 1 is substituted with **Pt166, Pt162, Pt6, Pt13, Pt14, Pt154, Pt197, Pt26, Pt63, Pt76, Pt230, Pt237, Pt63, Pt76, Pt244, Pt313, Pt327, Pt333, Pt338, Pt362, Pt364, Pt365, Pt367, Pt372, Pt378** and **Pt380** in Device Examples 2 to 27, respectively, and with **R¹** in Comparative Example 1. The luminescence characteristics of the fabricated devices in comparative example and the device examples are tested by using standard methods; and the data are presented in Table 2. Structural formulas of the involved devices are as follows, **P-4** denoting HATCN, **ET-14** denoting BPyTP.

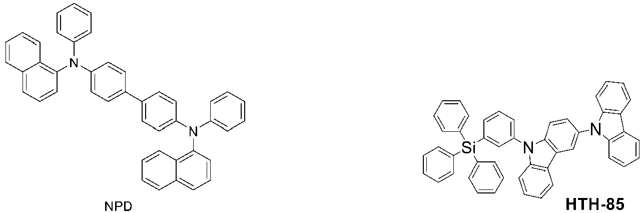

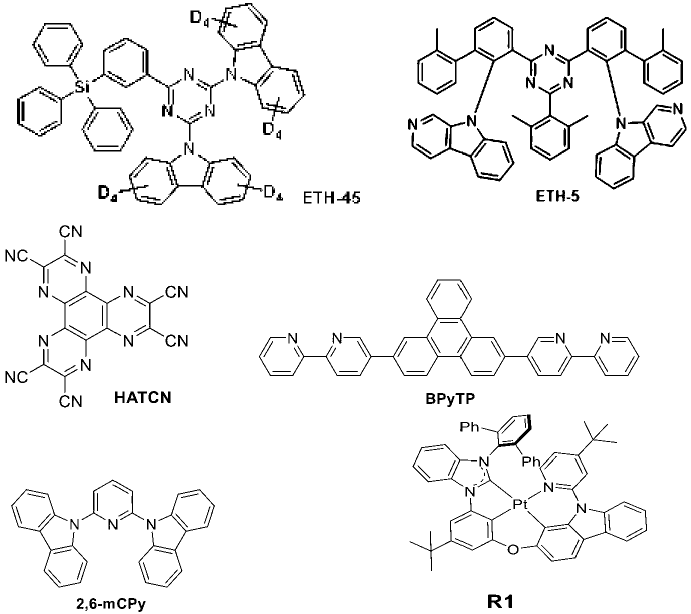

**Table 3. Device Luminescence Characteristics Data Sheet**

| Example | Platinum(II) Complex | Drive Voltage (Volt) @ 10 mA/cm² (Relative Value, %) | Current Efficiency (cd/A) @1000 cd/m² (Relative Value, %) | Device Lifetime (h) @1000 cd/m² (Relative Value, %) |
|---|---|---|---|---|
| Comparative Example 1 | **R1** | 100 | 100 | 100 |
| Device Example 1 | **Pt150** | 96 | 117 | 122 |
| Device Example 2 | **Pt166** | 97 | 120 | 127 |
| Device Example 3 | **Pt162** | 95 | 121 | 132 |
| Device Example 4 | **Pt6** | 98 | 116 | 122 |
| Device Example 5 | **Pt13** | 97 | 120 | 125 |
| Device Example 6 | **Pt14** | 96 | 123 | 126 |
| Device Example 7 | **Pt154** | 97 | 125 | 128 |
| Device Example 8 | **Pt197** | 95 | 117 | 130 |
| Device Example 9 | **Pt26** | 96 | 121 | 127 |
| Device Example 10 | **Pt63** | 97 | 120 | 125 |
| Device Example 11 | **Pt76** | 97 | 118 | 121 |
| Device Example 12 | **Pt230** | 97 | 124 | 128 |
| Device Example 13 | **Pt237** | 96 | 124 | 129 |
| Device Example 14 | **Pt244** | 97 | 119 | 123 |
| Device Example 15 | **Pt252** | 96 | 126 | 132 |
| Device Example 16 | **Pt257** | 96 | 127 | 134 |
| Device Example 17 | **Pt258** | 98 | 123 | 128 |
| Device Example 18 | **Pt263** | 97 | 121 | 129 |
| Device Example 19 | **Pt264** | 97 | 122 | 129 |
| Device Example 20 | **Pt328** | 97 | 119 | 123 |
| Device Example 21 | **Pt333** | 97 | 121 | 128 |
| Device Example 22 | **Pt362** | 96 | 124 | 128 |
| Device Example 23 | **Pt364** | 96 | 126 | 134 |
| Device Example 24 | **Pt365** | 96 | 120 | 125 |
| Device Example 25 | **Pt372** | 97 | 122 | 126 |
| Device Example 26 | **Pt378** | 96 | 122 | 126 |
| Device Example 27 | **Pt383** | 96 | 125 | 131 |

It can be seen from Table 3 that, compared with Comparative Example 1, Device Examples 1 to 27 fabricated in the present disclosure demonstrate superior device performance in terms of drive voltage, current efficiency and device lifetime; and color purity of the devices are also significantly improved. The performance improvements of the device examples are based on the fact that the specific compound materials of the present disclosure have narrow emission shoulder peaks and exhibit good electron transport capabilities. It can be seen that, when the compound materials of the present disclosure are each used as a material of a light-emitting layer to fabricated an electronic device, a drive voltage may be reduced, and current efficiency, device lifetime and color purity may also be improved. This indicates that the compounds provided in the present disclosure possess certain commercial application value. In addition, the devices fabricated in the present disclosure are all deep blue light-emitting devices, with CIEy values all below 0.19.

In a preferred embodiment of the present disclosure, a structure of Device Example 28 is: ITO/P-4 (10 **nm)/NPD** (60 nm)**/HTH-85** (5 nm)/Platinum(II) complex: boron-containing compound: **HTH-85:ETH-45** (25 nm) **(Pt150:BN1-8:HTH-85:ETH-45** with a mass ratio of 10:1:59:30)/ETH-5 (5 nm)**/ET-14** (40 nm)/LiQ (1 nm)/Aluminum (Al) (100 nm).

Device Examples 29 to 34 are fabricated by using structures similar to that of Device Example 28, differing only in that respectively using compounds listed in Table 4 to replace the platinum(II) complex and the boron-containing compound in Device Example 29. Structures of involved devices are as shown below. The device structure and luminescence characteristics data is shown in Table 4.

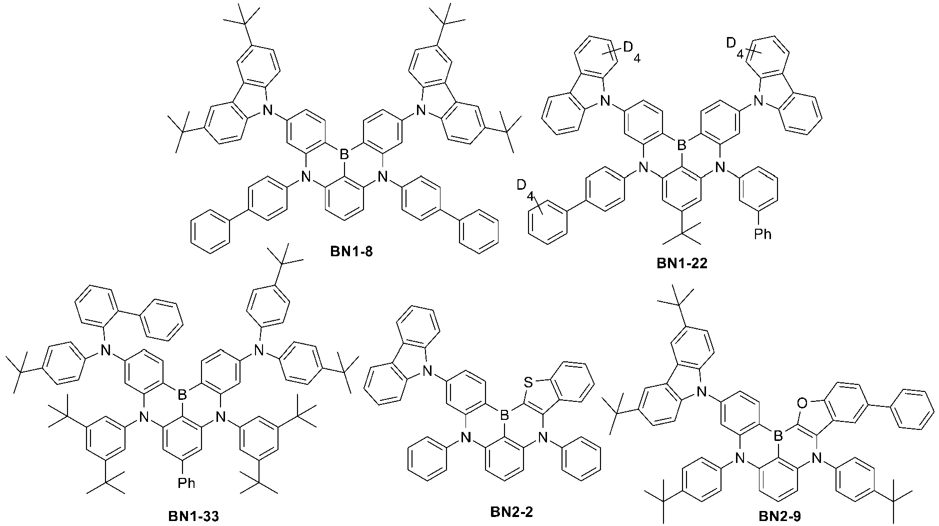

**Table 4. Device Structure and Luminescence Characteristics Data Sheet**

| Example | Platinum(II) Complex:Boron-Containing Compound | Drive Voltage (Volt) @ 10 mA/cm² (Relative Value, %) | Current Efficiency (cd/A) @1000 cd/m² (Relative Value, %) | Device Lifetime (h) @1000 cd/m² (Relative Value, %) |
|---|---|---|---|---|
| Comparative Example 1 | **R1** | 100 | 100 | 100 |
| Device Example 28 | **Pt150:BN1-8** | 97 | 121 | 119 |
| Device Example 29 | **Pt6:BN1-33** | 97 | 117 | 118 |
| Device Example 30 | **Pt13:BN2-2** | 96 | 121 | 120 |
| Device Example 31 | **Pt230:BN1-8** | 95 | 117 | 121 |
| Device Example 32 | **Pt264:BN1-22** | 96 | 122 | 121 |
| Device Example 33 | **Pt364:BN2-9** | 97 | 123 | 123 |
| Device Example 34 | **Pt383:BN1-8** | 96 | 120 | 122 |

It can be seen from Table 4 that, when the compounds, which are used as sensitizing materials, of the present disclosure and the boron-containing compounds are co-used as light-emitting materials in devices, the performances of the devices are also significantly enhanced. This further indicates that the compounds provided in the present disclosure possess certain commercial application value. In addition, a sensitized device structure that incorporates a boron-containing compound may further reduce a CIEy value, thereby further improving color purity of light emitted by a device.

The foregoing description constitutes only preferred specific embodiments of the present disclosure, but the scope of protection of the present disclosure is not limited thereto. Equivalent modifications or substitutions based on the technical solutions and inventive concepts of the present disclosure readily conceivable to any person skilled in the art within the technical scope disclosed by the present disclosure fall within the scope of protection and disclosure of the present disclosure.

## Claims

1. A fused-ring carbazole tetradentate platinum(II) complex, **characterized in that**, the complex has a general structure selected from formulas (I) to (V): 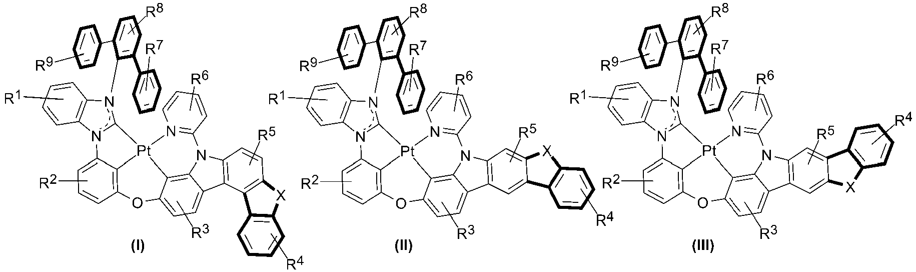 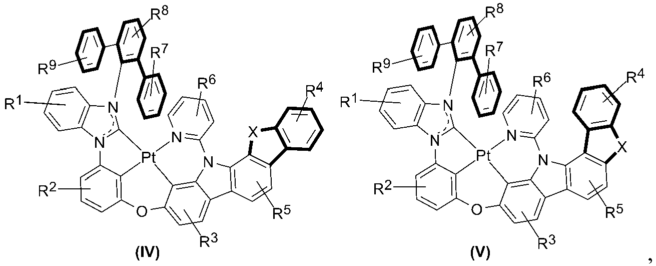 wherein in formulas (I) to (V), X is selected from C, O and S; R¹-R⁹ each independently represent from mono to maximum allowable substitution, or no substitution; and R¹-R⁹ are each independently selected from the group consisting of: hydrogen, deuterium (D), halogen, CN, C1-C30 alkyl, C1-C30 deuterated alkyl, C1-C30 haloalkyl, C1-C30 cycloalkyl, C1-C30 heterocycloalkyl, C6-C60 aryl, a C6-C60 fused-ring aromatic hydrocarbon group, C6-C60 heteroaryl, a C6-C60 fused heterocyclic aromatic hydrocarbon group, C6-C60 arylamino, and combinations thereof, in a case where a heteroatom is involved, the heteroatom being selected from N and O.

2. The fused-ring carbazole tetradentate platinum(II) complex according to claim 1, **characterized in that**, R¹ and R⁶-R⁹ are each independently selected from the group consisting of: hydrogen, deuterium, CD₃, F, methyl, ethyl, n-propyl, isopropyl, n-butyl, isobutyl, sec-butyl, tert-butyl, n-pentyl, isopentyl, sec-pentyl, tert-pentyl, n-hexyl, isohexyl, sec-hexyl, tert-hexyl, n-heptyl, isoheptyl, sec-heptyl, tert-heptyl, n-octyl, isooctyl, sec-octyl, tert-octyl, n-nonyl, isononyl, sec-nonyl, tert-nonyl, phenyl, and combinations thereof.

3. The fused-ring carbazole tetradentate platinum(II) complex according to claim 1, **characterized in that**, R¹ and R⁶-R⁹ are each independently selected from the group consisting of: hydrogen, deuterium, CD₃, F, methyl, ethyl, n-propyl, isopropyl, n-butyl, isobutyl, sec-butyl, tert-butyl, phenyl, and combinations thereof.

4. The fused-ring carbazole tetradentate platinum(II) complex according to claim 1, **characterized in that**, R²-R⁵ are each independently selected from the group consisting of: hydrogen, deuterium, CD₃, F, CF₃, methyl, ethyl, n-propyl, isopropyl, n-butyl, isobutyl, sec-butyl, tert-butyl, phenyl, naphthyl, pyridyl, quinolinyl, cyclopentane, cyclohexane, five-membered heterocycle, diphenylamine, and combinations thereof.

5. The fused-ring carbazole tetradentate platinum(II) complex according to claim 1, **characterized in that**, the complex is any one selected from chemical structures shown below, wherein D represents deuterium:

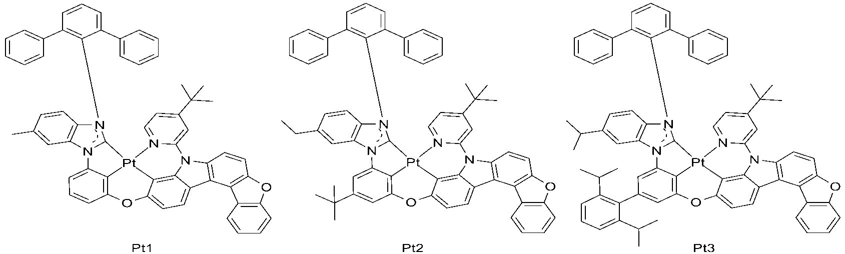

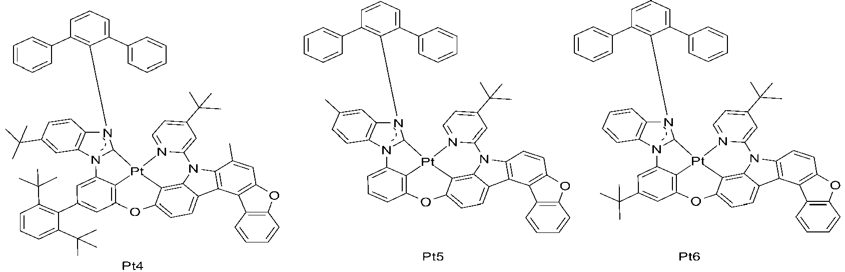

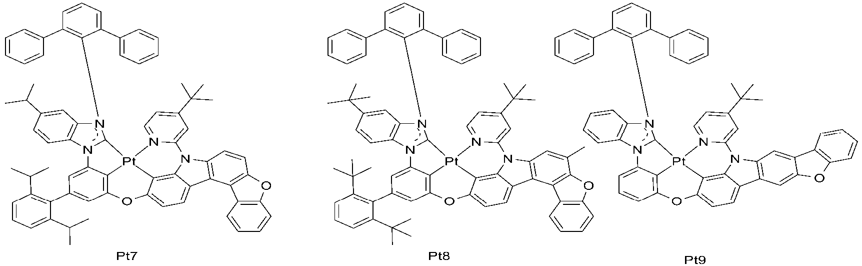

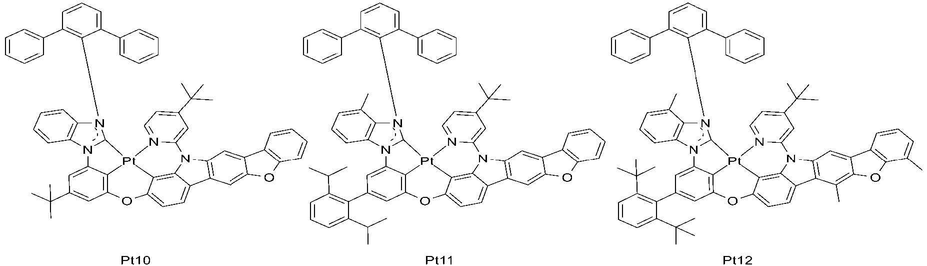

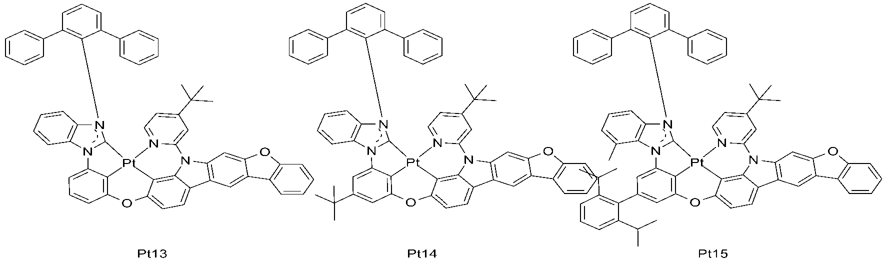

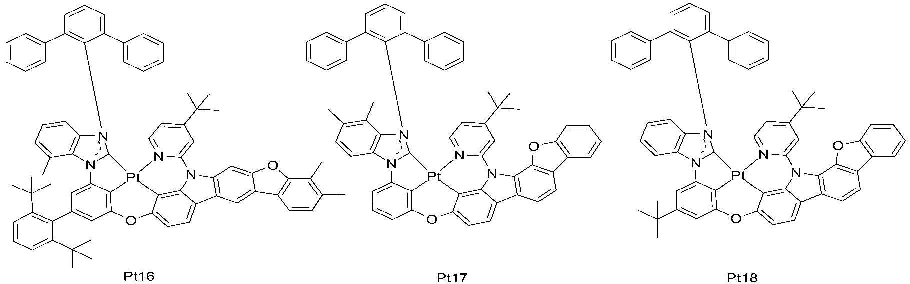

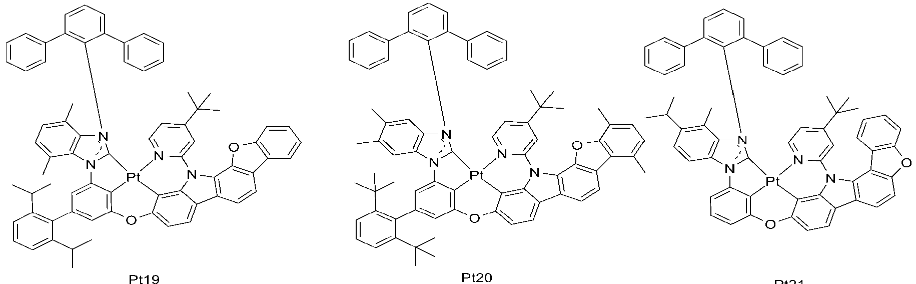

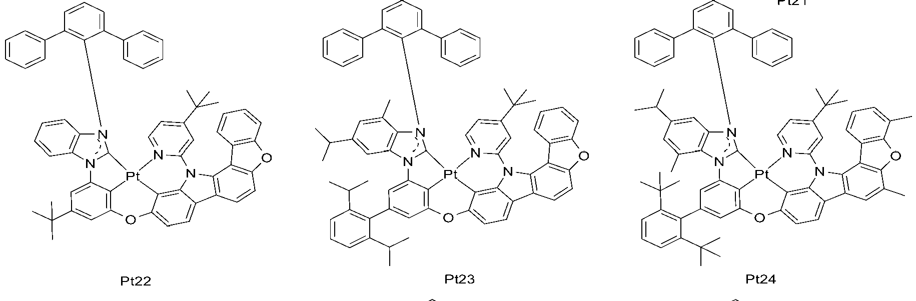

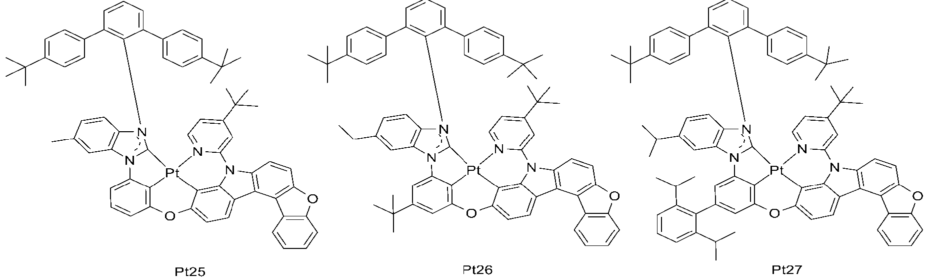

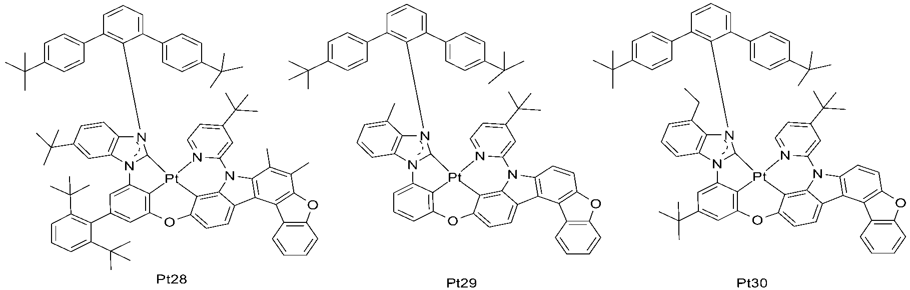

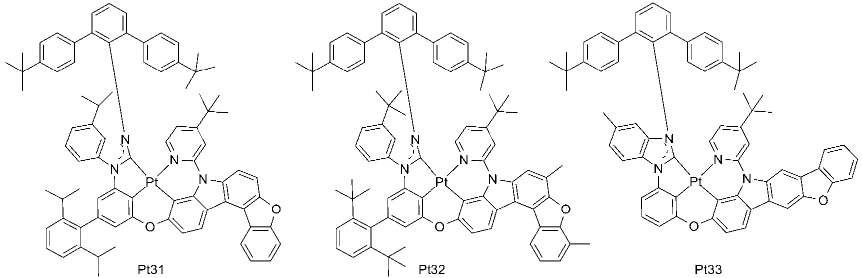

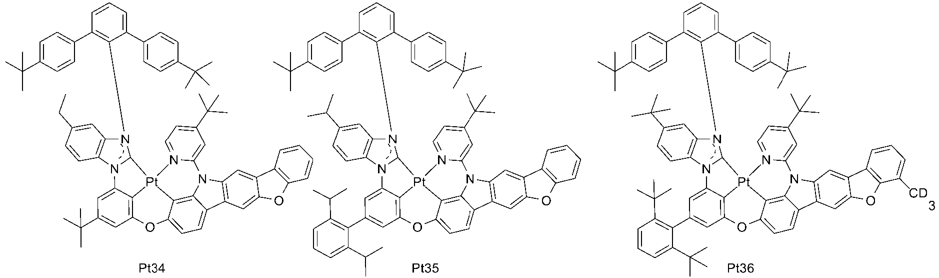

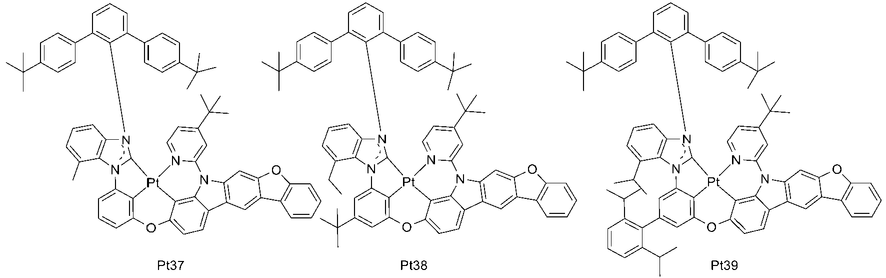

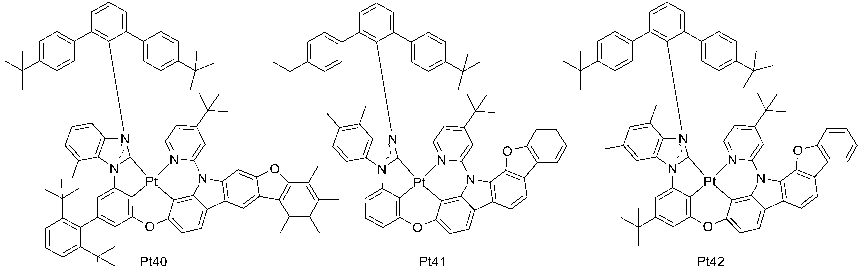

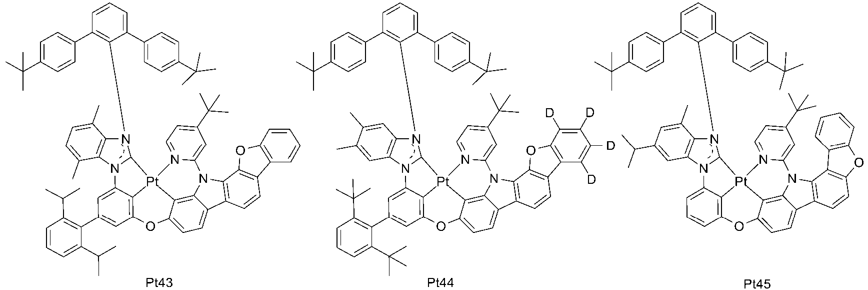

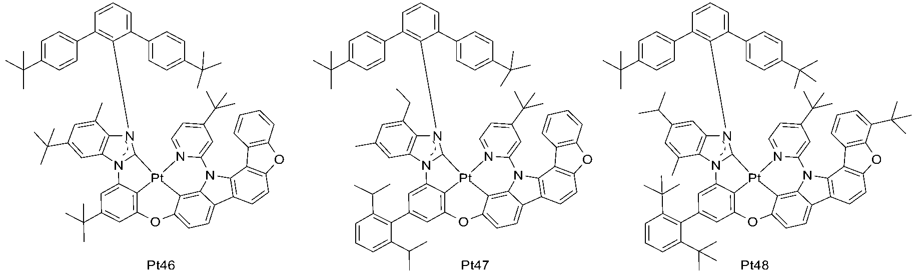

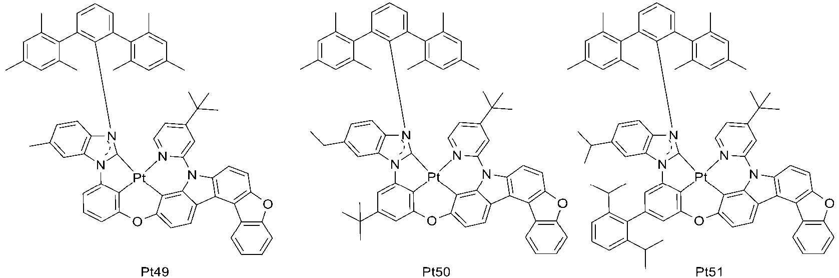

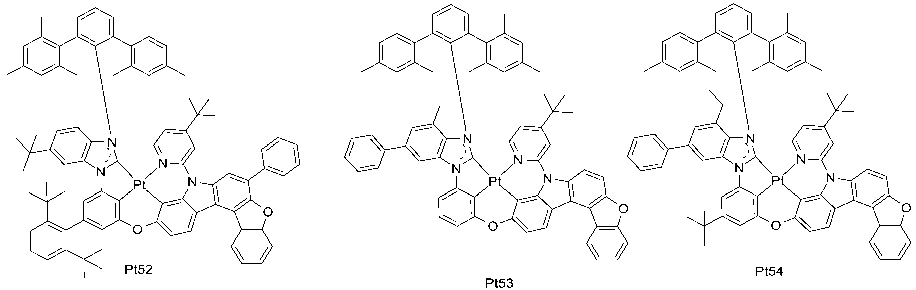

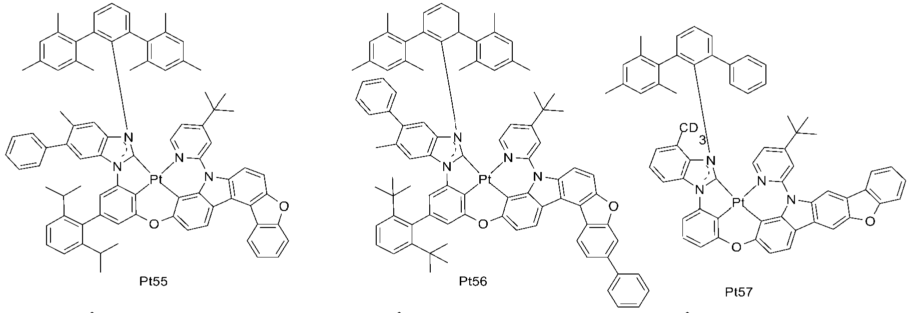

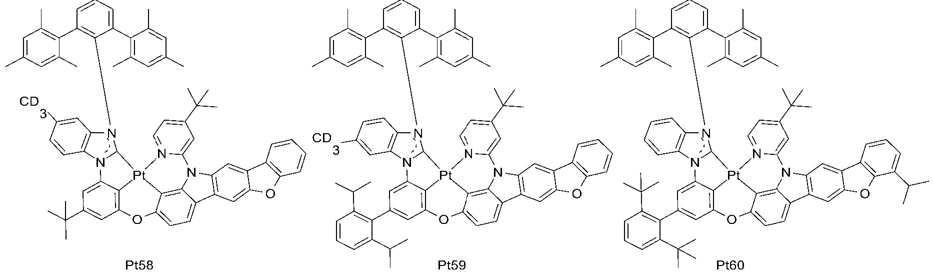

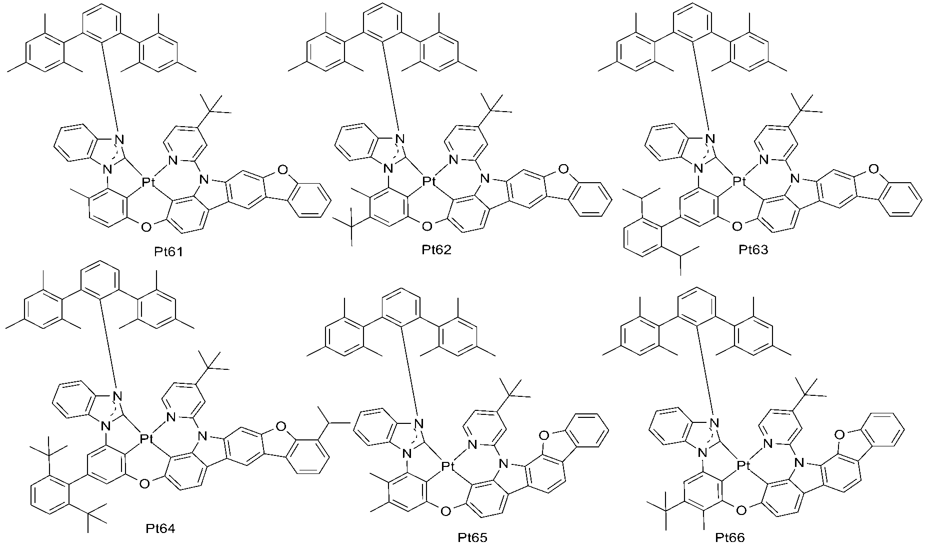

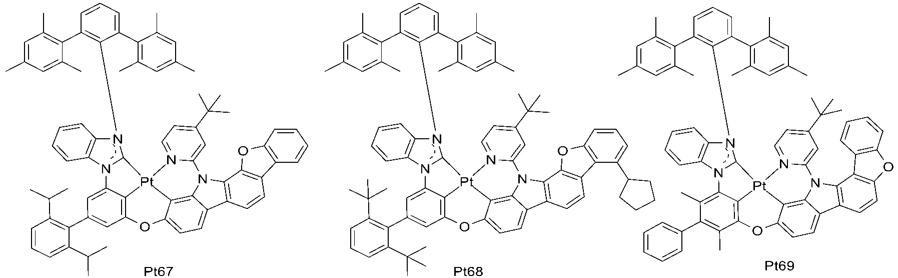

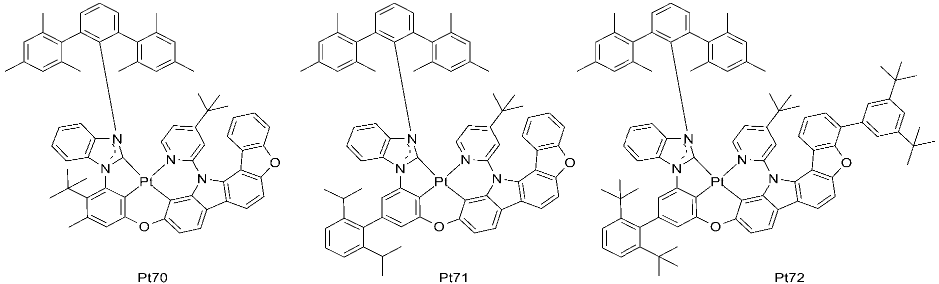

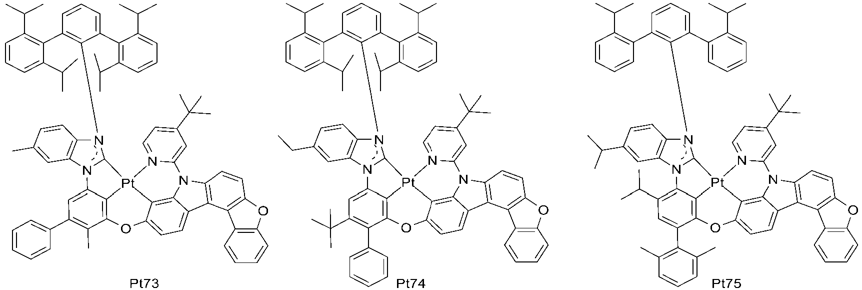

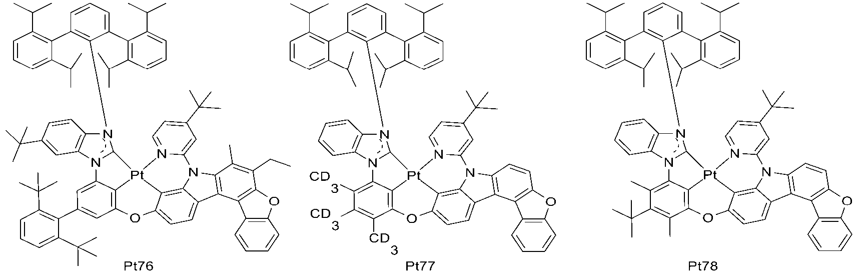

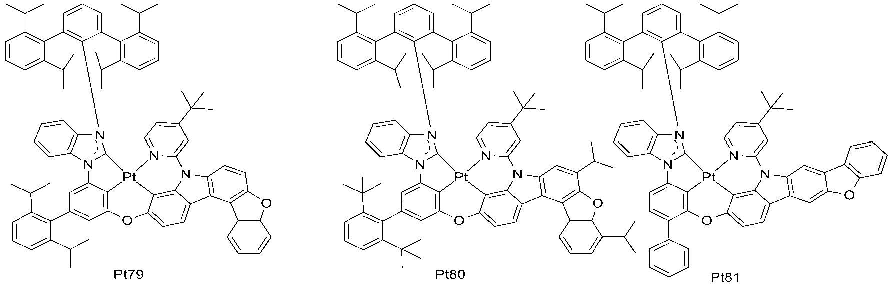

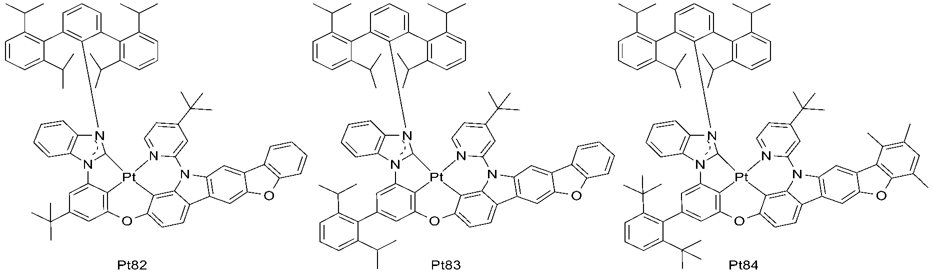

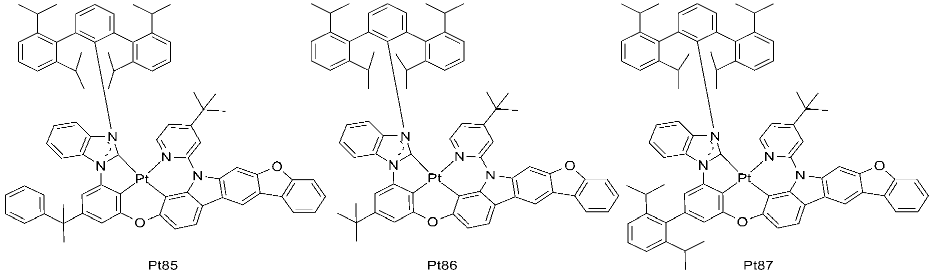

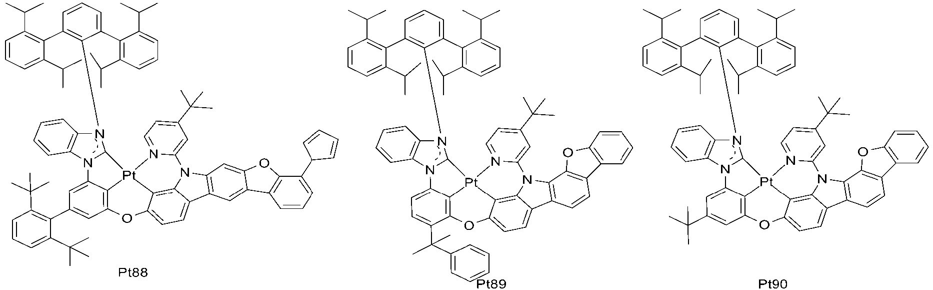

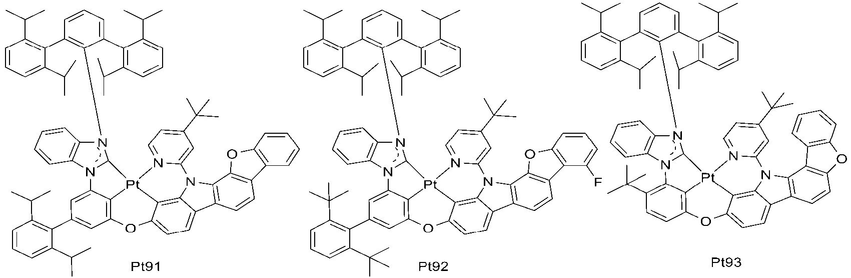

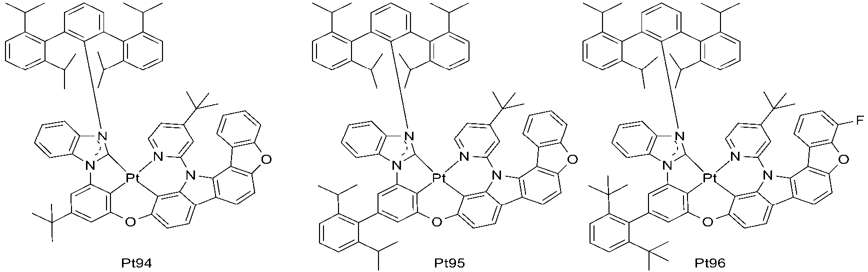

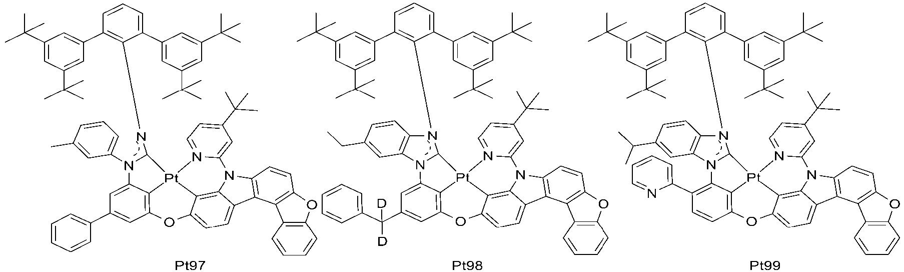

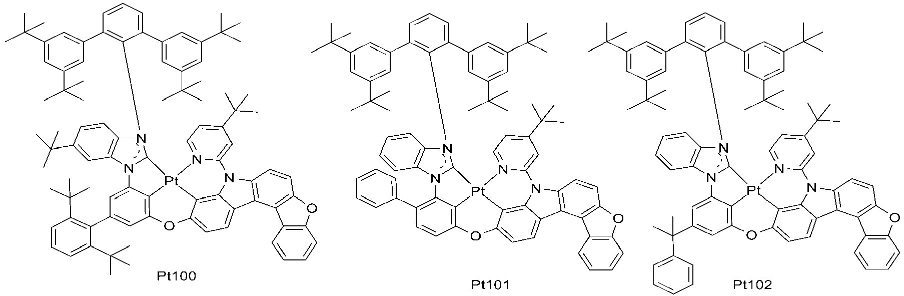

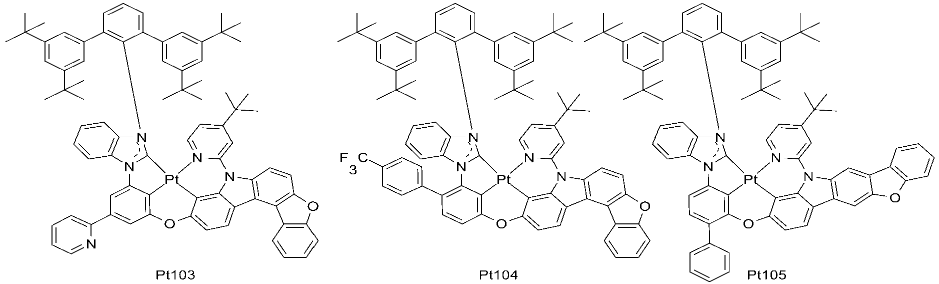

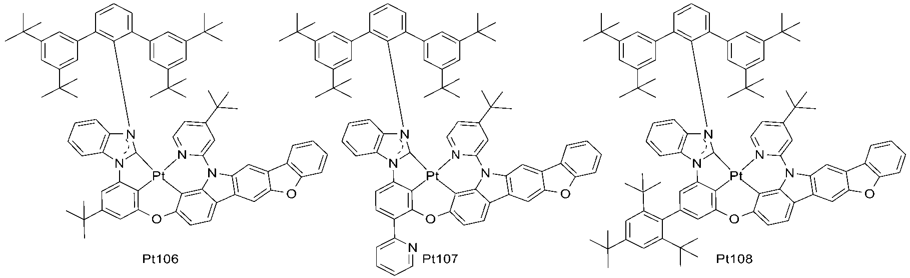

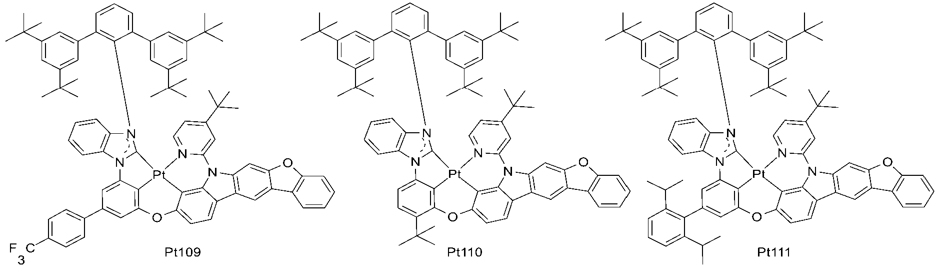

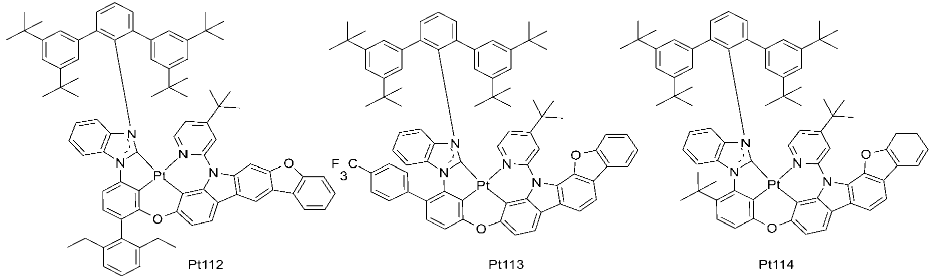

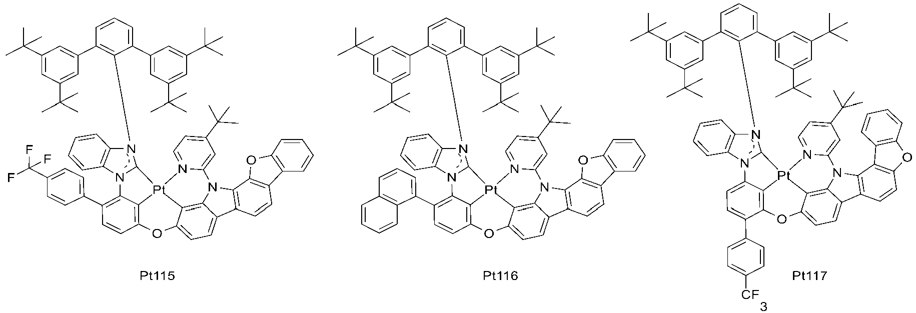

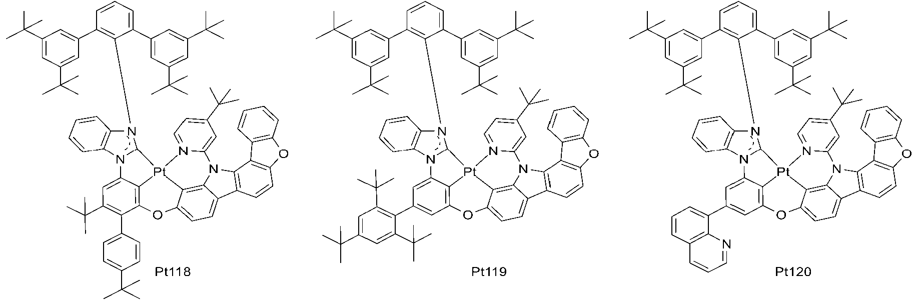

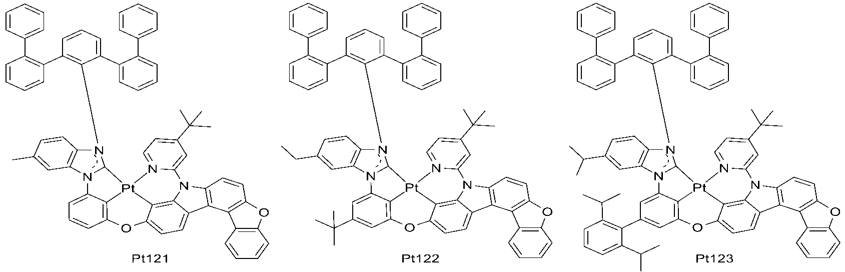

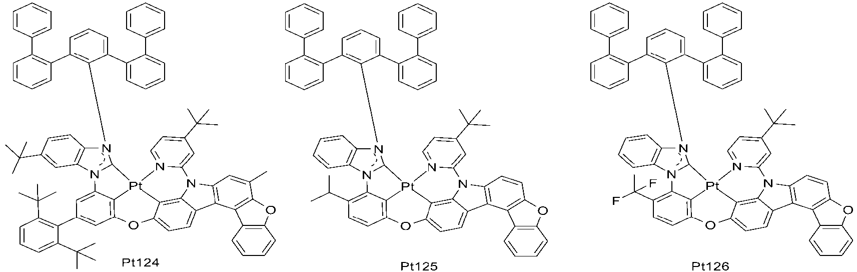

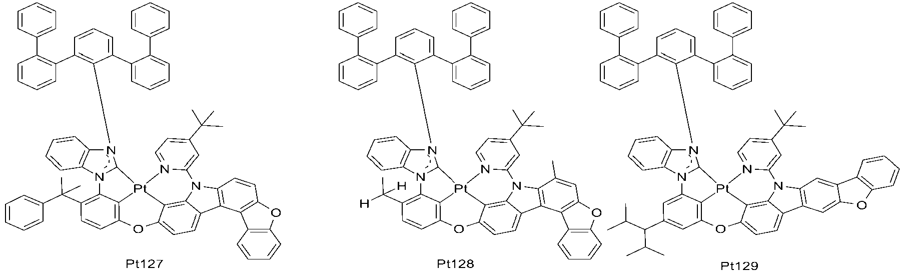

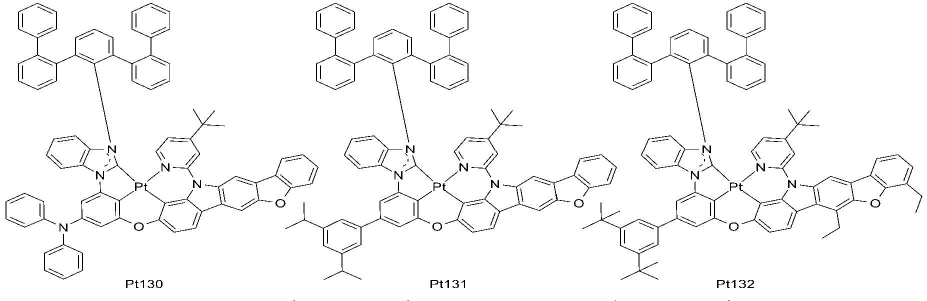

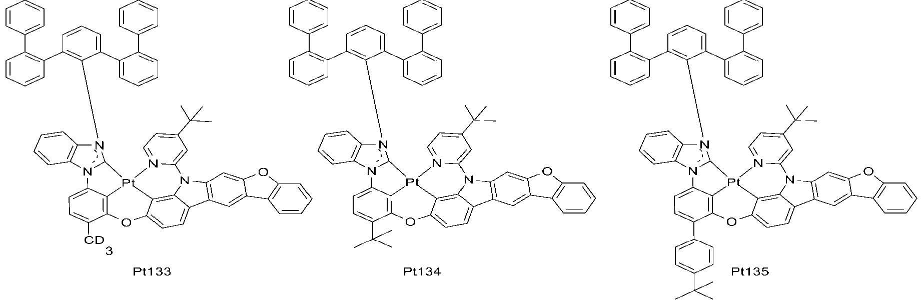

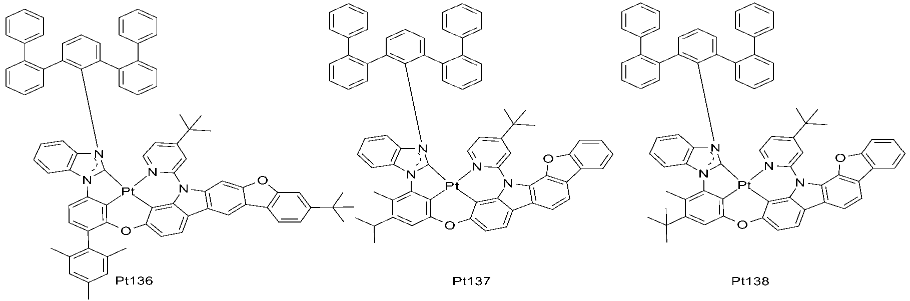

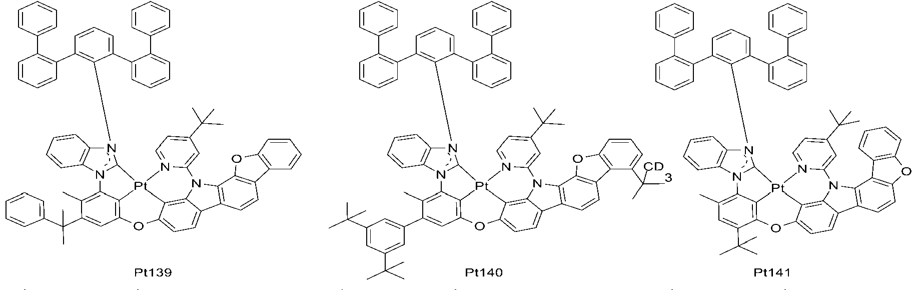

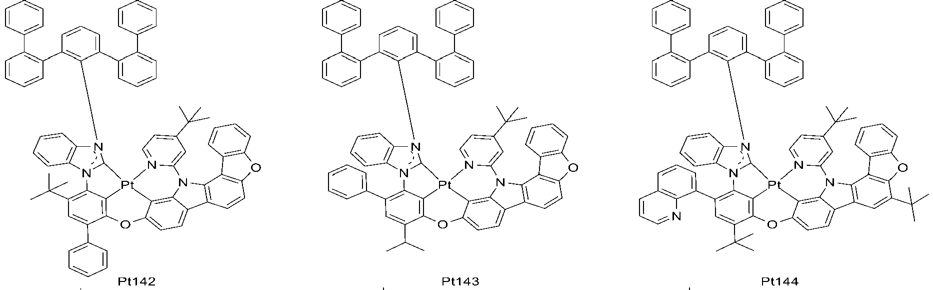

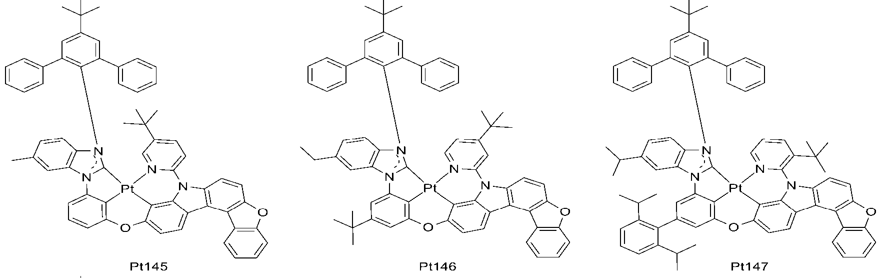

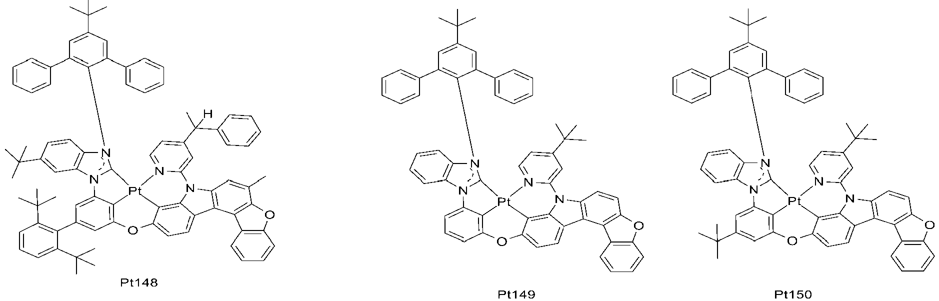

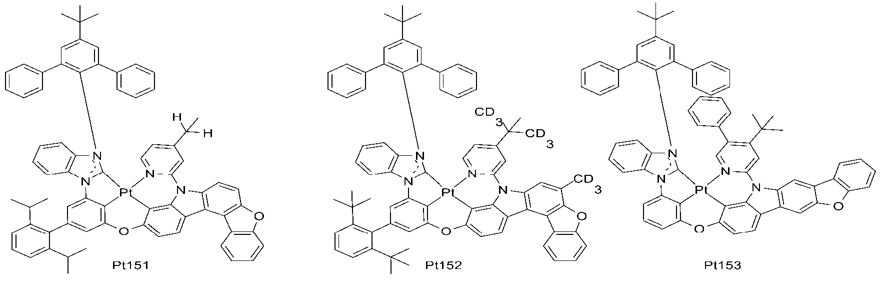

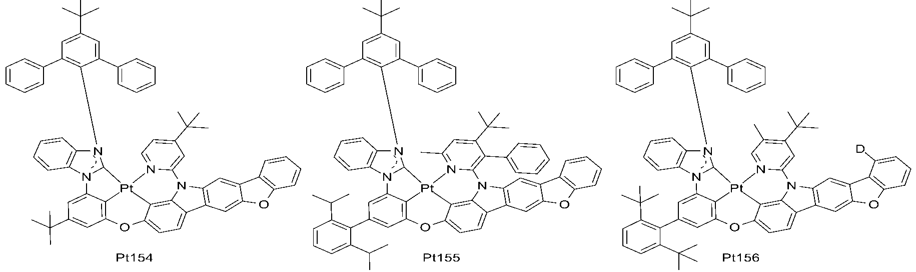

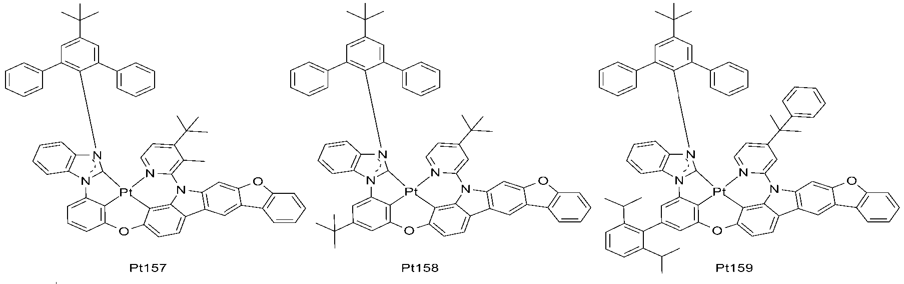

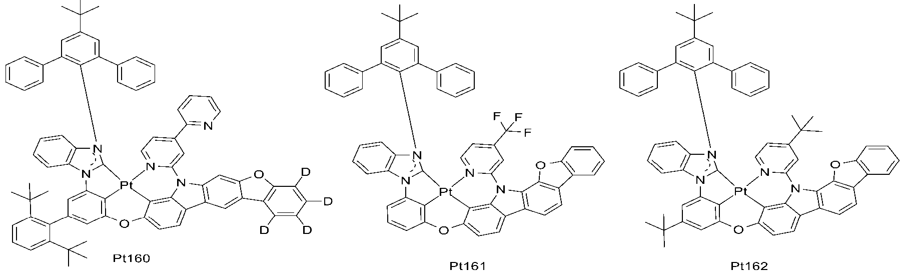

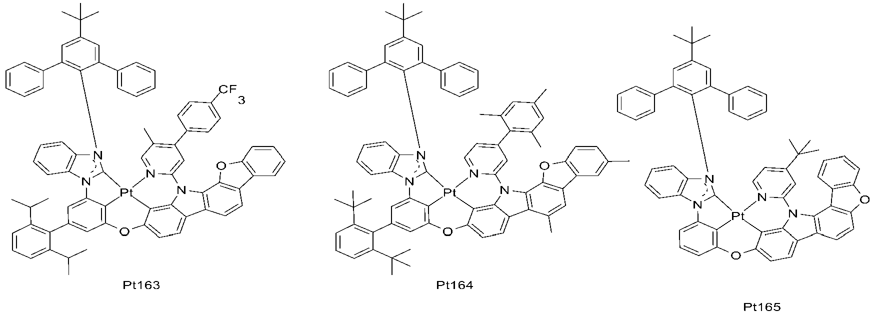

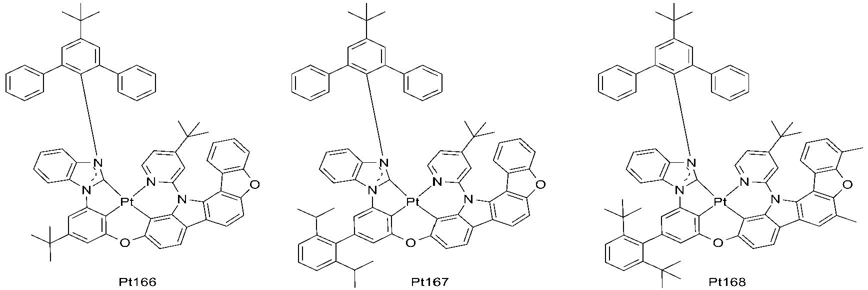

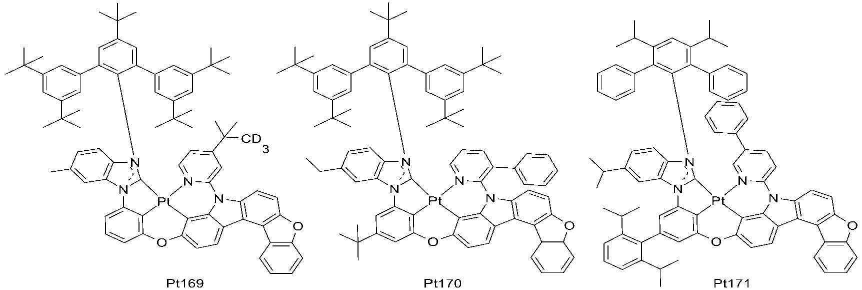

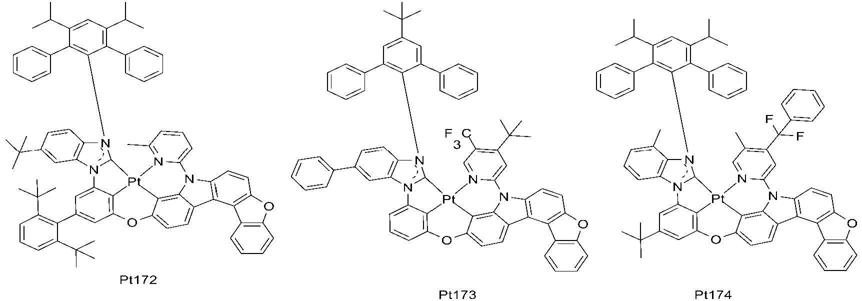

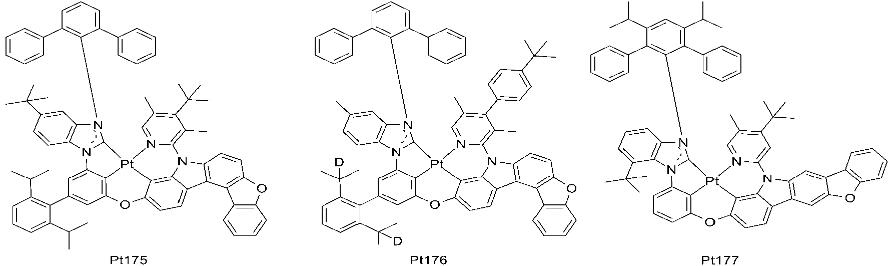

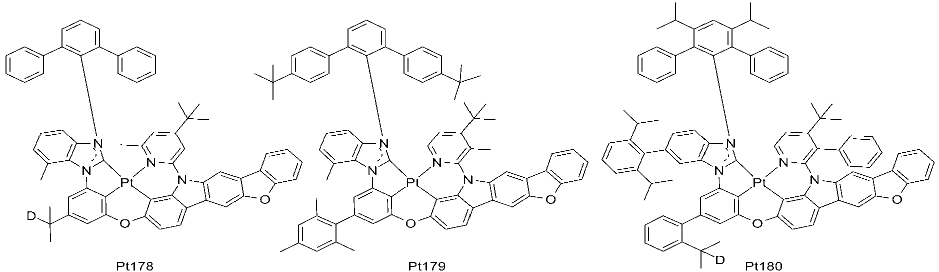

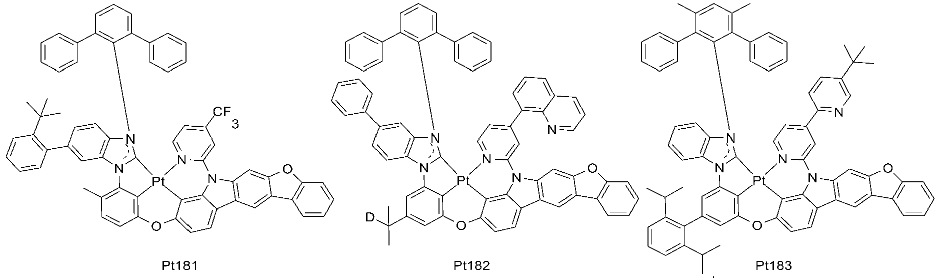

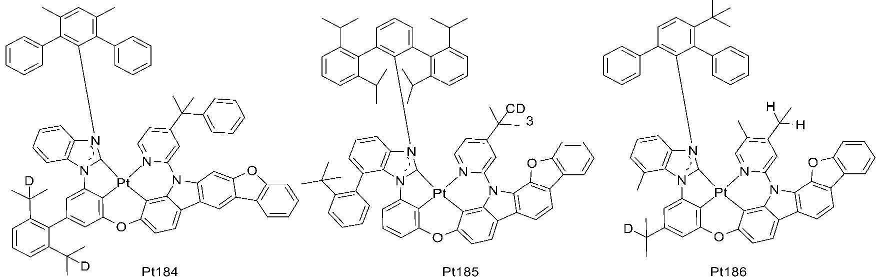

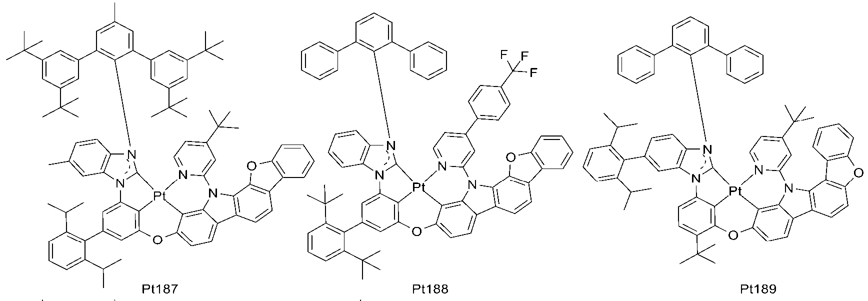

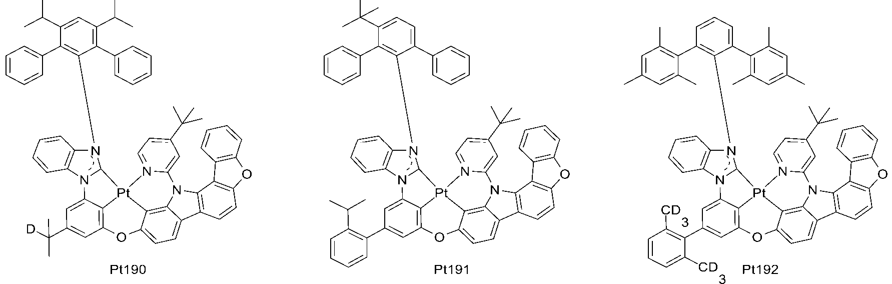

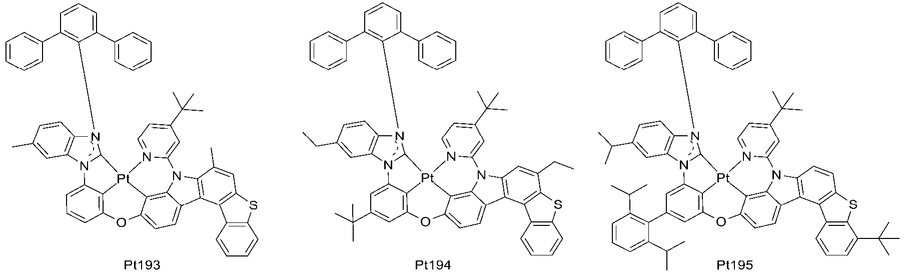

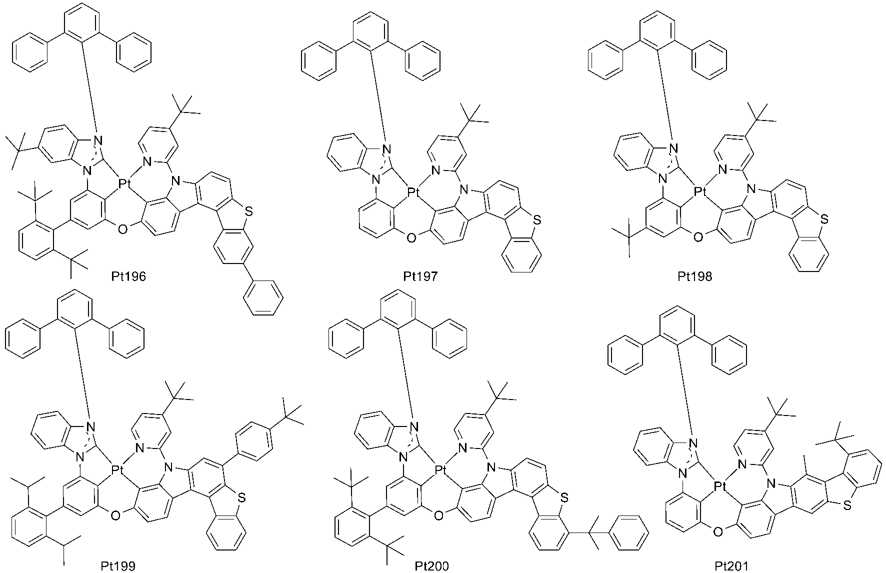

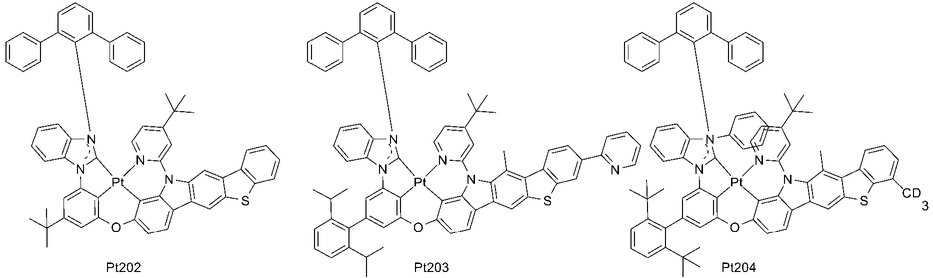

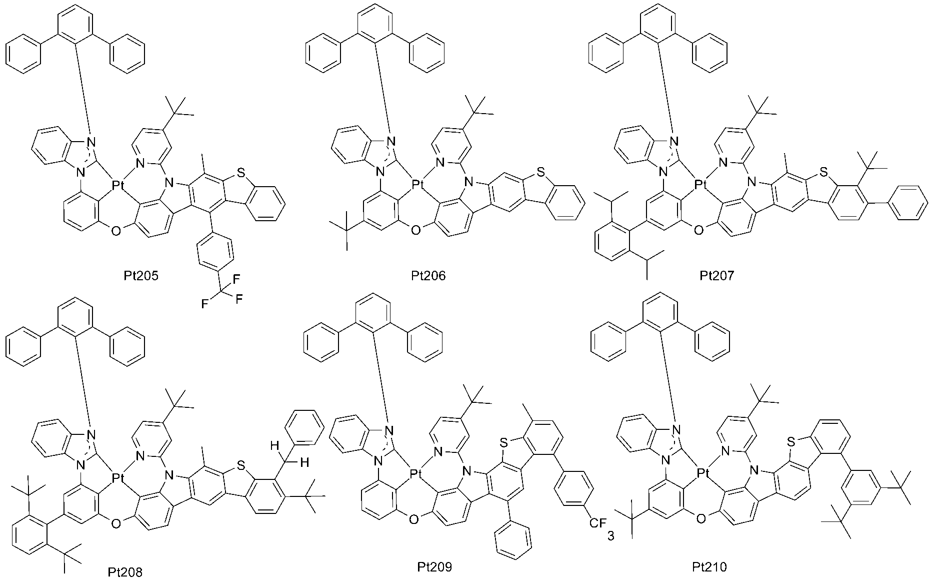

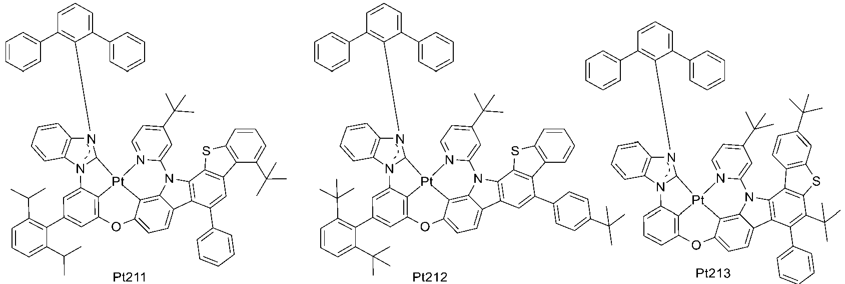

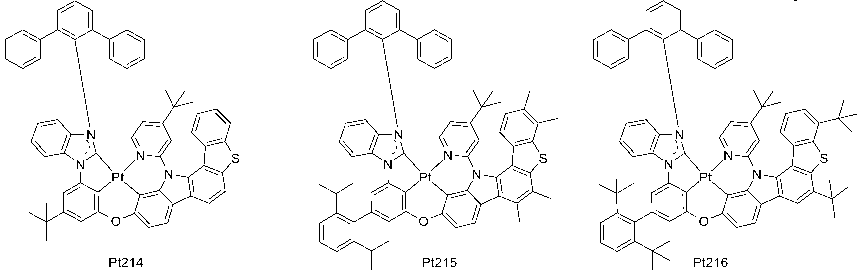

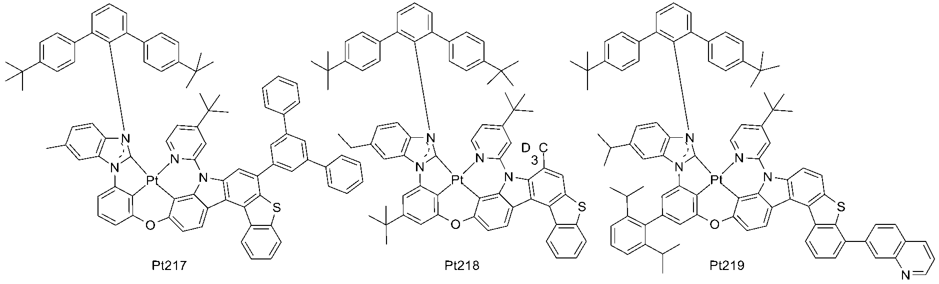

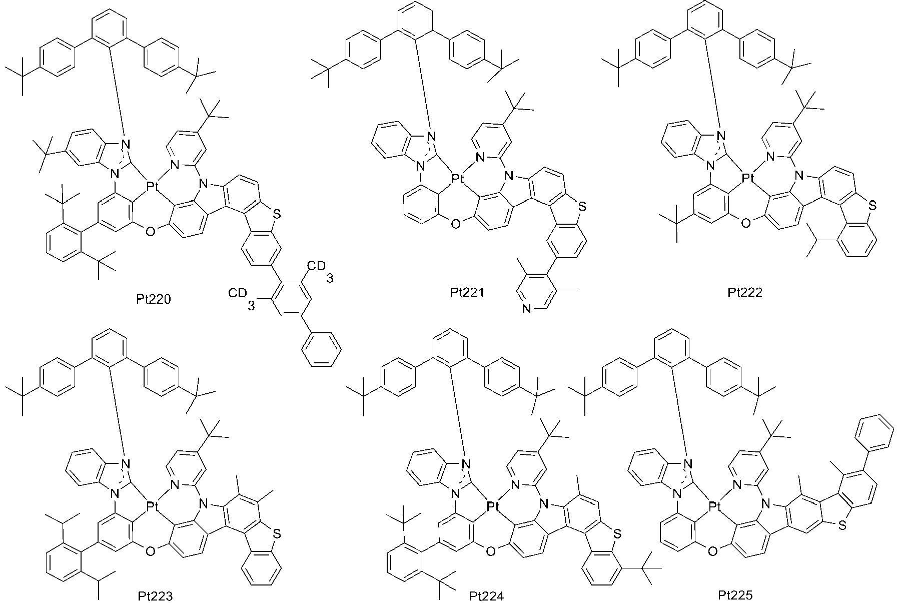

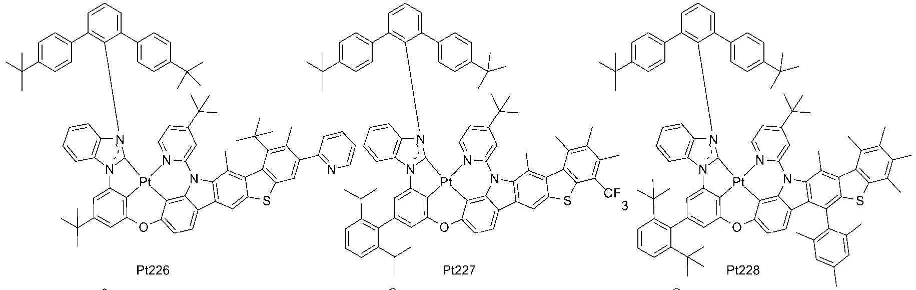

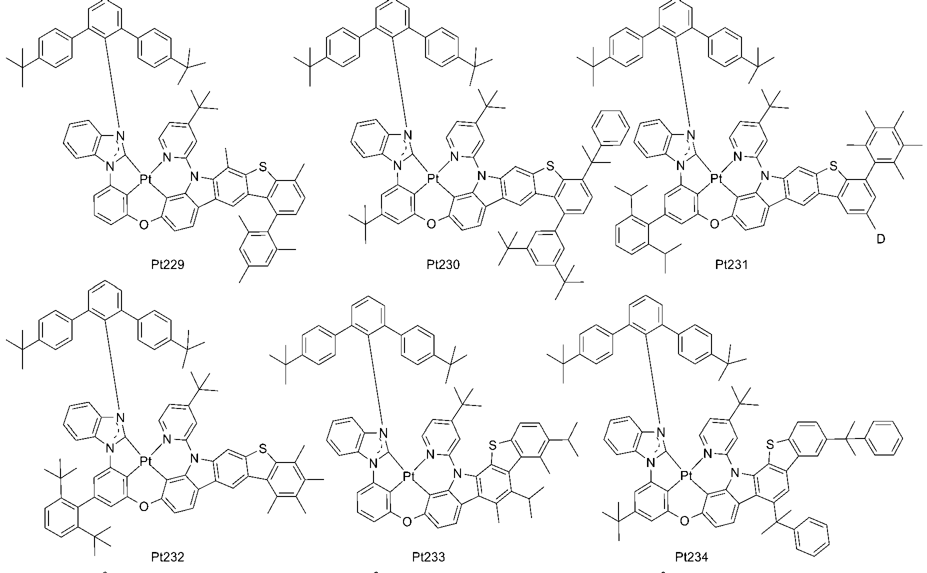

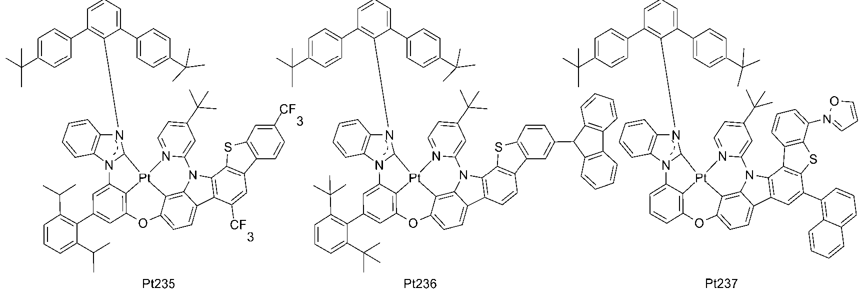

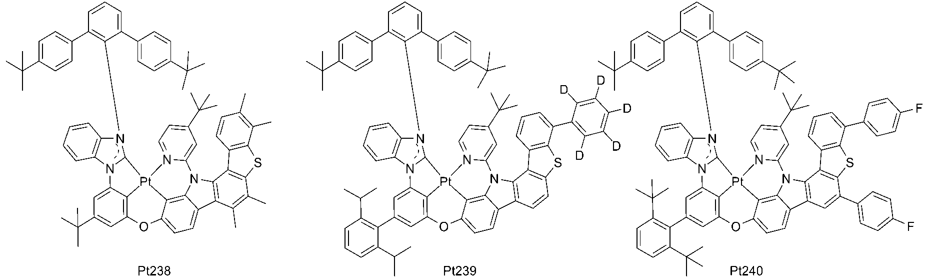

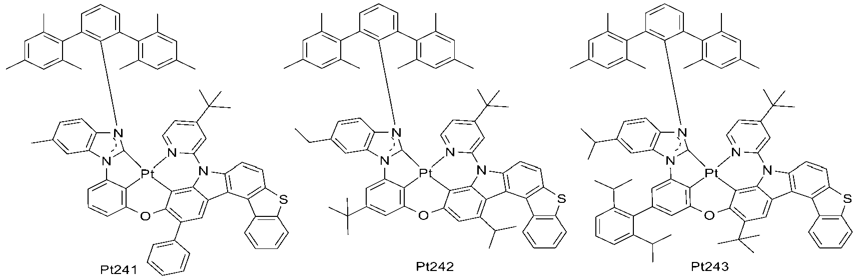

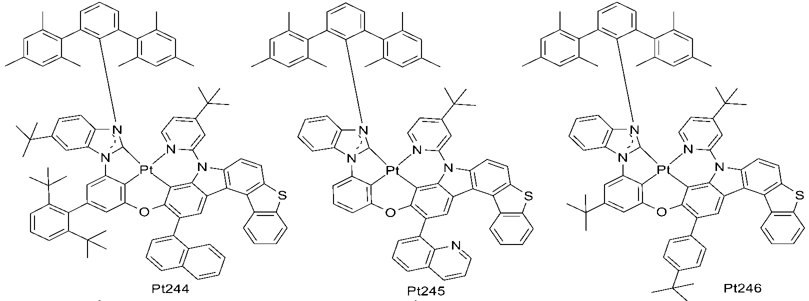

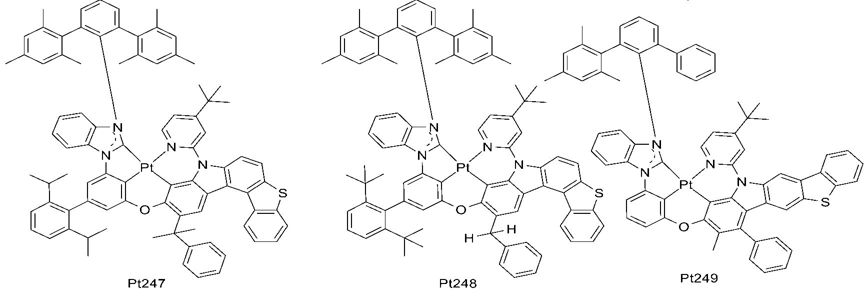

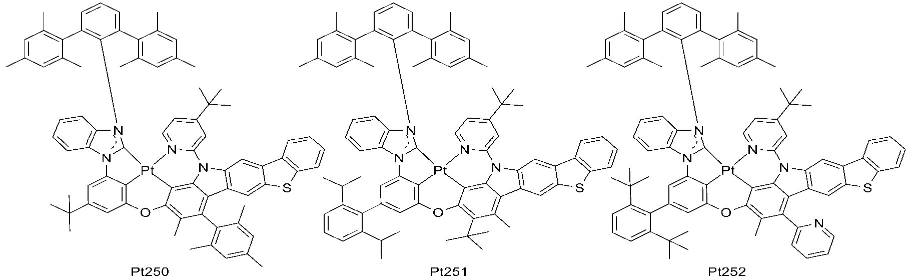

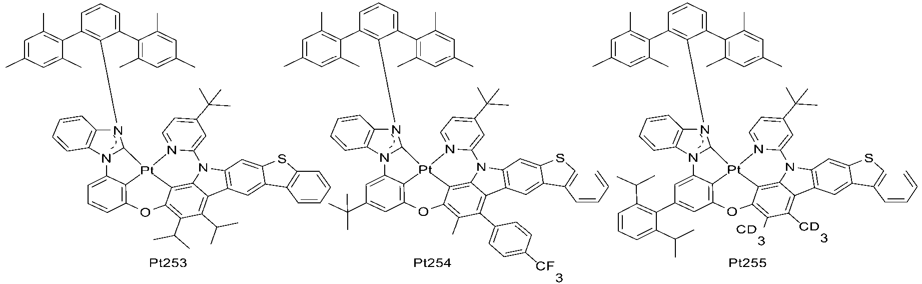

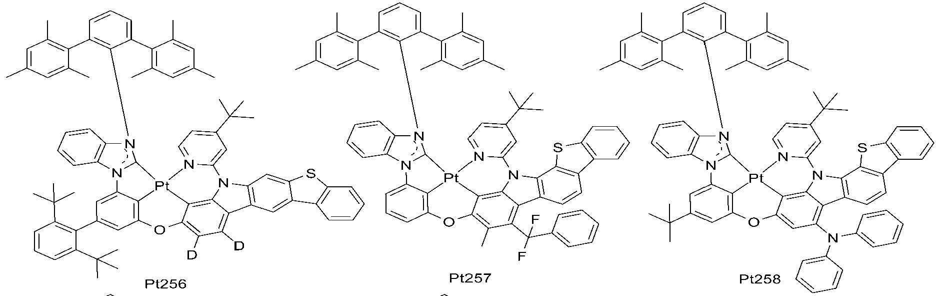

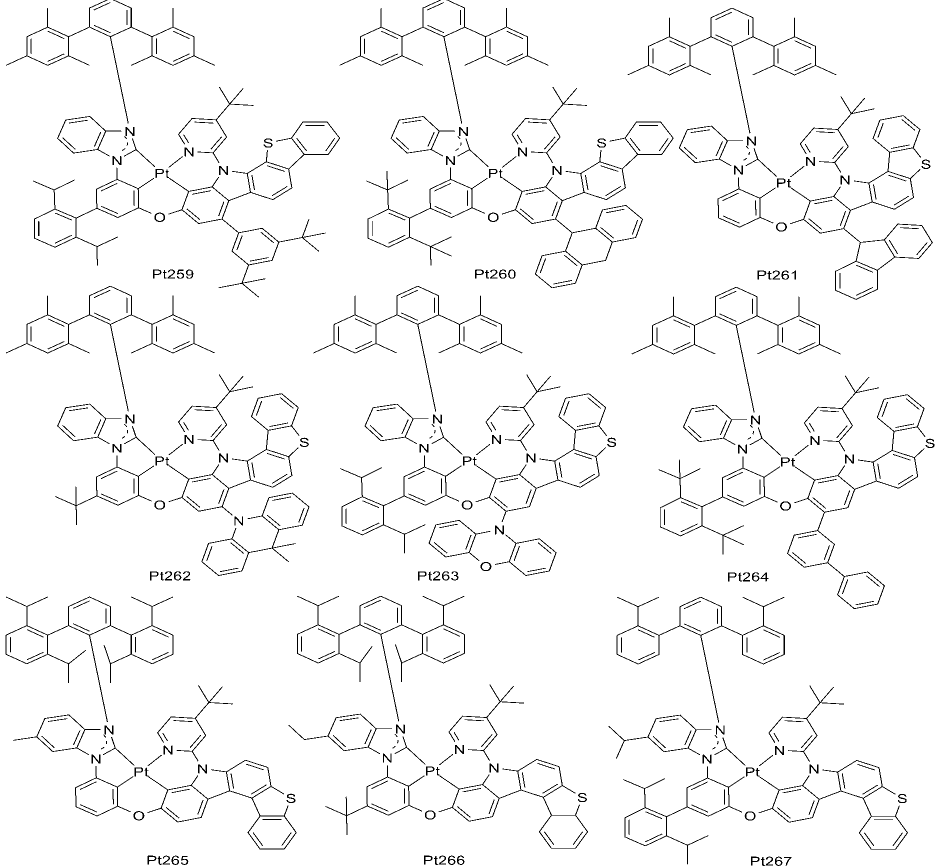

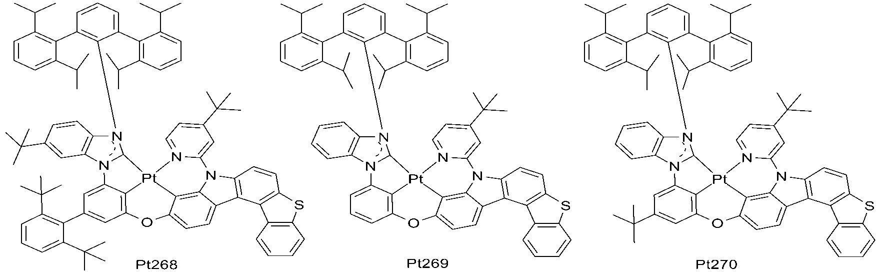

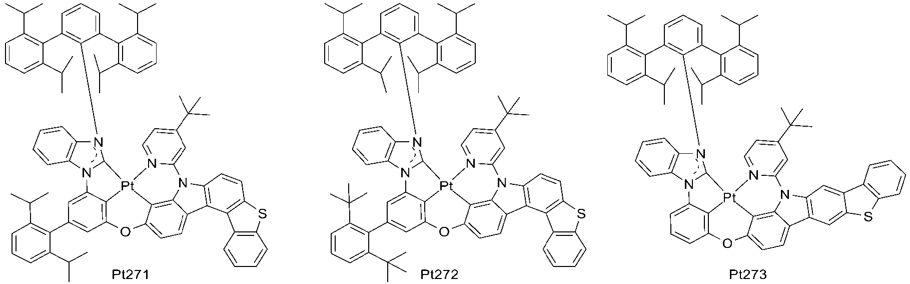

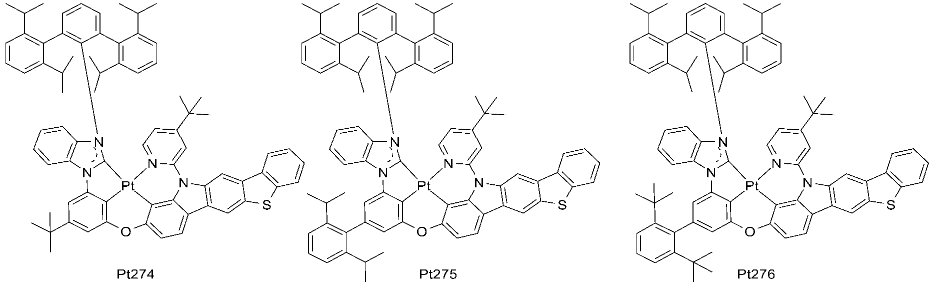

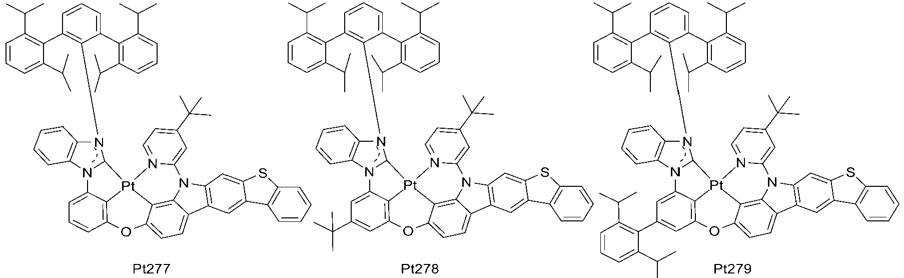

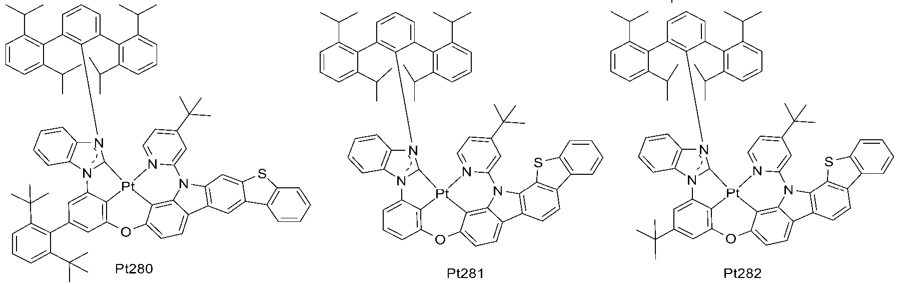

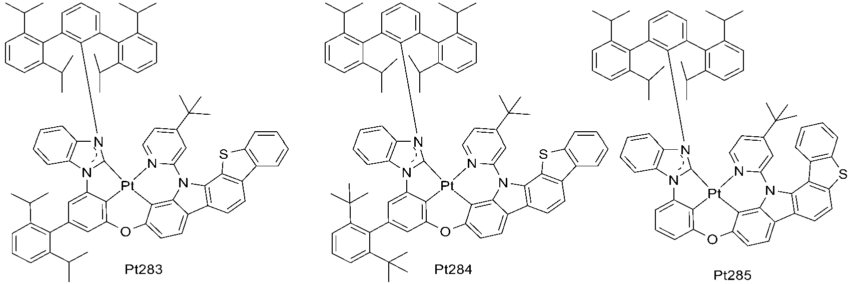

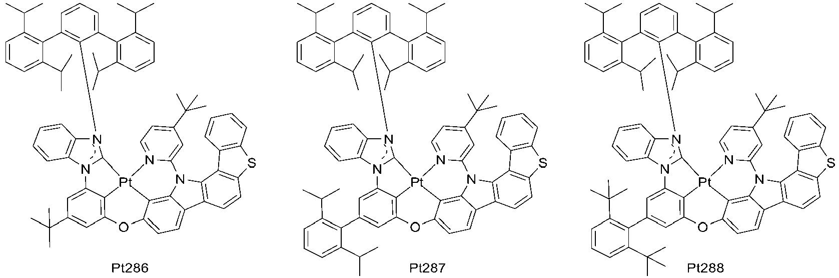

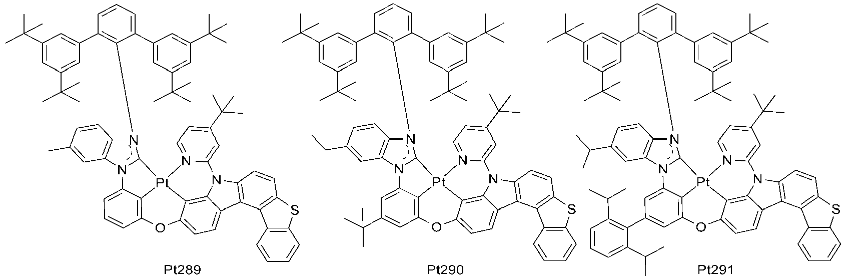

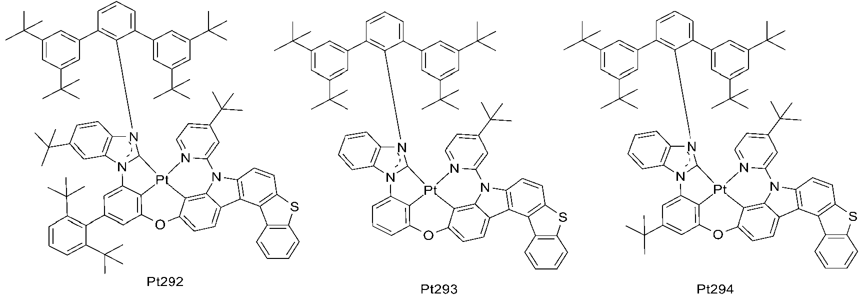

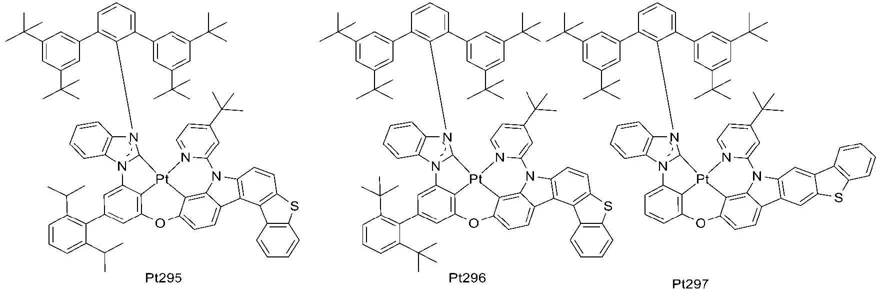

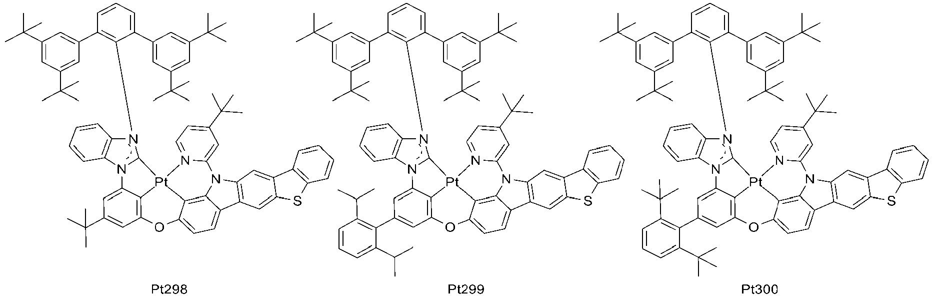

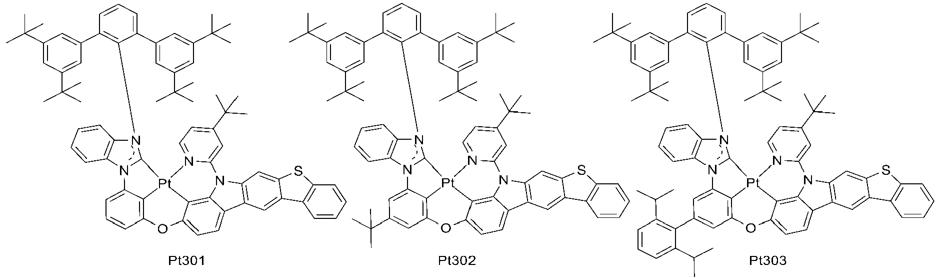

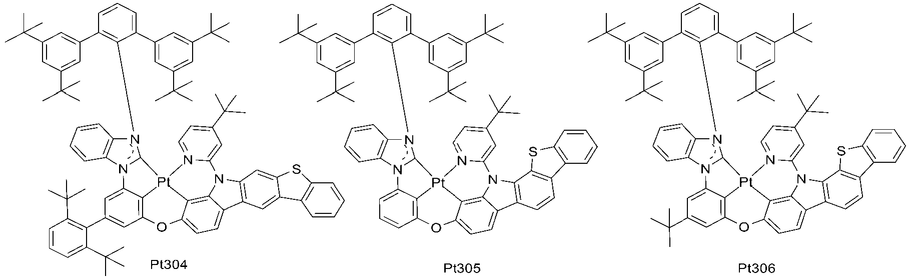

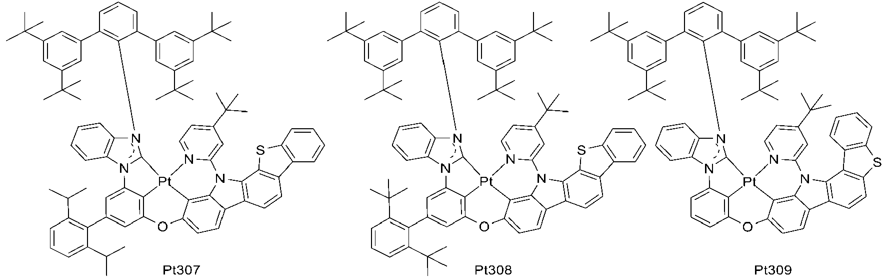

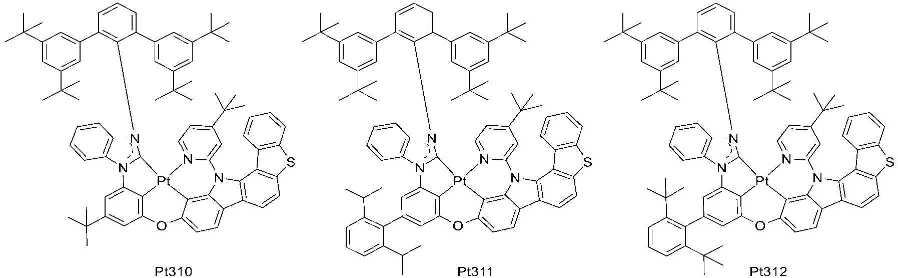

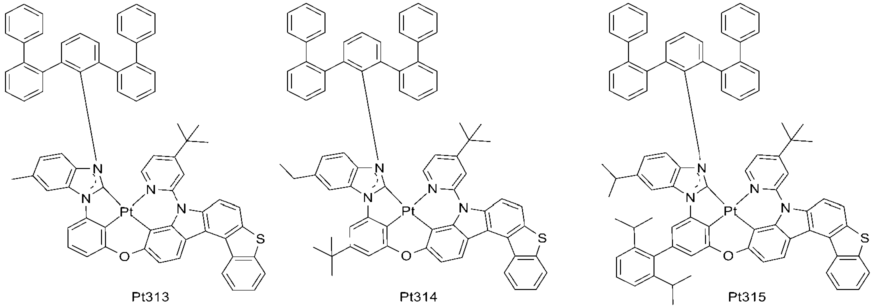

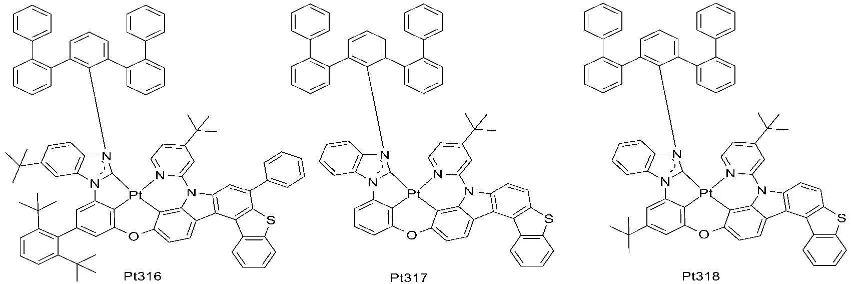

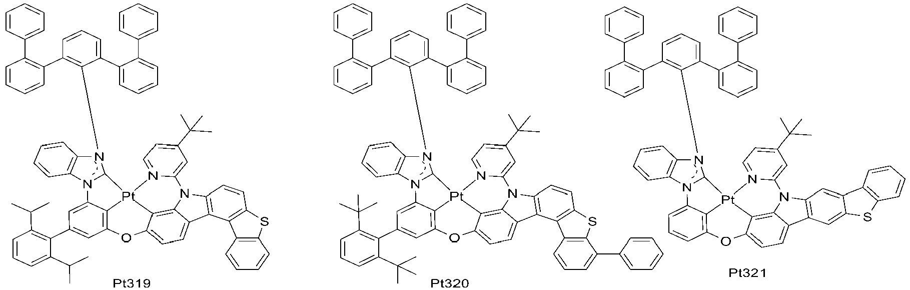

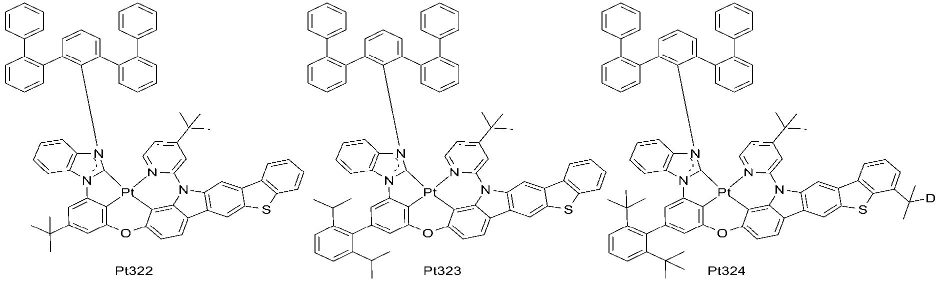

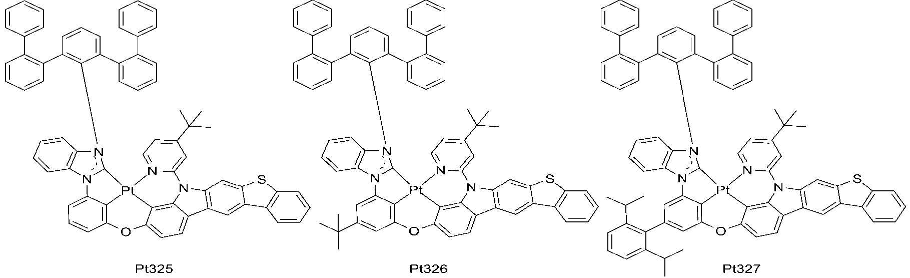

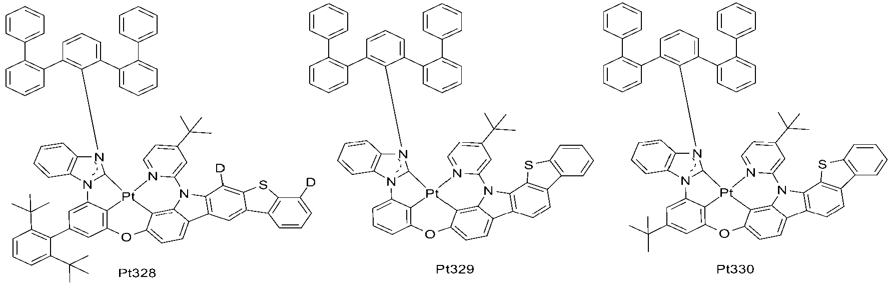

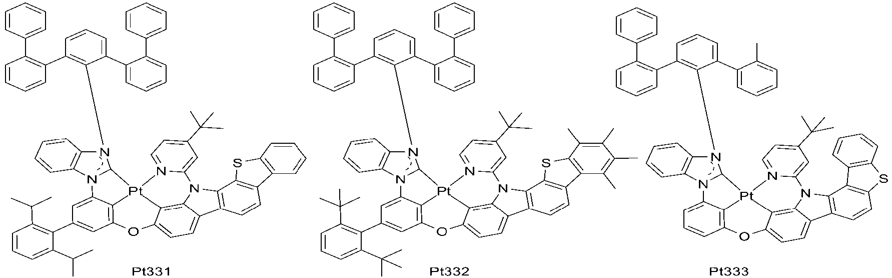

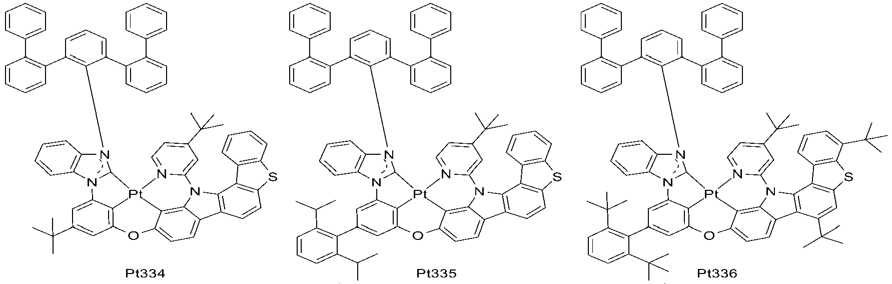

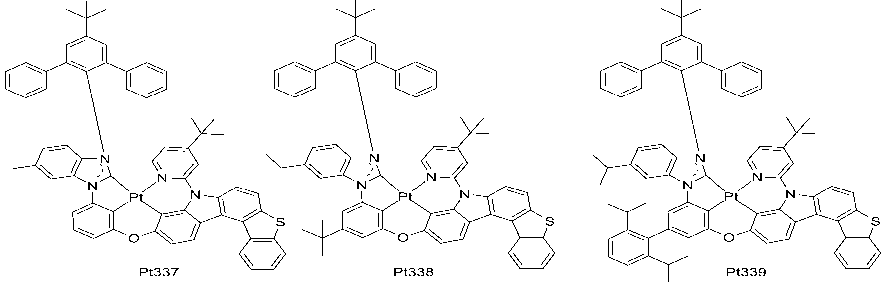

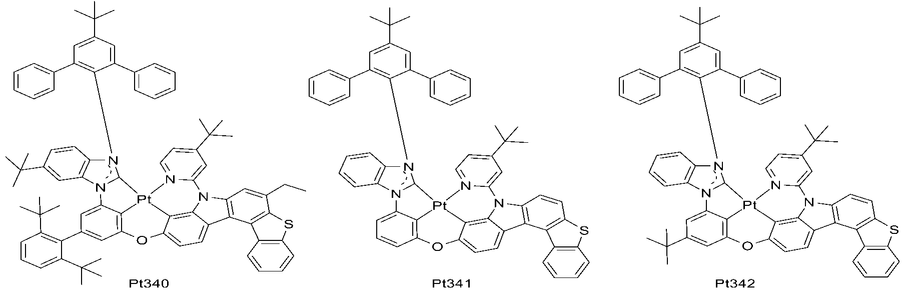

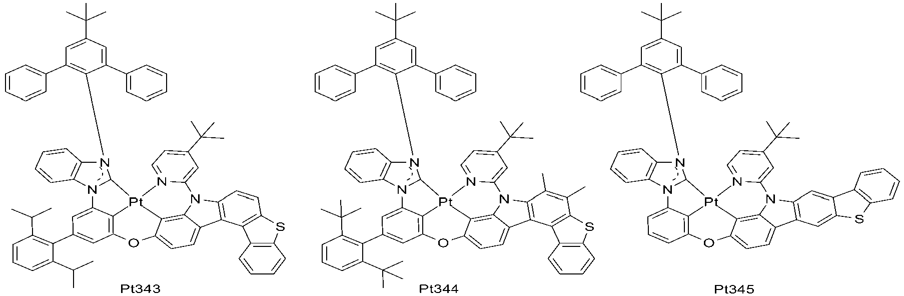

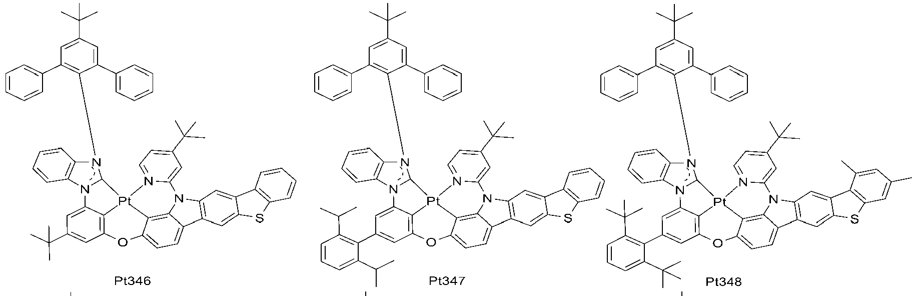

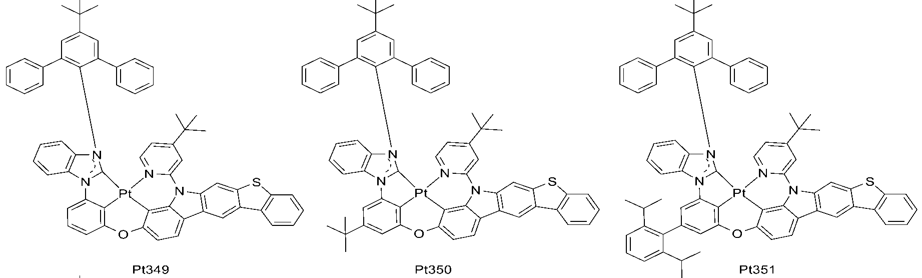

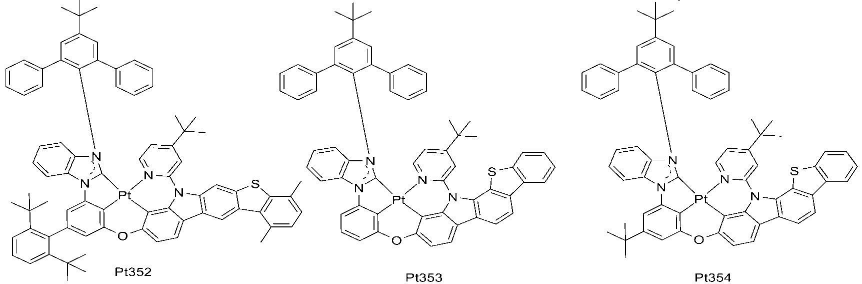

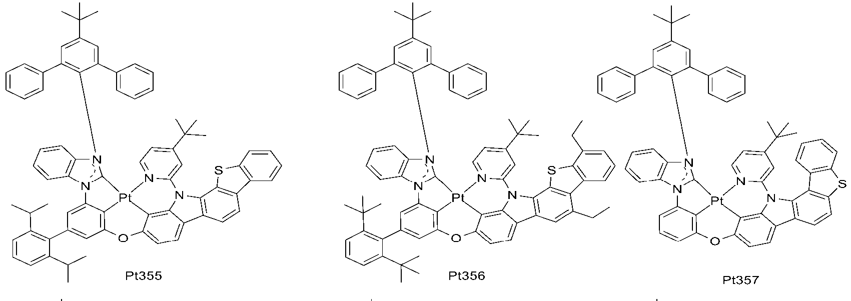

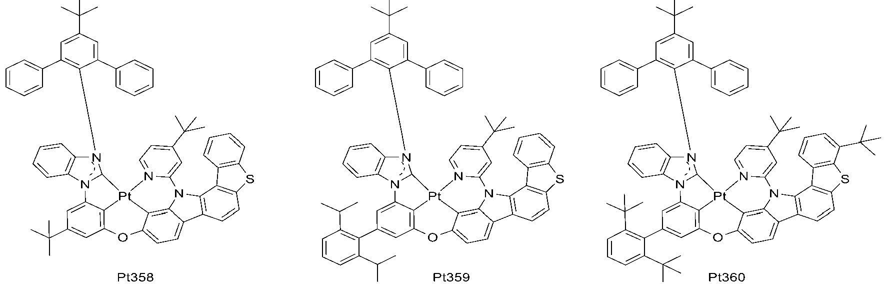

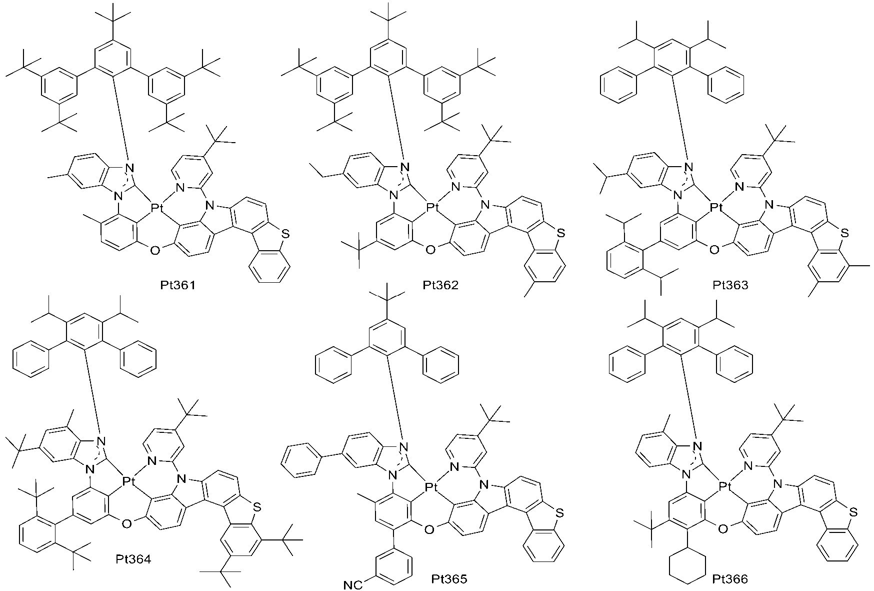

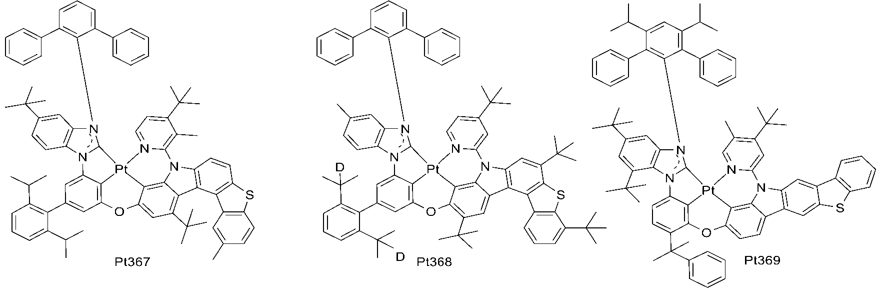

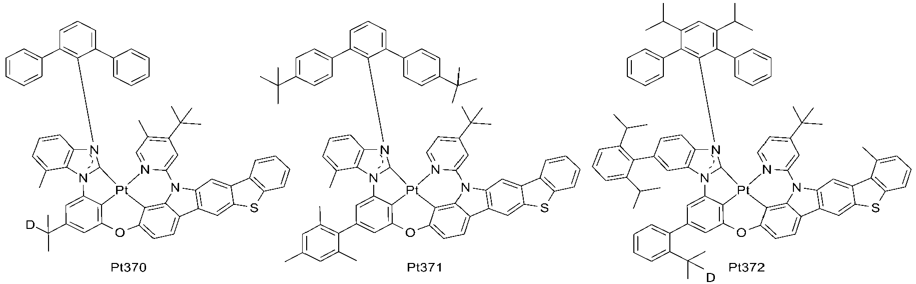

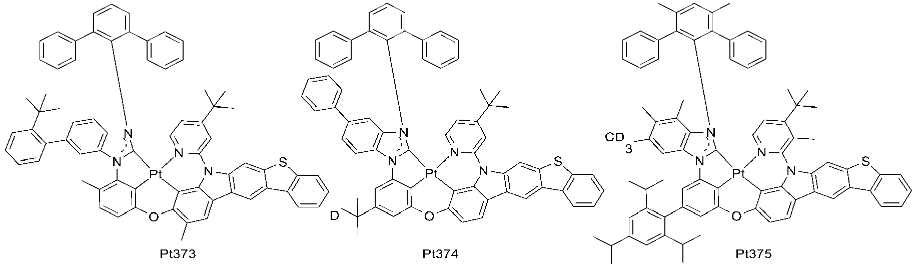

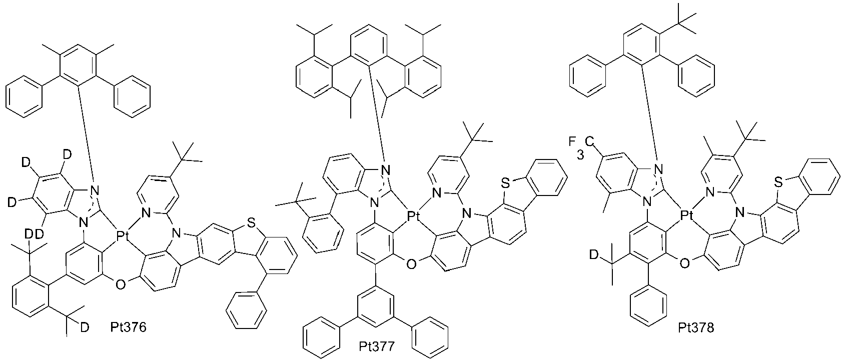

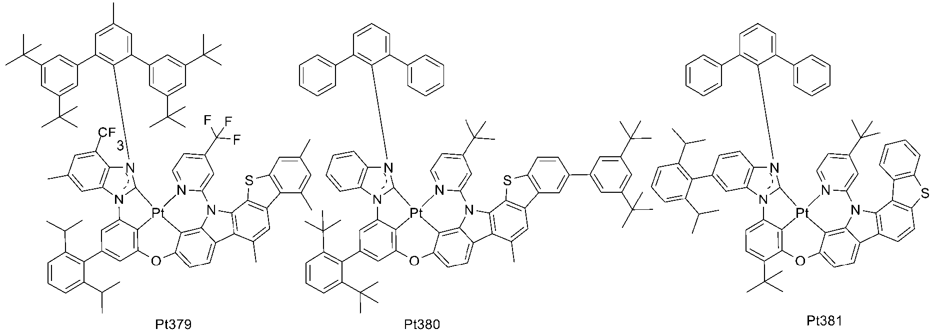

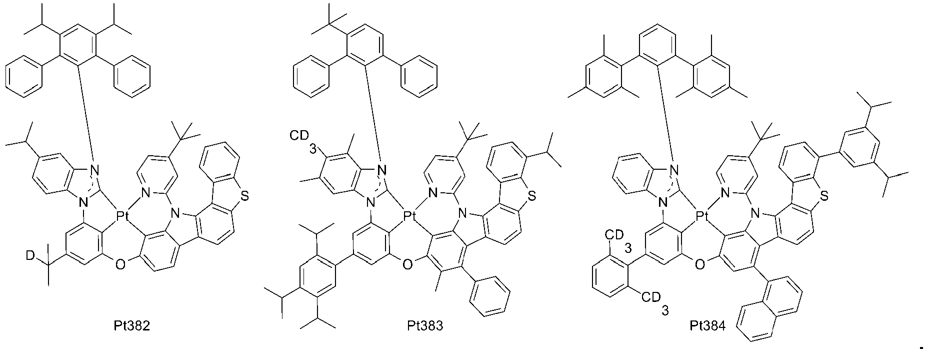

6. An application of the fused-ring carbazole tetradentate platinum(II) complex according to any one of claims **1** to **5** in an electronic device, wherein the electronic device comprises one or more of an organic electroluminescent device, an organic integrated circuit, an organic field-effect transistor, an organic thin-film transistor, an organic light-emitting transistor, an organic solar cell, an organic optical detector, an organic photosensor, an organic field-quench device, a light-emitting electrochemical cell and an organic laser diode.

7. An organic electroluminescent device, **characterized in that**, the organic electroluminescent device comprises a cathode, an anode and an organic functional layer between the cathode and the anode, wherein the organic functional layer contains the fused-ring carbazole tetradentate platinum(II) complex according to any one of claims **1** to **5.**

8. An organic electroluminescent device, **characterized in that**, the organic functional layer includes a light-emitting layer, wherein the light-emitting layer contains the fused-ring carbazole tetradentate platinum(II) complex according to any one of claims **1** to **5.**

9. The organic electroluminescent device according to claim **8, characterized in that**, the light-emitting layer further includes a fluorescent dopant material, and the fluorescent dopant material is a boron-containing compound.

10. An organic optoelectronic device, **characterized in that**, the organic optoelectronic device comprises: a substrate layer; a first electrode disposed on the substrate; an organic light-emitting functional layer disposed on the first electrode; and a second electrode disposed on the organic light-emitting functional layer, wherein the organic light-emitting functional layer contains the fused-ring carbazole tetradentate platinum(II) complex according to any one of claims **1** to **5.**

11. The organic optoelectronic device according to claim **10, characterized in that**, the organic light-emitting functional layer further includes a fluorescent dopant material, and the fluorescent dopant material is a boron-containing compound.

12. A composition, **characterized in that**, the composition contains the fused-ring carbazole tetradentate platinum(II) complex according to any one of claims **1** to **5.**

13. A formulation, **characterized in that**, the formulation contains the fused-ring carbazole tetradentate platinum(II) complex according to any one of claims **1** to **5.**

14. A display or lighting apparatus, **characterized in that**, the apparatus comprises at least one organic electroluminescent device each according to any one of claims **7** to **9.**
